# EUROPEAN PATENT SPECIFICATION

(11) **EP 3 643 720 B1**
(45) Date of publication and mention of the grant of the patent: **29.09.2021**
(21) Application number: 18202032.1
(22) Date of filing: 23.10.2018
(51) Int. Cl.: C07F 9/53, C09K 11/06, H01L 51/00, H01L 51/50

(54) **ORGANIC COMPOUNDS, ORGANIC SEMICONDUCTOR LAYER AND ORGANIC ELECTRONIC DEVICE**
ORGANISCHE VERBINDUNGEN, ORGANISCHE HALBLEITERSCHICHT UND ORGANISCHE ELEKTRONISCHE VORRICHTUNG
COMPOSÉS ORGANIQUES, COUCHE SEMI-CONDUCTRICE ORGANIQUE ET DISPOSITIF ÉLECTRONIQUE ORGANIQUE

(43) Date of publication of application: 29.04.2020
(73) Proprietor: Novaled GmbH, 01099 Dresden (DE)
(72) Inventor: SENKOVSKYY, Volodymyr, 01307 Dresden (DE); STEUDEL, Annette, 01307 Dresden (DE)
(74) Representative: Michalski Hüttermann & Partner Patentanwälte mbB

(56) References cited:
- EP-A1- 3 171 418
- EOIN RAFTER ET AL: "Synthesis of-stereogenic BINAP bissulfide analogues", TETRAHEDRON ASYMMETRY, PERGAMON PRESS LTD, OXFORD, GB, vol. 22, no. 16, 13 September 2011 (2011-09-13), pages 1680-1686, XP028110597, ISSN: 0957-4166, DOI: 10.1016/J.TETASY.2011.09.007 [retrieved on 2011-09-19]
- ZAKIROVA, GLADIS G. ET AL: "Synthesis of chelating tertiary phosphine oxides via palladium-catalysed C-P bond formation", TETRAHEDRON LETTERS, vol. 58, no. 35, 15 July 2017 (2017-07-15) , pages 3415-3417, XP002789433, ISSN: 0040-4039, DOI: 10.1016/J.TETLET.2017.07.055 10.1016/J.TETLET.2017.07.055
- HAN, ZHENGXU S. ET AL.: "General and stereoselective method for the synthesis of sterically congested and structurally diverse P-stereogenic secondary phosphine oxides", ORGANIC LETTERS, vol. 19, no. 7, 29 March 2017 (2017-03-29) , pages 1796-1799, XP002789434, ISSN: 1523-7052
- VARMA, INDRA K. ET AL: "Addition polyimides. IV. Effect of structure on thermal characteristics", JOURNAL OF APPLIED POLYMER SCIENCE, vol. 29, no. 9, 1 September 1984 (1984-09-01), pages 2807-2817, XP002789435, ISSN: 0021-8995, DOI: 10.1002/APP.1984.070290911 10.1002/APP.1984.070290911
- VARMA, INDRA K. ET AL: "Synthesis and characteristics of poly(bisdichloromaleimides)", ACS SYMPOSIUM SERIES , 195(CYCLOPOLYM. POLYM. CHAIN-RING STRUCT.), vol. 195, 12 August 1982 (1982-08-12), pages 253-271, XP002789436, ISSN: 0097-6156, DOI: 10.1021/BK-1982-0195.CH020 10.1021/BK-1982-0195.CH020

## Description

### Technical Field

The present invention relates to organic compounds, suitable for use as a layer material for electronic devices, and relates to an organic semiconductor layer comprising at least one compound thereof, as well as to an organic electronic device comprising at least one organic semiconductor layer, and a method of manufacturing the same.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic material being capable of increasing electron mobility and simultaneously increasing electrochemical stability is needed so that the organic electronic device, such as an organic light emitting diode, may be applied to a large-size flat panel display.

EP 3 171 418 A1 refers to an organic semiconductive layer which is an electron transport layer and/or an electron injection layer and/or an n-type charge generation layer, the organic semiconductive layer comprising at least one phosphine oxide compound.

EOIN RAFTER ET AL, "Synthesis of-stereogenic BINAP bissulfide analogues", TETRAHEDRON ASYMMETRY, PERGAMON PRESS LTD, OXFORD, GB, vol. 22, no. 16, doi:10.1016/J.TETASY.2011.09.007, ISSN 0957-4166, (20110913), pages 1680 - 1686.

ZAKIROVA, GLADIS G. ET AL, "Synthesis of chelating tertiary phosphine oxides via palladium-catalysed C-P bond formation", TETRAHEDRON LETTERS, (20170715), vol. 58, no. 35, ISSN 0040-4039, pages 3415 - 3417.

HAN, ZHENGXU S. ET AL., "General and stereoselective method for the synthesis of sterically congested and structurally diverse P-stereogenic secondary phosphine oxides", ORGANIC LETTERS, (20170329), vol. 19, no. 7, ISSN 1523-7052, pages 1796 - 1799.

VARMA, INDRA K. ET AL, "Addition polyimides. IV. Effect of structure on thermal characteristics", JOURNAL OF APPLIED POLYMER SCIENCE, (19840901), vol. 29, no. 9, ISSN 0021-8995, pages 2807 - 2817.

VARMA, INDRA K. ET AL, "Synthesis and characteristics of poly(bisdichloromale-imides)", ACS SYMPOSIUM SERIES , 195 (CYCLOPOLYM. POLYM. CHAIN-RING STRUCT.), (19820812), vol. 195, ISSN 0097-6156, pages 253 - 271.

Further, development of an organic material being capable to have an extended life span at higher current density and thereby at higher brightness is needed.

There remains a need to improve performance of organic semiconductor layers, organic semiconductor materials, as well as organic electronic devices thereof, in particular to achieve increased lifetime at higher current density and have a higher efficiency through improving the characteristics of the compounds comprised therein.

There is a need for alternative organic semiconductor materials and organic semiconductor layers as well as organic electronic devices having increased lifetime at higher current density, and/or improved efficiency at low operating voltage.

In particular there is a need for alternative compounds having increased lifetime at higher current density as well as improved efficiency, and at the same time keeping the operating voltage and thereby the power consumption low to deliver long battery life for example mobile electronic devices.

### DISCLOSURE

An aspect of the present invention in accordance with claim 1 provides a compound of formula 1: 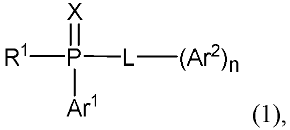 wherein
- X: is O;
- R¹: is selected from a substituted or unsubstituted C₁ to C₁₈ alkyl group, wherein the substituents of the substituted C₁ to C₁₈ alkyl group are selected from C₆ to
C₂₄ aryl, C₃ to C₂₄ heteroaryl, halogen, CN, perfluorinated C₁ to C₁₆ alkyl, perfluorinated C₁ to C₁₆ alkoxy;
- Ar¹: is selected from an unsubstituted C₆ to C₂₄ aryl;
- L: is selected from a substituted or unsubstituted C₆ to C₁₉ arylene or C₃ to C₂₄ heteroarylene group,
wherein the substituents of the substituted C₆ to C₁₉ arylene or of the substituted C₃ to C₂₄ heteroarylene group are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy;
- Ar²: is selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and
wherein the substituents of the substituted C₁₀ to C₄₂ aryl group or of the substituted C₃ to C₄₂ heteroaryl group are independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl, and
wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen;
- n: is an integer selected from 1, 2 or 3; and
excluding compound 2, 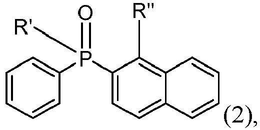
wherein R' is selected from C₁ to C₄ alkyl, and R" is selected from 1-naphthyl, (1,1'-biphenyl)-2-yl and/or 2-methoxy-1-naphthalene-yl; wherein formula 1 comprises at least 6 to 25 aromatic rings.

A conjugated system of delocalized electrons is a system of alternating π- and σ-bonds. With other words a conjugated system is for example a system of connected p orbitals with delocalized electrons in a molecule, which may be cyclic. Conjugation is the overlap of one p orbital with another across an intervening σ bond, which may be represented as having alternating single and multiple bonds.

Preferably, the conjugated system of delocalized electrons comprises at least two aromatic rings adhering to the Hückel rule, more preferably at least three aromatic rings adhering to the Hückel rule. Two or more aromatic rings may form an annulated ring system. In other words, two or more atoms, typically C atoms, may be part of two or more aromatic rings at the same time.

Hetero atoms if not otherwise stated can be individually selected from N, O, S, B, Si, P, Se, preferably from N, O and S and more preferred is N.

Substituted or unsubstituted heteroaryl group means that the substituted or unsubstituted heteroaryl group comprises at least one heterocyclic ring and the substituted or unsubstituted heteroaryl group may comprises in addition at least one non-heterocyclic ring. That means that the substituted or unsubstituted heteroaryl group may comprise in addition at least one non-heterocyclic ring but at least one heterocyclic ring. For example a C₃ to C₂₄ heteroaryl group comprises at least one heterocyclic ring and may comprise in addition at least one non-heterocyclic ring. For example a C₃ to C₂₄ heteroarylene group comprises at least one heterocyclic ring and may comprise in addition at least one non-heterocyclic ring. For example a C₃ to C₄₂ heteroaryl group comprises at least one heterocyclic ring and may comprise in addition at least one non-heterocyclic ring. With other words the term "heteroarylene group" and "heteroarylene group" comprises at least one heterocyclic ring but may not exclude the presents of at least one non-hetero cyclic ring.

In the present invention, endings like "yl", "ylene" and "ene" may be used interchangeable. For example "phenyl" may refer to a benzene ring which is connected to another chemical group via a direct bond, "phenylene" may refer to a benzene ring which is connect to two other chemical groups via direct bonds and "anthracene" may refer to an anthracene group which is connected to one or more other chemical groups via direct bonds.

If not otherwise stated H can represent hydrogen or deuterium.

In the present invention, "PXR³R⁴" is a group wherein the P atom is connected to Ar² via a direct bond and group X is connected to the P atom via a double bond.

In the present invention, "L-PXR³R⁴" is a group wherein group L is connected to Ar² and the P atom via direct bonds and group X is connected to the P atom via a double bond.

In the present invention, "COR⁵" is a group wherein the C atom is connected to Ar² via a direct bond and the O atom is connected to the C atom via a double bond.

According to one embodiment of the compound of formula 1, wherein compound 2, 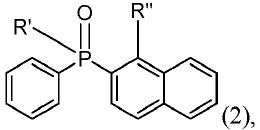 wherein R' is selected from C₁ to C₄ alkyl, R" is selected from 1-naphthyl, (1,1'-biphenyl)-2-yl and 2-methoxy-1-naphthalene-yl are excluded.

According to one embodiment of the compound of formula 1, wherein the compound 2 may be excluded, 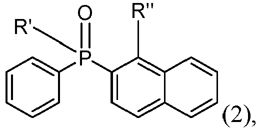 wherein R' can be selected from C₁ to C₄ alkyl and R" is selected from naphthyl or biphenyl, wherein R" may be further substituted with a methoxy group.

According to one embodiment Ar¹ of the compound of formula 1 can be free of a nitrile substituent. According to one embodiment Ar² of the compound of formula 1 can be free of a nitrile substituent. According to one embodiment R¹ of the compound of formula 1 can be free of a nitrile substituent. According to one embodiment Ar¹ and Ar² of the compound of formula 1 can be free of a nitrile substituent. According to one embodiment R¹ and Ar² of the compound of formula 1 can be free of a nitrile substituent. According to one embodiment R¹ and Ar¹ of the compound of formula 1 can be free of a nitrile substituent. According to one embodiment the compound of formula 1 can be free of a nitrile substituent.

According to one embodiment of the compound of formula 1: 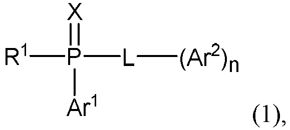 wherein
- X: is O;
- R¹: can be selected from a substituted or unsubstituted C₁ to C₁₈ alkyl group,
wherein the substituents of the substituted C₁ to C₁₈ alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
- Ar¹: can be selected from an unsubstituted C₆ to C₂₄ aryl;
- L: can be selected from a substituted or unsubstituted C₆ to C₁₉ arylene or C₃ to C₂₄ heteroarylene group,
wherein the substituents of the substituted C₆ to C₁₉ arylene or of the substituted C₃ to C₂₄ heteroarylene group are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy;
- Ar²: can be selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and the C₁₀ to C₄₂ aryl group comprises at least one annulated ring system,
wherein the substituents of the substituted C₁₀ to C₄₂ aryl group or of the substituted C₃ to C₄₂ heteroaryl group are independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl, and
wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen;
- n: is an integer selected from 1, 2 or 3; and
excluding compound 2, 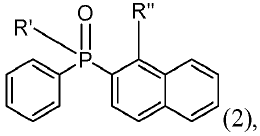 wherein R' is selected from C1 to C4 alkyl and R" is selected from 1-naphthyl, (1,1'-biphenyl)-2-yl and/or 2-methoxy-1-naphthalene-yl.

According to one embodiment of the compound of formula 1, wherein Ar² can be selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and the C₁₀ to C₄₂ aryl group and/or the C₃ to C₄₂ heteroaryl group comprise at least one annulated ring system.

According to one embodiment of the compound of formula 1: 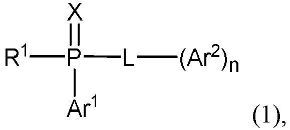 wherein
- X: is O;
- R¹: can be selected from a substituted or unsubstituted C₁ to C₁₈ alkyl group, wherein the substituents of the substituted C₁ to C₁₈ alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
- Ar¹: can be selected from an unsubstituted C₆ to C₂₄ aryl;
- L: can be selected from a substituted or unsubstituted C₆ to C₁₉ arylene or C₃ to C₂₄ heteroarylene group,
wherein the substituents of the substituted C₆ to C₁₉ arylene or of the substituted C₃ to C₂₄ heteroarylene group are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy;
- Ar²: can be selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and the C₁₀ to C₄₂ aryl group comprises at least one annulated ring system,
wherein the annulated ring system does not comprises a ring which is bonded by a single bond to another ring of the annulated ring system;
wherein the substituents of the substituted C₁₀ to C₄₂ aryl group or of the substituted C₃ to C₄₂ heteroaryl group are independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄heteroaryl, perfluorinated C₁ to C₁₆ alkyl, and
wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen;
- n: is an integer selected from 1, 2 or 3; and
excluding compound 2, 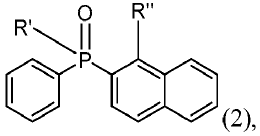 wherein R' is selected from C1 to C4 alkyl and R" is selected from 1-naphthyl, (1,1'-biphenyl)-2-yl and/or 2-methoxy-1-naphthalene-yl.

According to one embodiment of the compound of formula 1: 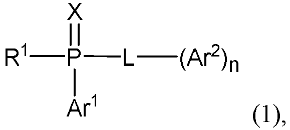 wherein
- X: is O;
- R¹: can be selected from a substituted or unsubstituted C₁ to C₁₈ alkyl group, wherein the substituents of the substituted C₁ to C₁₈ alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
- Ar¹: can be selected from an unsubstituted C₆ to C₂₄ aryl;
- L: can be selected from a substituted or unsubstituted C₆ to C₁₉ arylene or C₃ to C₂₄ heteroarylene group,
wherein the substituents of the substituted C₆ to C₁₉ arylene or of the substituted C₃ to C₂₄ heteroarylene group are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy;
- Ar²: can be selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and the C₁₀ to C₄₂ aryl group comprises at least one annulated ring system, and wherein the C₁₀ to C₄₂ aryl group is free of a biphenyl group or terphenyl group;
wherein the substituents of the substituted C₁₀ to C₄₂ aryl group or of the substituted C₃ to C₄₂ heteroaryl group are independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl, and
wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen;
- n: is an integer selected from 1, 2 or 3; and
excluding compound 2, 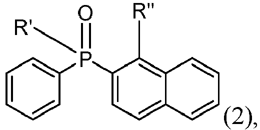 wherein R' is selected from C1 to C4 alkyl and R" is selected from 1-naphthyl, (1,1'-biphenyl)-2-yl and/or 2-methoxy-1-naphthalene-yl.

According to one embodiment of the compound of formula 1: 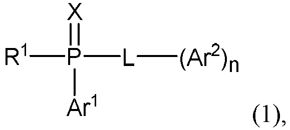 wherein
- X: is O;
- R¹: is C₁ to C₁₂ alkyl, preferably C₁ to C₁₀ alkyl, further preferred C₁ to C₆ alkyl, and more preferred methyl, wherein the substituents of the substituted alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
- Ar¹: is an unsubstituted C₆ to C₁₉ aryl;
- Ar²: can be selected from a substituted or unsubstituted C₁₀ to C₃₆ aryl or substituted or unsubstituted C₃ to C₃₅ heteroaryl group, wherein the C₁₀ to C₃₆ aryl group comprises a conjugated system of delocalized electrons having at least 10 conjugated delocalized electrons, and wherein
the substituents of the substituted C₁₀ to C₃₆ aryl group or of the substituted C₃ to C₃₅ heteroaryl group are independently selected from C₁ to C₆ alkyl, C₁ to C₆ alkoxy, substituted or unsubstituted C₆ to C₁₂ aryl, substituted or unsubstituted C₃ to C₁₁ heteroaryl, halogen, CN, perfluorinated C₁ to C₆ alkyl, perfluorinated C₁ to C₆ alkoxy, PXR³R⁴, L-PXR³R⁴, COR⁵, and wherein
R³, R⁴ and R⁵ are independently selected from C₁ to C₆ alkyl, substituted or unsubstituted C₆ to C₁₂ aryl, substituted or unsubstituted C₃ to C₁₁ heteroaryl, perfluorinated C₁ to C₆ alkyl, and wherein
the substituent of the substituted C₆ to C₁₂ aryl or of the substituted C₃ to C₁₁ heteroaryl are independently selected from C₁ to C₆ alkyl, C₁ to C₆ alkoxy, C₆ to C₁₂ aryl, C₄ to C₁₁ heteroaryl, CN, halogen;
- L: can be selected from a substituted or unsubstituted C₆ to C₁₈ arylene or C₃ to C₁₇ heteroarylene group, preferably from a substituted or unsubstituted C₆ to C₁₂ arylene or C₃ to C₁₁ heteroarylene group, further preferred from a substituted or unsubstituted C₆ to C₁₀ arylene or C₃ to C₁₂ heteroarylene group, and more preferred from a phenylene group; wherein
the substituents of the substituted of the arylene or of the substituted heteroarylene group are independently selected from C₁ to C₆ alkyl, C₁ to C₆ alkoxy, C₆ to C₁₂ aryl, C₃ to C₁₁ heteroaryl, perfluorinated C₁ to C₆ alkyl, perfluorinated C₁ to C₆ alkoxy;
- n: can be selected 1 or 2, preferably n is 1; and
excluding compound 2, 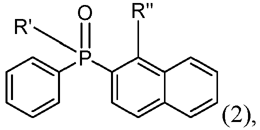 wherein R' is selected from C1 to C4 alkyl and R" is selected from 1-naphthyl, (1,1'-biphenyl)-2-yl and/or 2-methoxy-1-naphthalene-yl.

According to one embodiment of the compound of formula 1, n can be selected from 1 or 2.

According to one embodiment of the compound of formula 1, n can be selected 1. According to another embodiment of the compound of formula 1, n can be selected 2. According to another embodiment of the compound of formula 1, n can be selected 3.

According to one embodiment of the compound of formula 1, wherein R¹ can be selected from a substituted or unsubstituted C₁ to C₁₂ alkyl group, preferably from a substituted or unsubstituted C₁ to C₈ alkyl group, more preferred from a C₁ to C₆ alkyl group, also preferred from a C₁ to C₄ alkyl group,

According to one embodiment of the compound of formula 1, wherein R¹ can be selected from a substituted or unsubstituted C₁ to C₁₈ alkyl group, wherein the substituents are selected from C₆ to C₁₂ aryl, C₃ to C₁₀ heteroaryl, halogen.

According to one embodiment of the compound of formula 1, wherein Ar¹ can be selected from an unsubstituted C₆ to C₁₈ aryl, preferably from an unsubstituted C₆ to C₁₂ aryl group.

According to one embodiment of the compound of formula 1, wherein Ar¹ can be selected from an unsubstituted C₆ to C₂₄ aryl, preferably from an unsubstituted C₆ to C₁₈ aryl; and Ar¹ comprises at least one annulated aryl.

According to one embodiment of the compound of formula 1, wherein Ar¹ is free of an annulated aryl and/or annulated heteroaryl group.

According to one embodiment of formula I, wherein the Ar¹ group comprises 1 to 4 non-hetero aromatic 6 membered rings, preferably 1 to 3 non-hetero aromatic 6 membered rings; or further preferred 2 or 3 non-hetero aromatic 6 membered rings.

According to one embodiment of formula I, wherein the Ar¹ group comprises 1 to 4 non-hetero aromatic 6 membered rings, preferably 1 to 3 non-hetero aromatic 6 membered rings; or further preferred 2 or 3 non-hetero aromatic 6 membered rings; wherein at least two of the aromatic rings of the Ar¹ group may form an annulated ring system. In the present invention, "non-hetero aromatic 6 membered rings" are aryl groups which are free of heteroatoms.

According to one embodiment of formula I, wherein the Ar¹ group comprises 1 to 4 rings, preferably 1 to 3 rings; or further preferred 1 or 2 rings.

According to one embodiment of formula I, wherein the Ar¹ group can be selected from substituted or unsubstituted phenyl, biphenyl, fluorenyl, benzofluorenyl, naphthyl, phenanthryl, anthracenyl, pyrenyl.

According to one embodiment of formula I, wherein the Ar¹ group can be selected from naphthalyl, phenanthryl and/or anthracenyl, preferably naphthyl or phenynthryl.

According to one embodiment of formula I, wherein the Ar¹ group can be selected from phenyl, biphenyl or terphenyl, and preferably phenyl.

According to one embodiment of formula I, wherein the Ar¹ group can be selected from phenyl, biphenyl or naphthyl, and preferably phenyl or naphthyl.

According to another embodiment of the compound of formula 1, wherein Ar¹ may be selected from an unsubstituted C₆ to C₁₂ aryl.

According to another embodiment of the compound of formula 1, wherein Ar¹ may be selected from unsubstituted C₆ to C₂₄ aryl, preferably a C₆ or C₁₂ aryl.

According to one embodiment of formula I, wherein the Ar¹ group is free of sp³-hybridised carbon atom.

According to one embodiment of the compound of formula 1, wherein
- Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group; and/or
- Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group; and Ar² comprises at least two annulated aryl and/or at least two annulated heteroaryl groups, preferably Ar² comprises at least three annulated aryl and/or heteroaryl groups; and/or
- Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group, which is free of an annulated aryl and/or heteroaryl group, and preferably Ar² is free of an annulated aryl and/or heteroaryl group.

According to one embodiment of formula I, wherein the Ar² group can be selected from substituted or unsubstituted fluorene, benzofluorene, dibenzofluorene, 9,9'-spirobi[fluorene], 13H-indeno[1,2-1]phenanthrene, naphthalene, anthracene, phenanthrene, pyrene, perylene, triphenylene, rubrene, chrysene, fluoranthene, spiro[benzo[de]anthracene-7,9'-fluorene], acridine, benzoacridine, dibenzoacridine, quinoline, quinazoline, quinoxaline, benzoquinoline, phenanthroline, benzimidazole, , pyrimidine, pyridine, pyrazine, aza-triphenylene, carbazole, dibenzofurane, dibenzothiophene, dibenzoselenophene, aza-dibenzofuran, aza-dibenzothiophene, aza-dibenzoselenophene, di-aza-dibenzothiophene or di-aza-dibenzoselenophene.

According to one embodiment Ar² can be selected from a substituted or unsubstituted C₁₀ to C₄₂ aryl, wherein Ar² may comprises an annulated ring system. According to one embodiment Ar² can be selected from a substituted or unsubstituted C₁₀ to C₄₂ aryl, wherein Ar² may comprises an annulated ring system of at least 2 to 6 rings. According to one embodiment Ar² can be selected from a substituted or unsubstituted C₁₀ to C₄₂ aryl, wherein Ar² may comprises an annulated ring system of at least 2 to 6 aromatic 6 member rings.

According to one embodiment Ar² can be selected from a substituted or unsubstituted C₁₀ to C₄₂ aryl, wherein Ar² may comprises an annulated ring system and the Ar² group is free of two or more rings which are connected by a direct bond, preferably Ar² is free of a biphenylyl and/or terphenyl group, wherein the substituents of Ar² are excepted.

The substituents of the substituted Cio to C₄₂ aryl of Ar² can be independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵; wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl, and wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen.

According to one embodiment of the compound of formula 1, wherein Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group.

According to one embodiment of the compound of formula 1, wherein Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group; and Ar² comprises at least two annulated aryl and/or at least two annulated heteroaryl groups, preferably Ar² comprises at least three annulated aryl and/or heteroaryl groups.

According to one embodiment of the compound of formula 1, wherein Ar² can be selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group, which is free of an annulated aryl and/or heteroaryl group, and preferably Ar² is free of an annulated aryl and/or heteroaryl group.

According to one embodiment of formula I, wherein the Ar² group comprises 3 to 9 non-hetero aromatic 6 membered rings, preferably 3 to 8 non-hetero aromatic 6 membered rings; or further preferred 3 to 7 non-hetero aromatic 6 membered rings, 4 to 8 non-hetero aromatic 6 membered rings, 4 to 6 non-hetero aromatic 6 membered rings, or 4 to 8 non-hetero aromatic 6 membered rings.

According to one embodiment of formula I, wherein the Ar² group comprises 3 to 9 non-hetero aromatic 6 membered rings, preferably 3 to 8 non-hetero aromatic 6 membered rings; or further preferred 3 to 7 non-hetero aromatic 6 membered rings, 4 to 8 non-hetero aromatic 6 membered rings, 4 to 6 non-hetero aromatic 6 membered rings, or 4 to 8 non-hetero aromatic 6 membered rings; wherein the aromatic rings of the Ar² group may form an annulated ring system.

According to one embodiment of formula I, wherein the Ar² group comprises 1 to 9 hetero aromatic 6 membered rings, preferably 1 to 7 hetero aromatic 6 membered rings; or further preferred 1 to 5 hetero aromatic 6 membered rings, 1 to 4 hetero aromatic 6 membered rings, 1 to 3 hetero aromatic 6 membered rings, more preferred 1 or 2 hetero aromatic 6 membered rings.

According to one embodiment of formula I, wherein the Ar² group comprises 1 to 9 hetero aromatic 6 membered rings, preferably 1 to 7 hetero aromatic 6 membered rings; or further preferred 1 to 5 hetero aromatic 6 membered rings, 1 to 4 hetero aromatic 6 membered rings, 1 to 3 hetero aromatic 6 membered rings, more preferred 1 or 2 hetero aromatic 6 membered rings; wherein the aromatic rings of the Ar² group may form an annulated ring system.

According to one embodiment of formula I, wherein the Ar² group comprises 1 to 9 hetero aromatic 5 membered rings, preferably 1 to 7 hetero aromatic 5 membered rings; or further preferred 1 to 5 hetero aromatic 5 membered rings, 1 to 4 hetero aromatic 5 membered rings, 1 to 3 hetero aromatic 5 membered rings, more preferred 1 or 2 hetero aromatic 5 membered rings.

According to one embodiment of formula I, wherein the Ar² group comprises 1 to 9 hetero aromatic 5 membered rings, preferably 1 to 7 hetero aromatic 5 membered rings; or further preferred 1 to 5 hetero aromatic 5 membered rings, 1 to 4 hetero aromatic 5 membered rings, 1 to 3 hetero aromatic 5 membered rings, more preferred 1 or 2 hetero aromatic 5 membered rings; wherein the aromatic rings of the Ar² group may form an annulated ring system.

According to one embodiment of formula I, wherein the Ar² group comprises 1 to 9 hetero aromatic 5 membered rings, preferably 1 to 7 hetero aromatic 5 membered rings; or further preferred 1 to 5 hetero aromatic 5 membered rings, 1 to 4 hetero aromatic 5 membered rings, 1 to 3 hetero aromatic 5 membered rings, more preferred 1 or 2 hetero aromatic 5 membered rings.

According to one embodiment of formula I, wherein the Ar² group comprises 1 to 9 hetero aromatic 5 membered rings, preferably 1 to 7 hetero aromatic 5 membered rings; or further preferred 1 to 5 hetero aromatic 5 membered rings, 1 to 4 hetero aromatic 5 membered rings, 1 to 3 hetero aromatic 5 membered rings, more preferred 1 or 2 hetero aromatic 5 membered rings; wherein the aromatic rings of the Ar² group may form an annulated ring system.

According to one embodiment of formula I, wherein the Ar² group comprises 1 to 10 rings, preferably 2 to 9 rings; or further preferred 3 to 8 rings, 4 to 7 rings, 5 to 7 rings, more preferred 5 to 8 rings.

According to one embodiment of formula I, wherein the Ar² group comprises 1 to 10 rings, preferably 2 to 9 rings; or further preferred 3 to 8 rings, 4 to 7 rings, 5 to 7 rings, more preferred 5 to 8 rings; and wherein the Ar² group comprises at least one, preferably two or three annulated ring system.

According to one embodiment of formula I, wherein the Ar² group comprises 1 to 10 rings, preferably 2 to 9 rings; or further preferred 3 to 8 rings, 4 to 7 rings, 5 to 7 rings, more preferred 5 to 8 rings; and wherein the Ar² group comprises at least one, preferably two or three annulated ring systems; wherein the annulated ring system can be optional selected from naphthalene and/or anthracene.

According to one embodiment of formula I, wherein the Ar² group comprises 1 to 10 rings, preferably 2 to 9 rings; or further preferred 3 to 8 rings, 4 to 7 rings, 5 to 7 rings, more preferred 5 to 8 rings; and wherein the Ar² group comprises at least one annulated ring system of anthracene.

According to one embodiment of formula I, wherein the Ar¹ group can be selected from substituted or unsubstituted phenyl, biphenyl, fluorenyl, benzofluorenyl, naphthyl, phenanthryl, anthracenyl, pyrenyl; and/or the Ar² group can be selected from substituted or unsubstituted fluorene, benzofluorene, dibenzofluorene, 9,9'-spirobi[fluorene], 13H-indeno[1,2-l]phenanthrene, naphthalene, anthracene, phenanthrene, pyrene, perylene, triphenylene, rubrene, chrysene, fluoranthene, spiro[benzo[de]anthracene-7,9'-fluorene], acridine, benzoacridine, dibenzoacridine, quinoline, quinazoline, quinoxaline, benzoquinoline, phenanthroline, benzimidazole, , pyrimidine, pyridine, pyrazine, aza-triphenylene, carbazole, dibenzofurane, dibenzothiophene, dibenzoselenophene, aza-dibenzofuran, aza-dibenzothiophene, aza-dibenzoselenophene, di-aza-dibenzothiophene, di-aza-dibenzoselenophene.

According to one embodiment of formula I, wherein the Ar¹ group and/ or Ar² group comprises 0 or 1 sp³-hybridised carbon atoms.

According to one embodiment of formula I, wherein the Ar¹ group and/ or Ar² group is free of sp³-hybridised carbon atoms.

According to one embodiment of formula I, wherein the Ar² group is selected from a C1 to C35 group: 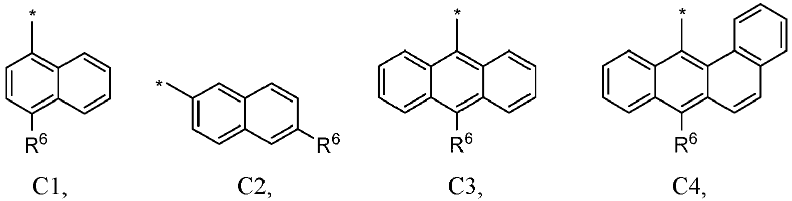 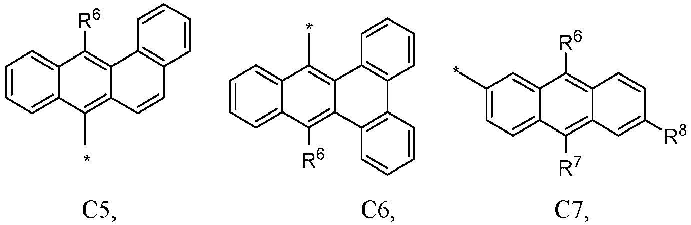 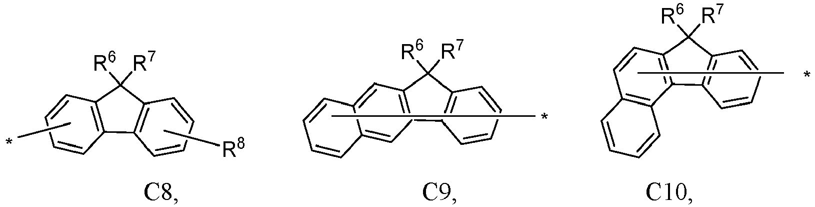 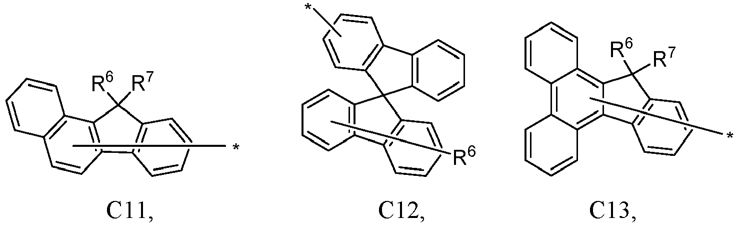 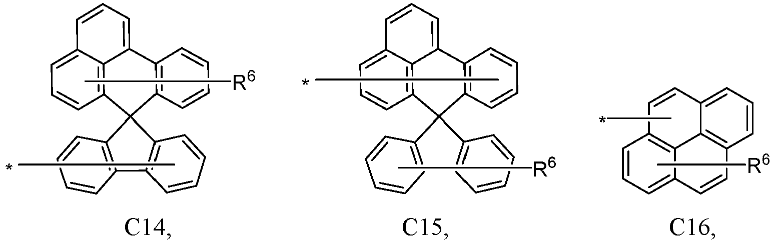 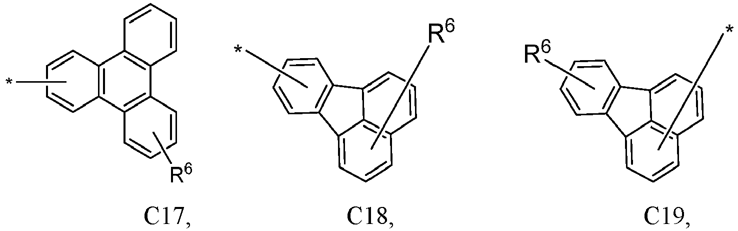 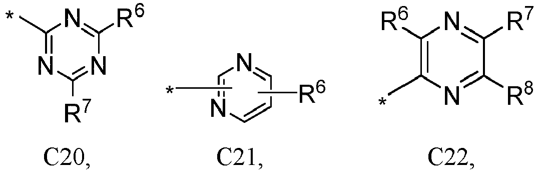 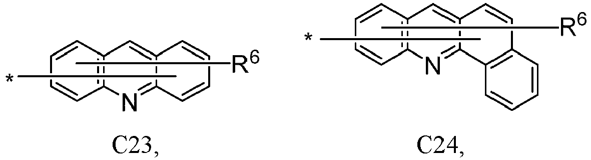 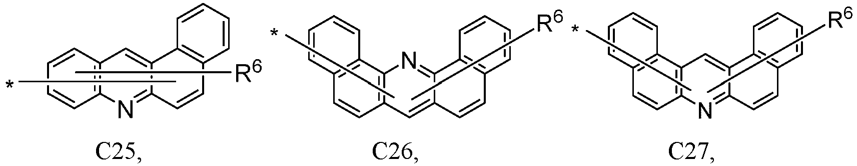 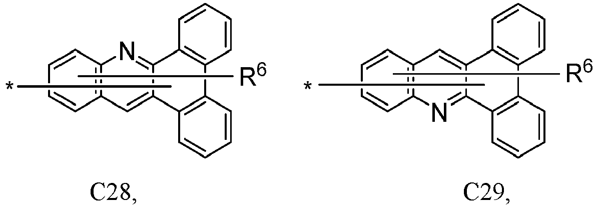 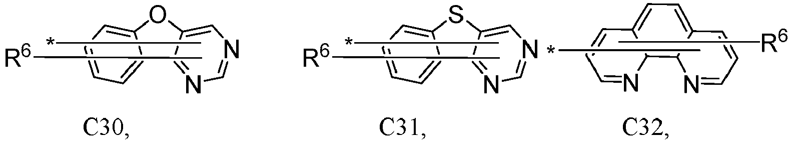 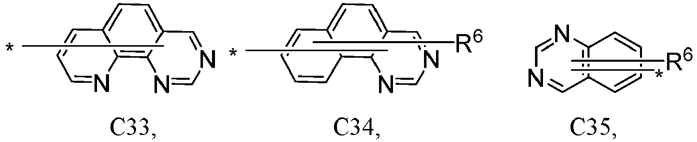 wherein
R⁶, R⁷ and R⁸ are independently selected from H, C₁ to C₁₆ alkyl, C₁ to C₁₆ alkoxy, substituted or unsubstituted C₆ to C₂₄ aryl, substituted or unsubstituted C₃ to C₂₄ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl;
   the substituent of the substituted C₆ to C₂₄ aryl and of the substituted C₃ to C₂₄ heteroaryl are selected from C₁ to C₁₆ alkyl, C₁ to C₁₆ alkoxy, C₆ to C₁₈ aryl, C₄ to C₁₈ heteroaryl, CN, halogen;
   preferably, R⁶, R⁷ and R⁸ are independently selected from H, substituted or unsubstituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl, PXR³R⁴, L-PXR³R⁴ or COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl; and
   the substituent of the substituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl are independently selected from C₁ to C₁₆ alkyl, C₁ to C₁₆ alkoxy, C₆ to C₁₈ aryl, C₄ to C₁₈ heteroaryl, CN, halogen.

According to one embodiment of formula I, wherein R⁶, R⁷ and R⁸ are independently selected from H, substituted or unsubstituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl, PXR³R⁴, L-PXR³R⁴, COR⁵; wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl; and the substituent of the substituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl are independently selected from C₁ to C₁₆ alkyl, C₁ to C₁₆ alkoxy, C₆ to C₁₈ aryl, C₄ to C₁₈ heteroaryl, CN, halogen.

According to one embodiment of formula I, wherein the substituents of the substituted aryl of the Ar² group, preferably the substituents of the substituted C₁₀ to C₄₂ aryl, or the substituents of the substituted heteroaryl of the Ar² group, preferably the substituents of the substituted heteroaryl C₃ to C₄₂ heteroaryl, or the substituents of the C1 to C35 groups, can be independently selected from halogen, CN or D1 to D59:

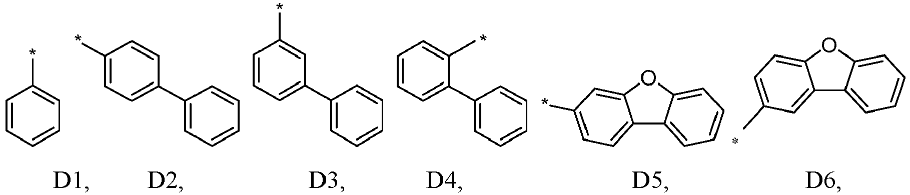

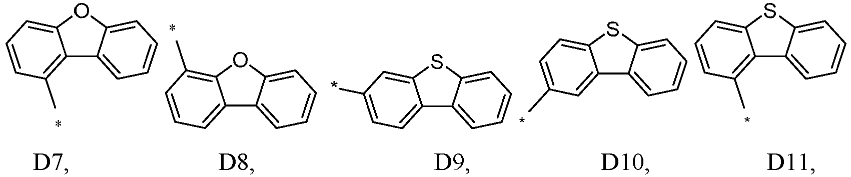

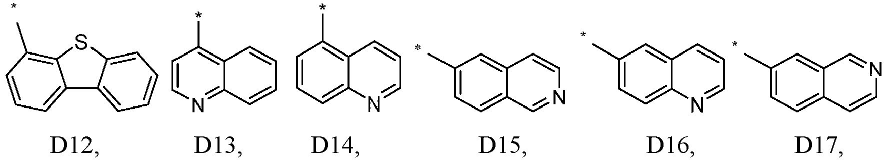

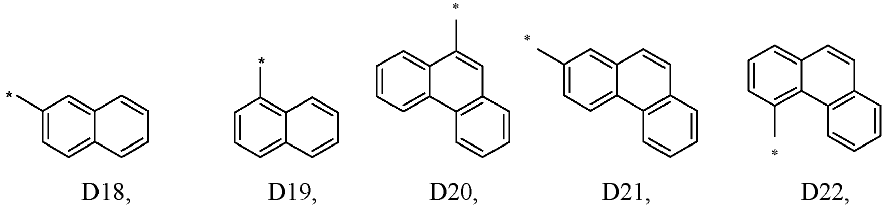

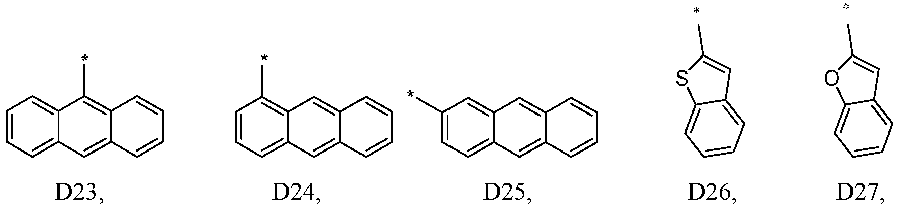

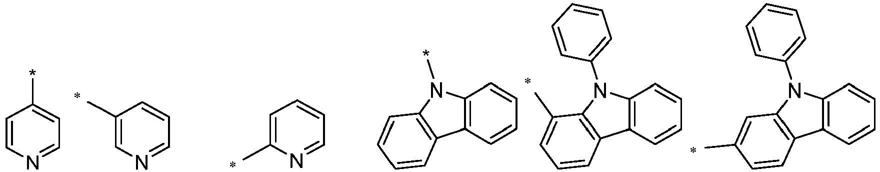

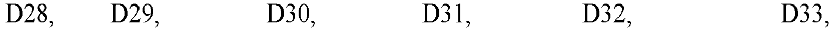

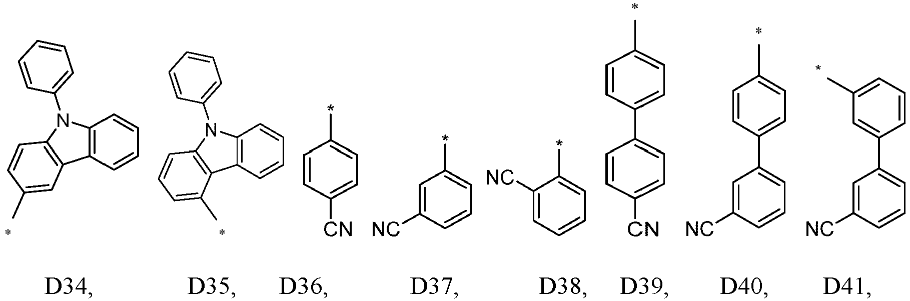

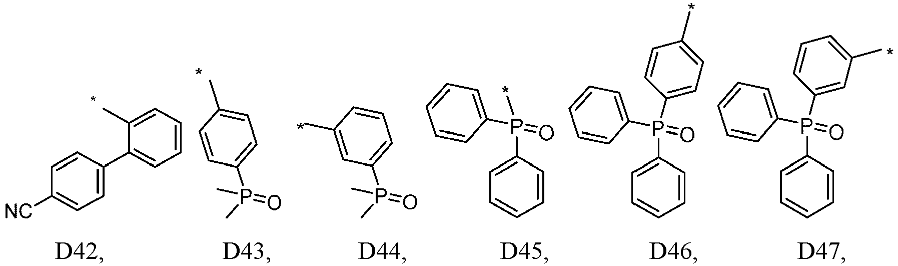

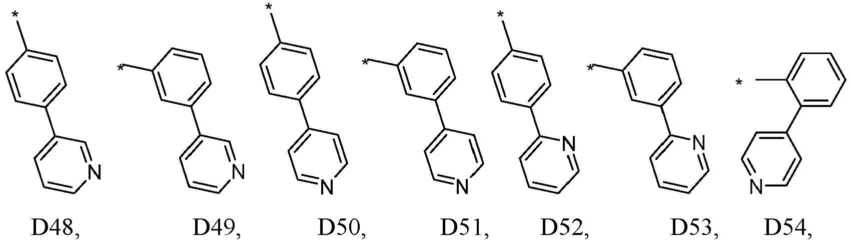

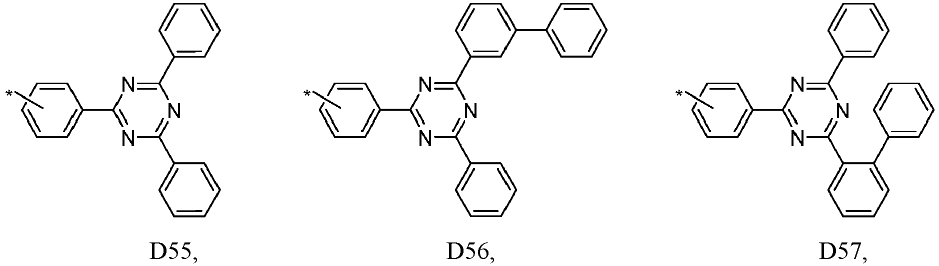

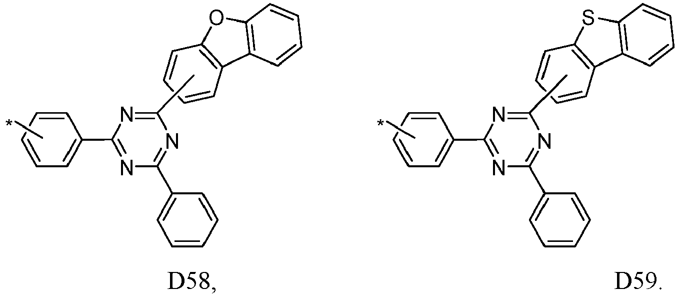

According to one embodiment of formula I, wherein L is selected from substituted or unsubstituted phenylene, biphenylene, terphenylene, naphthylene, anthracenylene, fluorenylene, carbazolylene, pyridylene, pyrimidinylene, triazinylene,
wherein the substituent is selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy.

According to one embodiment of formula I, wherein L is selected from unsubstituted phenylene, biphenylene, terphenylene, naphthylene, anthracenylene, fluorenylene, carbazolylene, pyridylene, pyrimidinylene, triazinylene.

According to one embodiment of formula I, wherein L is selected from substituted or unsubstituted phenylene, biphenylene, terphenylene, naphthylene, anthracenylene, fluorenylene, E20, E21, E22 and E23, wherein the substituent is selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy.

According to one embodiment of formula I, wherein L is selected from a group of E1 to E23: 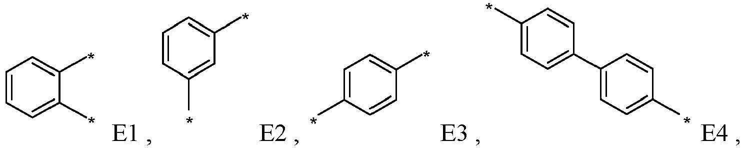 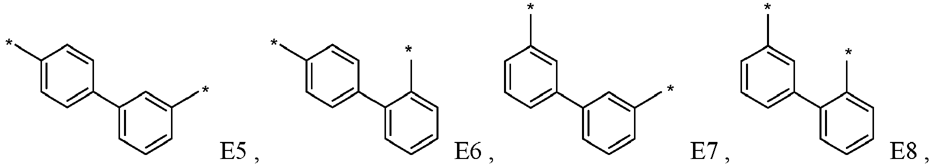 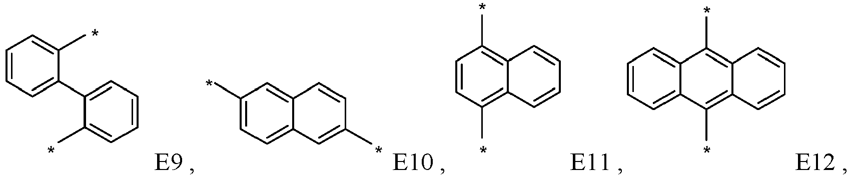 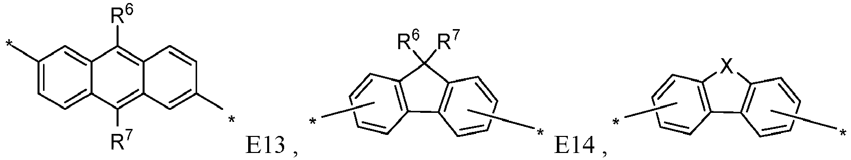 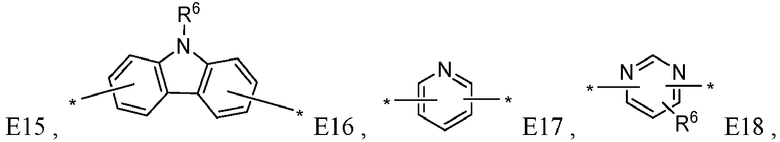 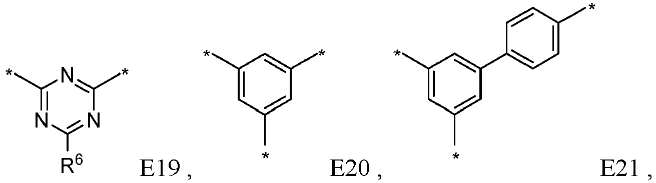 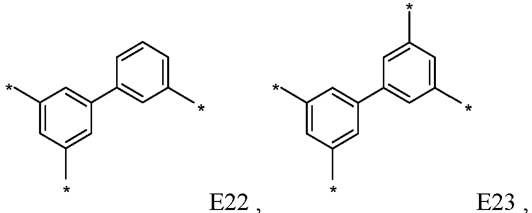 wherein R⁶ and R⁷ are independently selected from H, C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy, or R⁶ and R⁷ may form an annulated ring, wherein the annulated ring can be E24 or E25:

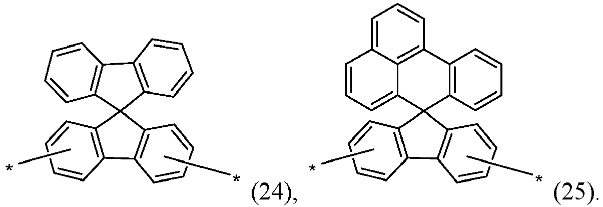

According to another embodiment of formula I, wherein R⁶ and R⁷ are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy.

According to another embodiment of formula I, wherein L may be selected from E1 to E14, preferably from E1 to E12, further preferred from E1 to E8 and more preferred from E2 or E3.

According to another embodiment of formula 1, wherein L may be selected from E2, E5 and E7, more preferred from E2 and E7.

According to another embodiment of formula I, wherein L may be selected from E15 to E19, preferably from E15.

According to another embodiment of formula 1, wherein L may be selected from E1 to E14 and E20 to E23, preferably from E2 to E9 and E20 to E23, more preferred from E2 to E7 and E20 to E23.

According to another embodiment, compound of formula 1 may be free of carbazole and/or indolo-carbazole groups.

According to another embodiment, wherein the compound of formula 1 is selected from F1 to F30:

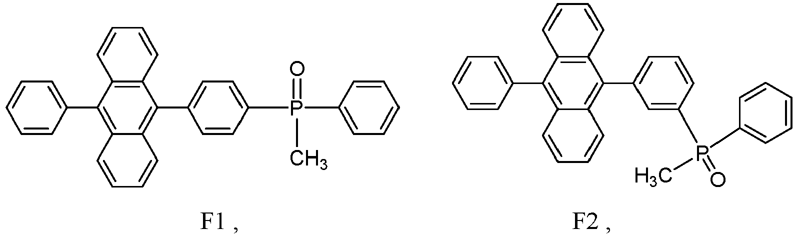

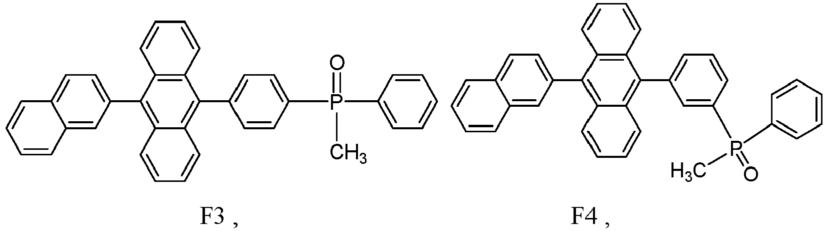

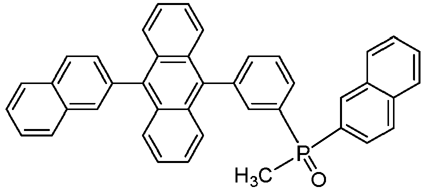

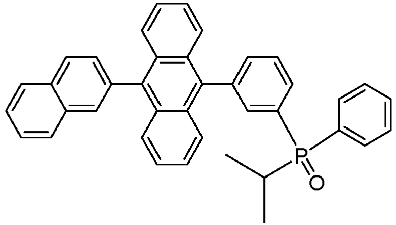

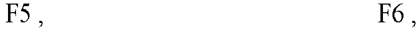

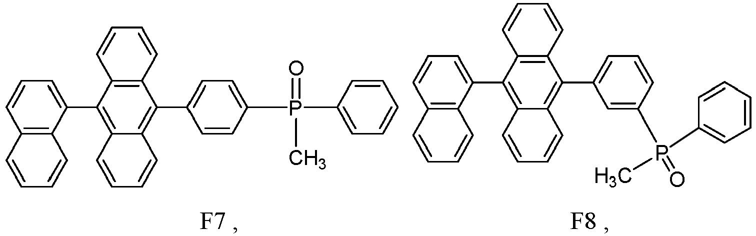

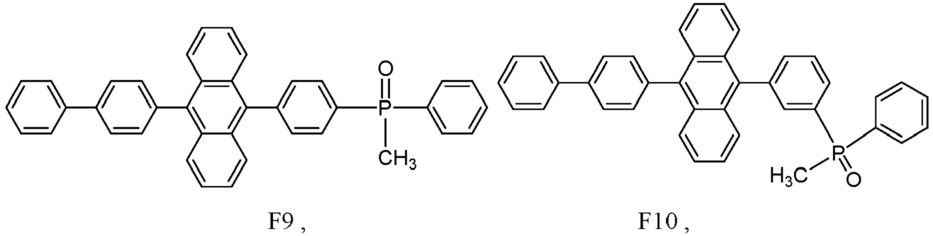

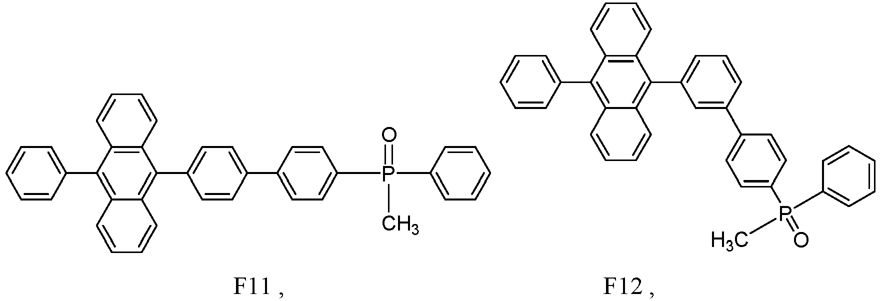

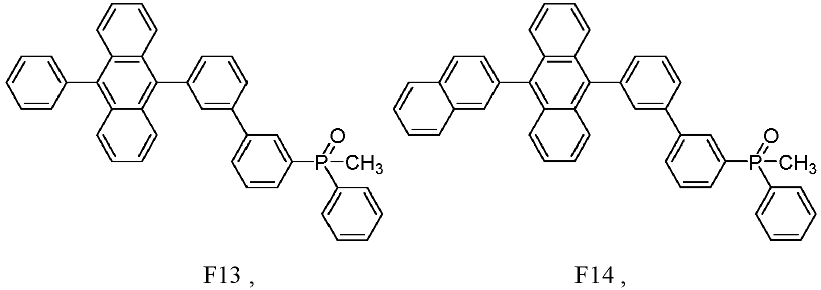

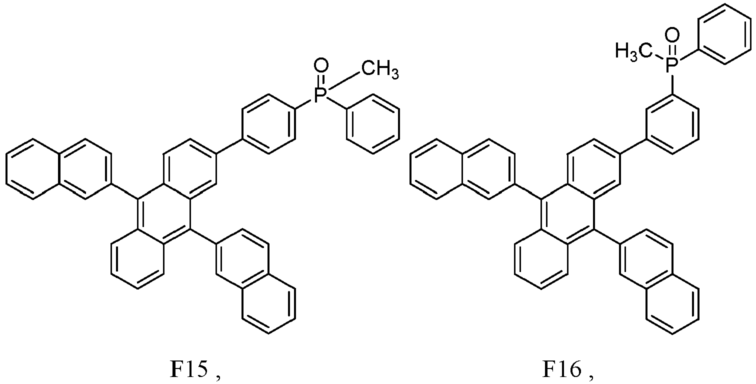

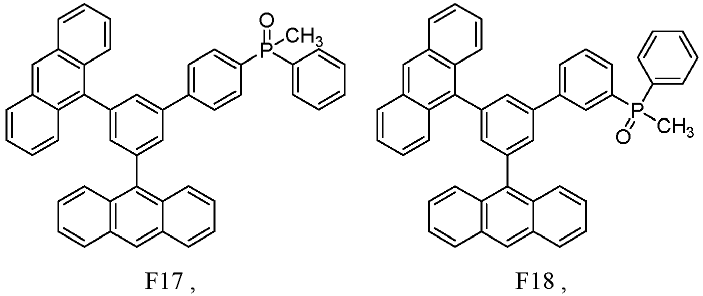

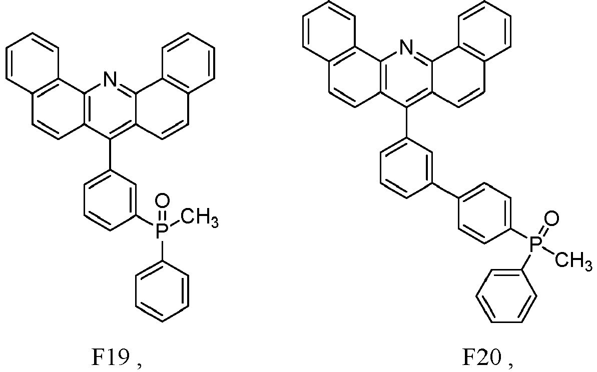

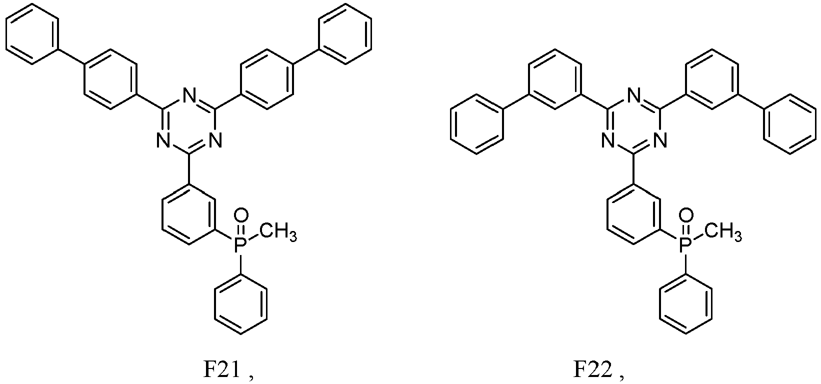

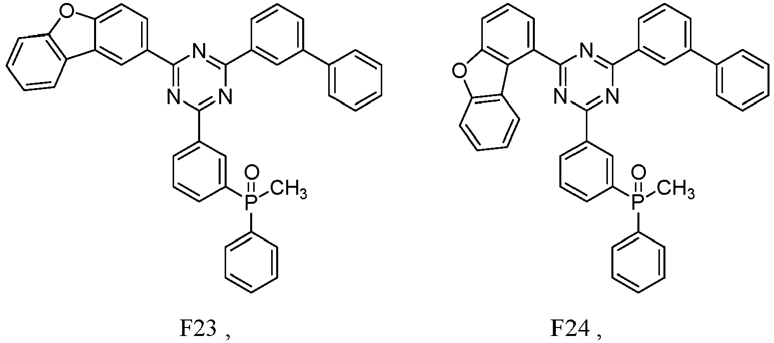

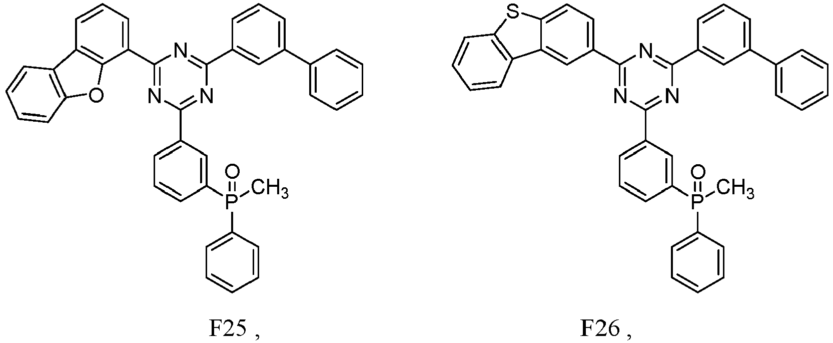

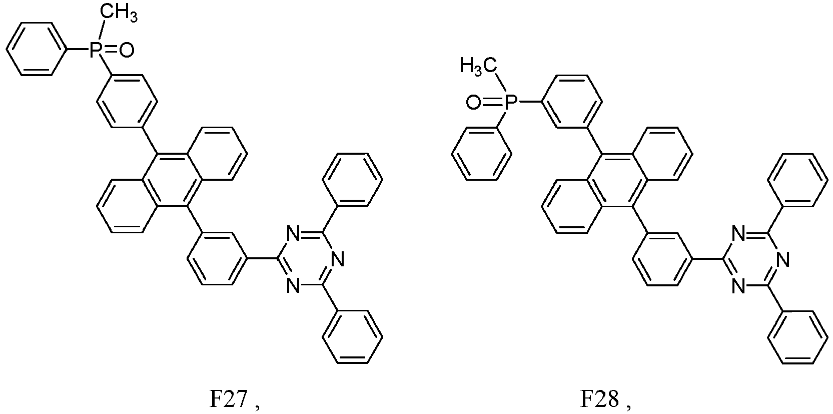

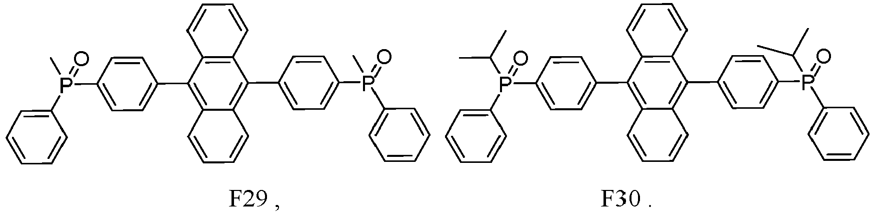

According to an aspect the compound of formula 1 can be used as a matrix material for an organic semiconductor layer.

According to an aspect the compound of formula 1 can be used as a matrix material for an organic semiconductor layer selected from the group comprising electron transport layer, electron injection layer (EIL) or electron generation layer, and preferably an electron transport layer (ETL).

Compounds represented by formula 1 may have improved melting points, glass transition temperatures, rate onset temperatures and strong electron injection and transport characteristics to increase charge injection, mobility and/or stability and thereby to improve luminance efficiency, voltage characteristics, and/or lifetime characteristics.

Compounds represented by formula 1 and an organic semiconductor layer consisting or comprising of a compound of formula 1 may be non-emissive.

In the context of the present specification the term "essentially non-emissive" or "non-emitting" means that the contribution of compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

Preferably, the organic semiconductor layer comprising a compound of formula 1 is essentially non-emissive or non-emitting.

The term "free of', "does not contain", "does not comprise" does not exclude impurities which may be present in compounds prior to deposition. Impurities have no technical effect with respect to the object achieved by the present invention.

The operating voltage, also named U, is measured in Volt (V) at 10 milliAmpere per square centimeter (mA/cm2).

The candela per Ampere efficiency, also named cd/A efficiency, is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color.

The highest occupied molecular orbital, also named HOMO, and lowest unoccupied molecular orbital, also named LUMO, are measured in electron volt (eV).

The rate onset temperature is measured in °C and describes the VTE source temperature at which measurable evaporation of a compound commences at a pressure of less than 10⁻⁵ mbar.

The term "OLED", "organic light emitting diode", "organic light emitting device", "organic optoelectronic device" and "organic light-emitting diode" are simultaneously used and have the same meaning.

The term "transition metal" means and comprises any element in the d-block of the periodic table, which comprises groups 3 to 12 elements on the periodic table.

The term "group III to VI metal" means and comprises any metal in groups III to VI of the periodic table.

As used herein, "weight percent", "wt.-%", "percent by weight", "% by weight", and variations thereof refer to a composition, component, substance or agent as the weight of that composition, component, substance or agent of the respective electron transport layer divided by the total weight of the composition thereof and multiplied by 100. It is understood that the total weight percent amount of all components, substances or agents of the respective electron transport layer are selected such that it does not exceed 100 wt.-%.

As used herein, "volume percent", "vol.-%", "percent by volume", "% by volume", and variations thereof refer to an elemental metal, a composition, component, substance or agent as the volume of that elemental metal, component, substance or agent of the respective electron transport layer divided by the total volume of the respective electron transport layer thereof and multiplied by 100. It is understood that the total volume percent amount of all elemental metal, components, substances or agents of the respective cathode electrode layer are selected such that it does not exceed 100 vol.-%.

All numeric values are herein assumed to be modified by the term "about", whether or not explicitly indicated. As used herein, the term "about" refers to variation in the numerical quantity that can occur.

Whether or not modified by the term "about", the claims include equivalents to the quantities.

It should be noted that, as used in this specification and the appended claims, the singular forms "a", "an", and "the" include plural referents unless the content clearly dictates otherwise.

It should be noted that, as used in this specification and the appended claims, "*" if not otherwise defined indicates the chemical bonding position.

The anode electrode and cathode electrode may be described as anode electrode / cathode electrode or anode electrode / cathode electrode or anode electrode layer / cathode electrode layer.

According to another aspect, an organic optoelectronic device comprises an anode layer and a cathode layer facing each other and at least one organic semiconductor layer between the anode layer and the cathode layer, wherein the organic semiconductor layer comprises or consists of compound of formula 1.

According to yet another aspect, a display device comprising the organic electronic device, which can be an organic optoelectronic device, is provided.

In the present specification, when a definition is not otherwise provided, an "alkyl group" may refer to an aliphatic hydrocarbon group. The alkyl group may refer to "a saturated alkyl group" without any double bond or triple bond. The alkyl group may be a linear, cyclic or branched alkyl group.

The term "alkyl group" includes C₁ to C₁₆ alkyl, C₃ to C₁₆ branched alkyl.

The alkyl group may be a C₁ to C₁₆ alkyl group, or preferably a C₁ to C₁₂ alkyl group. More specifically, the alkyl group may be a C₁ to C₁₄ alkyl group, or preferably a C₁ to C₁₀ alkyl group or a C₁ to C₆ alkyl group. For example, a C₁ to C₄ alkyl group comprises 1 to 4 carbons in alkyl chain, and may be selected from methyl, ethyl, propyl, iso-propyl, n-butyl, iso-butyl, sec-butyl, and t-butyl.

Specific examples of the alkyl group may be a methyl group, an ethyl group, a propyl group, an isopropyl group, a butyl group, an isobutyl group, a tert-butyl group, a pentyl group, a hexyl group, a cyclopropyl group, a cyclobutyl group, a cyclopentyl group, a cyclohexyl group, and the like.

In the present specification R³ and R⁴ of PXR³R⁴ and L-PXR³R⁴ can be independently selected from C₁ to C₁₆ alkyl, C₁ to C₁₆ alkoxy, partially or perfluorinated C₁ to C₁₆ alkyl, partially or perfluorinated C₁ to C₁₆ alkoxy, partially or perdeuterated C₁ to C₁₆ alkyl, partially or perdeuterated C₁ to C₁₆ alkoxy, C₆ to C₁₈ aryl, C₃ to C₂₅ heteroaryl.

In the present specification "arylene group" may refer to a group comprising at least one hydrocarbon aromatic moiety, and all the elements of the hydrocarbon aromatic moiety may have p-orbitals which form conjugation, for example a phenyl group, a naphthyl group, an anthracenyl group, a phenanthrenyl group, a pyrenyl group, a fluorenyl group and the like.

The term "heteroarylene" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S.

A heteroarylene ring may comprise at least 1 to 3 heteroatoms. Preferably a heteroarylene ring may comprise at least 1 to 3 heteroatoms individually selected from N, S and/or O.

A compound according to formula 1 may comprise at least 1 to 3 N-atoms, or at least 1 to 2-N atoms or at least one N-atom.

According to another preferred embodiment a compound according to formula 1 may comprise:
- at least 6 to 25 aromatic rings, preferably at least 7 to 22 aromatic rings, further preferred at least 8 to 20 aromatic rings, in addition preferred at least 9 to 15 aromatic rings and more preferred at least 10 to 14 aromatic rings; wherein
- at least 2 to 5, preferably 3 to 4 or 2 to 3, are heteroaromatic rings.

According to one embodiment a compound according to formula 1:
- comprises at least about 6 to about 20 aromatic rings, preferably at least about 7 to about 18 aromatic rings, further preferred at least about 9 to about 16 aromatic rings, in addition preferred at least about 10 to about 15 aromatic rings and more preferred at least about 11 to about 14 aromatic rings; and/or
- compound of formula 1 comprises at least about 2 to about 6, preferably about 3 to about 5 or about 2 to about 4 hetero aromatic rings, wherein the hetero atoms can be selected from N, O, S; and/or
- comprises at least one fluorene ring and at least one hetero-fluorene ring, wherein the hetero atoms can be selected from N, O, S; and/or
- comprises at least two rings.

According to a further preferred embodiment a compound of formula 1 comprises at least 2 to 7, preferably 2 to 5, or 2 to 3 hetero aromatic rings.

According to a further preferred embodiment a compound of formula 1 comprises at least 2 to 7, preferably 2 to 5, or 2 to 3 hetero aromatic rings, wherein at least one of the aromatic rings is a five member hetero aromatic ring.

According to a further preferred embodiment a compound of formula 1 comprises at least 3 to 7, preferably 3 to 6, or 3 to 5 hetero aromatic rings, wherein at least two of the hetero aromatic rings are five member hetero-aromatic-rings.

According to one embodiment a compound according to formula 1 may comprise at least 6 to 12 non-hetero aromatic rings and 2 to 3 hetero aromatic rings.

According to one preferred embodiment a compound according to formula 1 may comprise at least 7 to 12 non-hetero aromatic rings and 2 to 5 hetero aromatic rings.

According to one preferred embodiment a compound according to formula 1 may comprise at least 7 to 11 non-hetero aromatic rings and 2 to 3 hetero aromatic rings.

According to another embodiment of formula 1, wherein at least one heteroarylene group may be selected from pyridinyl, pyrimidinyl, triazinyl, quinolinyl or quinazolinyl.

### Melting point

The melting point (mp) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 µL Mettler Toledo aluminum pan with lid, a <1 mm hole is pierced into the lid).

According to another embodiment a compound of formula 1 may have a melting point of about ≥ 240° C and about ≤ 380° C, preferably about ≥ 250° C and about ≤ 370° C, further preferred about ≥ 250° C and about ≤ 360° C.

### Glass transition temperature

The glass transition temperature is measured under nitrogen and using a heating rate of 10 K per min in a Mettler Toledo DSC 822e differential scanning calorimeter as described in DIN EN ISO 11357, published in March 2010.
According to another embodiment a compound of formula 1 may have a glass transition temperature Tg of about ≥ 100° C and about ≤ 380° C, preferably about ≥ 105° C and about ≤ 350° C, further preferred about ≥ 105° C and about ≤ 320° C.

### Rate onset temperature

The rate onset temperature is determined by loading 100 mg compound into a VTE source. As VTE source a point source for organic materials is used as supplied by Kurt J. Lesker Company (www.lesker.com) or CreaPhys GmbH (http://www.creaphys.com). The VTE source is heated at a constant rate of 15 K/min at a pressure of less than 10⁻⁵ mbar and the temperature inside the source measured with a thermocouple. Evaporation of the compound is detected with a QCM detector which detects deposition of the compound on the quartz crystal of the detector. The deposition rate on the quartz crystal is measured in Angstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low takt time and decomposition of the organic compound in VTE source may occur due to prolonged exposure to elevated temperatures.

The rate onset temperature is an indirect measure of the volatility of a compound. The higher the rate onset temperature the lower is the volatility of a compound.
According to another embodiment a compound of formula 1 may have a rate onset temperature T_{RO} of about ≥ 200° C and about ≤ 350° C.

### Technical effect

Surprisingly, it was found that compounds of formula 1 and the inventive organic electronic devices solve the problem underlying the present invention by being superior over the organic electroluminescent devices and compounds known in the art, in particular with respect to rate onset temperature, cd/A efficiency, also referred to as current efficiency, and to lifetime. At the same time the operating voltage is kept at a similar or even improved level which is important for reducing power consumption and increasing battery life, for example of a mobile display device. High cd/A efficiency is important for high efficiency and thereby increased battery life of a mobile device, for example a mobile display device. Long lifetime at high current density is important for the longevity of a device which is run at high brightness.

The inventors have surprisingly found that particular good performance can be achieved when using the organic electroluminescent device as a fluorescent blue device.

The specific arrangements mentioned herein as preferred were found to be particularly advantageous.

Likewise, some compounds falling within the scope of the broadest definition of the present invention have surprisingly be found to be particularly well performing with respect to the mentioned property of cd/A efficiency and/or lifetime. These compounds are discussed herein to be particularly preferred.

Further an organic optoelectronic device having high efficiency and/or long lifetime may be realized.

### Anode

A material for the anode may be a metal or a metal oxide, or an organic material, preferably a material with work function above about 4.8 eV, more preferably above about 5.1 eV, most preferably above about 5.3 eV. Preferred metals are noble metals like Pt, Au or Ag, preferred metal oxides are transparent metal oxides like ITO or IZO which may be advantageously used in bottom-emitting OLEDs having a reflective cathode.

In devices comprising a transparent metal oxide anode or a reflective metal anode, the anode may have a thickness from about 50 nm to about 100 nm, whereas semitransparent metal anodes may be as thin as from about 5 nm to about 15 nm, and non-transparent metal anodes may have a thickness from about 15 nm to about 150 nm.

### Hole injection layer (HIL)

The hole injection layer may improve interface properties between the anode and an organic material used for the hole transport layer, and is applied on a non-planarized anode and thus may planarize the surface of the anode. For example, the hole injection layer may include a material having a median value of the energy level of its highest occupied molecular orbital (HOMO) between the work function of the anode material and the energy level of the HOMO of the hole transport layer, in order to adjust a difference between the work function of the anode and the energy level of the HOMO of the hole transport layer.

When the hole transport region comprises a hole injection layer 36, the hole injection layer may be formed on the anode by any of a variety of methods, for example, vacuum deposition, spin coating, casting, Langmuir-Blodgett (LB) method, or the like.

When hole injection layer is formed using vacuum deposition, vacuum deposition conditions may vary depending on the material that is used to form the hole injection layer, and the desired structure and thermal properties of the hole injection layer to be formed and for example, vacuum deposition may be performed at a temperature of about 100 °C to about 500 °C, a pressure of about 10⁻⁶ Pa to about 10⁻¹ Pa, and a deposition rate of about 0.1 to about 10 nm/sec, but the deposition conditions are not limited thereto.

When the hole injection layer is formed using spin coating, the coating conditions may vary depending on the material that is used to form the hole injection layer, and the desired structure and thermal properties of the hole injection layer to be formed. For example, the coating rate may be in the range of about 2000 rpm to about 5000 rpm (wherein 1 rpm = 1/60 Hz), and a temperature at which heat treatment is performed to remove a solvent after coating may be in a range of about 80 °C to about 200 °C, but the coating conditions are not limited thereto.

The hole injection layer may further comprise a p-dopant to improve conductivity and/or hole injection from the anode.

### p-dopant

In another aspect, the p-dopant may be homogeneously dispersed in the hole injection layer.

In another aspect, the p-dopant may be present in the hole injection layer in a higher concentration closer to the anode and in a lower concentration closer to the cathode.

The p-dopant may be one of a quinone derivative or a radialene compound but not limited thereto. Non-limiting examples of the p-dopant are quinone derivatives such as tetracyanoquinonedimethane (TCNQ), 2,3,5,6-tetrafluoro-tetracyano-1,4-benzoquinonedimethane (F4-TCNQ), 4,4',4"-((1E,1'E,1"E)-cyclopropane-1,2,3-triylidenetris(cyanomethanylylidene))-tris(2,3,5,6-tetrafluorobenzonitrile).

According to another embodiment, the device comprising a compound of formula 1 may further comprise a layer comprising a radialene compound and/or a quinodimethane compound.

In another embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have formula (XX) and/or the quinodimethane compound may have formula (XXIa) or (XXIb): 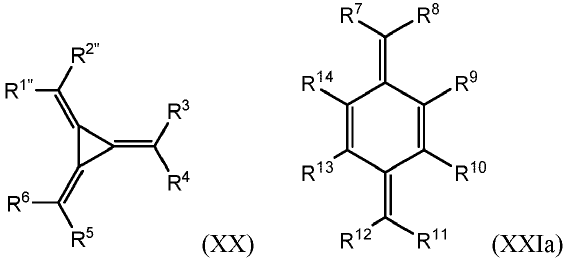 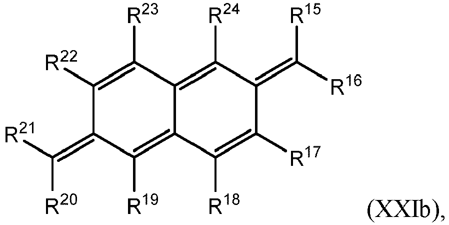 wherein R^{1"}, R^{2"}, R³, R⁴, R⁵, R⁶, R⁷, R⁸, R¹¹, R¹², R¹⁵, R¹⁶, R²⁰, R²¹ are independently selected from an electron withdrawing groups and R⁹, R¹⁰, R¹³, R¹⁴, R¹⁷, R¹⁸, R¹⁹, R²², R²³ and R²⁴ are independently selected from H, halogen and electron withdrawing groups. Electron withdrawing group that can be suitable used are above mentioned.

### Hole transport layer (HTL)

Conditions for forming the hole transport layer and the electron blocking layer may be defined based on the above-described formation conditions for the hole injection layer.

A thickness of the hole transport part of the charge transport region may be from about 10 nm to about 1000 nm, for example, about 10 nm to about 100 nm. When the hole transport part of the charge transport region comprises the hole injection layer and the hole transport layer, a thickness of the hole injection layer may be from about 10 nm to about 1000 nm, for example about 10 nm to about 100 nm and a thickness of the hole transport layer may be from about 5 nm to about 200 nm, for example about 10 nm to about 150 nm. When the thicknesses of the hole transport part of the charge transport region, the HIL, and the HTL are within these ranges, satisfactory hole transport characteristics may be obtained without a substantial increase in operating voltage.

Hole transport matrix materials used in the hole transport region are not particularly limited. Preferred are covalent compounds comprising a conjugated system of at least 6 delocalized electrons, preferably organic compounds comprising at least one aromatic ring, more preferably organic compounds comprising at least two aromatic rings, even more preferably organic compounds comprising at least three aromatic rings, most preferably organic compounds comprising at least four aromatic rings. Typical examples of hole transport matrix materials which are widely used in hole transport layers are polycyclic aromatic hydrocarbons, triarylene amine compounds and heterocyclic aromatic compounds. Suitable ranges of frontier orbital energy levels of hole transport matrices useful in various layer of the hole transport region are well-known. In terms of the redox potential of the redox couple HTL matrix/ cation radical of the HTL matrix, the preferred values (if measured for example by cyclic voltammetry against ferrocene/ferrocenium redox couple as reference) may be in the range 0.0 - 1.0 V, more preferably in the range 0.2 - 0.7 V, even more preferably in the range 0.3 - 0.5 V.

### Buffer layer

The hole transport part of the charge transport region may further include a buffer layer.

Buffer layer that can be suitable used are disclosed in US 6 140 763, US 6 614 176 and in US2016/248022.

The buffer layer may compensate for an optical resonance distance of light according to a wavelength of the light emitted from the EML, and thus may increase efficiency.

### Emission layer (EML)

The emission layer may be formed on the hole transport region by using vacuum deposition, spin coating, casting, LB method, or the like. When the emission layer is formed using vacuum deposition or spin coating, the conditions for deposition and coating may be similar to those for the formation of the hole injection layer, though the conditions for the deposition and coating may vary depending on the material that is used to form the emission layer. The emission layer may include an emitter host (EML host) and an emitter dopant (further only emitter).

A thickness of the emission layer may be about 100Å to about 1000Å, for
example about 200Å to about 600Å. When the thickness of the emission layer is within these ranges, the emission layer may have improved emission characteristics without a substantial increase in operating voltage.

### Emitter host

According to another embodiment, the emission layer comprises compound of formula 1 as emitter host.

The emitter host compound has at least three aromatic rings, which are independently selected from carbocyclic rings and heterocyclic rings.

Other compounds that can be used as the emitter host is an anthracene matrix compound represented by formula 400 below:

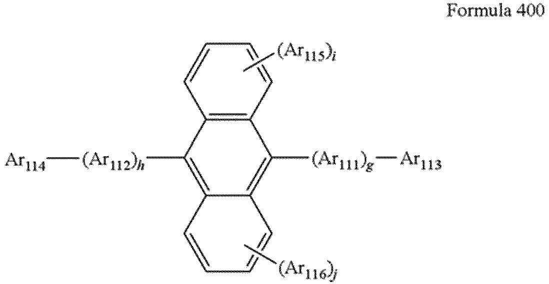

In formula 400, Arm and Ar₁₁₂ may be each independently a substituted or unsubstituted C₆-C₆₀ arylene group; Ar₁₁₃ to Ar₁₁₆ may be each independently a substituted or unsubstituted C₁-C₁₀ alkyl group or a substituted or unsubstituted C₆-C₆₀ arylene group; and g, h, i, and j may be each independently an integer from 0 to 4.

In some embodiments, Arm and Ar₁₁₃ in formula 400 may be each independently one of a phenylene group, a naphthalene group, a phenanthrenylene group, or a pyrenylene group; or
a phenylene group, a naphthalene group, a phenanthrenylene group, a fluorenyl group, or a pyrenylene group, each substituted with at least one of a phenyl group, a naphthyl group, or an anthryl group.

In formula 400, g, h, i, and j may be each independently an integer of 0, 1, or 2.

In formula 400, Ar₁₁₃ to Ar₁₁₃ may be each independently one of
- a C₁-C₁₀ alkyl group substituted with at least one of a phenyl group, a naphthyl group, or an anthryl group;
- a phenyl group, a naphthyl group, an anthryl group, a pyrenyl group, a phenanthrenyl group, or a fluorenyl group;
- a phenyl group, a naphthyl group, an anthryl group, a pyrenyl group, a phenanthrenyl group, or a fluorenyl group, each substituted with at least one of a deuterium atom, a halogen atom, a hydroxyl group, a cyano group, a nitro group, an amino group, an amidino group, a hydrazine group, a hydrazone group, a carboxyl group or a salt thereof,
- a sulfonic acid group or a salt thereof, a phosphoric acid group or a salt thereof,
- a C₁-C₆₀ alkyl group, a C₂-C₆₀ alkenyl group, a C₂-C₆₀ alkynyl group, a C₁-C₆₀ alkoxy group, a phenyl group, a naphthyl group, an anthryl group, a pyrenyl group, a phenanthrenyl group, or
- a fluorenyl group 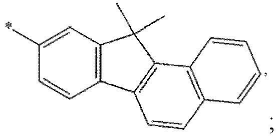 or
- formulas 7 or 8

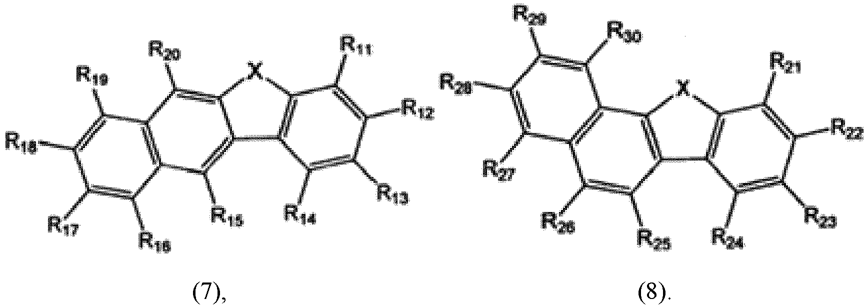

Wherein in the formulas 7 and 8, X is selected form an oxygen atom and a sulfur atom, but embodiments of the invention are not limited thereto.

In the formula 7, any one of R₁₁ to R₁₄ is used for bonding to Arm. R₁₁ to R₁₄ that are not used for bonding to Arm and R₁₅ to R₂₀ are the same as R₁ to R₈.

In the formula 8, any one of R₂₁ to R₂₄ is used for bonding to Arm. R₂₁ to R₂₄ that are not used for bonding to Arm and R₂₅ to R₃₀ are the same as R₁ to R₈.

Preferably, the EML host comprises between one and three heteroatoms selected from the group consisting of N, O or S. More preferred the EML host comprises one heteroatom selected from S or O.

### Emitter dopant

The dopant is mixed in a small amount to cause light emission, and may be generally a material such as a metal complex that emits light by multiple excitation into a triplet or more. The dopant may be, for example an inorganic, organic, or organic/inorganic compound, and one or more kinds thereof may be used.

The emitter may be a red, green, or blue emitter.

The dopant may be a fluorescent dopant, for example ter-fluorene, the structures are shown below. 4.4'-bis(4-diphenyl amiostyryl)biphenyl (DPAVBI, 2,5,8,11-tetra-tert-butyl perylene (TBPe), and Compound 8 below are examples of fluorescent blue dopants.

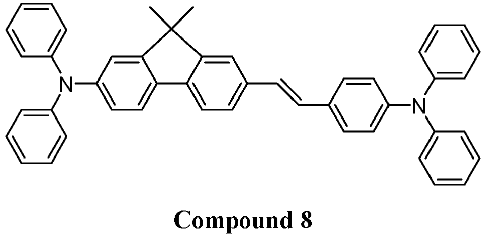

The dopant may be a phosphorescent dopant, and examples of the phosphorescent dopant may be an organic metal compound comprising Ir, Pt, Os, Ti, Zr, Hf, Eu, Tb, Tm, Fe, Co, Ni, Ru, Rh, Pd, or a combination thereof. The phosphorescent dopant may be, for example a compound represented by formula Z, but is not limited thereto:

J₂MX (Z).

In formula Z, M is a metal, and J and X are the same or different, and are a ligand to form a complex compound with M.

The M may be, for example Ir, Pt, Os, Ti, Zr, Hf, Eu, Tb, Tm, Fe, Co, Ni, Ru, Rh, Pd or a combination thereof, and the J and X may be, for example a bidendate ligand.

One or more emission layers may be arranged between the anode and the cathode. To increase overall performance, two or more emission layers may be present.

### Charge generation layer

A charge generation layer (also named CGL) may be arranged between the first and the second emission layer, and second and third emission layer, if present. Typically, the CGL comprises a n-type charge generation layer (also named n-CGL or electron generation layer) and a p-type charge generation layer (also named p-CGL or hole generation layer). An interlayer may be arranged between the n-type CGL and the p-type CGL.

In one aspect, the n-type CGL may comprise a compound of formula 1. The n-type CGL further comprises a metal, metal salt or organic metal complex, preferably a metal. The metal may be selected from an alkali, alkaline earth or rare earth metal.

The p-type CGL may comprise a dipyrazino[2,3-f:2',3'-h]quinoxaline, a quinone compound or a radialene compound, preferably dipyrazino[2,3-f:2',3'-h]quinoxaline-2,3,6,7,10,11-hexacarbonitrile or a compound or formula (XX) and/or a compound of formula (XXIa) or (XXIb) or dipyrazino[2,3-f:2',3'-h]quinoxaline-2,3,6,7,10,11-hexacarbonitrile.

In another aspect, the n-type and p-type CGL are in direct contact.

### Electron transport layer (ETL)

The electron transport layer is arranged between the at least one photoactive layer and the cathode.

According to another embodiment, the organic semiconductor layer that comprises compound of formula 1 is an electron transport layer. In another embodiment the electron transport layer may consist of compound of formula 1.

For example, an organic light emitting diode according to an embodiment of the present invention comprises at least one electron transport layer, and in this case, the electron transport layer comprises a compound of formula 1, or preferably of at least one compound of formulae F1 to F30.

In another embodiment, the organic electronic device comprises an electron transport region of a stack of organic layers formed by two or more electron transport layers, wherein at least one electron transport layer comprises compound of formula 1.

The electron transport layer may include one or two or more different electron transport compounds.

A thickness of the electron transport layer may be about 1 nm to about 100 nm, for example about 2 nm to about 20 nm. When the thickness of the electron transport layer is within these ranges, the electron transport layer may have satisfactory electron transporting ability without a substantial increase in operating voltage.

According to another embodiment, an auxiliary electron transport layer may be arranged between the at least one photoactive layer and the organic semiconductor layer comprising compound of formula 1. The auxiliary electron transport layer may comprise a triazine compound.

The thickness of the auxiliary electron transport layer may be from about 0.5 nm to about 20 nm, for example about 2 nm to about 10 nm. When the thickness of the auxiliary electron transport layer is within these ranges, the first electron transport layer may have improved electron transport ability without a substantial increase in operating voltage.

The electron transport layer may further comprise a monovalent or divalent metal halide or an organic monovalent or divalent metal organic complex, preferably an alkali halide and/or alkali or alkaline earth organic complex.

### Alkali halide

Alkali halides, also known as alkali metal halides, are the family of inorganic compounds with the chemical formula MX, where M is an alkali metal and X is a halogen.

M can be selected from Li, Na, Potassium, Rubidium and Cesium.

X can be selected from F, Cl, Br and J.

According to various embodiments of the present invention a lithium halide may be preferred. The lithium halide can be selected from the group comprising LiF, LiCl, LiBr and LiJ. However, most preferred is LiF.

### Metal organic complex

The metal organic complex may comprise an alkali or alkaline earth metal and at least one organic ligand. The metal is preferably selected from lithium, magnesium or calcium. According to various embodiments of the present invention the organic ligand of the metal organic complex is a quinolate or a borate.

According to various embodiments of the present invention the organic ligand of the metal organic complex, preferably of a lithium organic complex, can be a quinolate. Quinolates that can be suitable used are disclosed in WO 2013079217 A1.

According to various embodiments of the present invention the organic ligand of the metal organic complex can be a borate based organic ligand. Preferably the metal organic complex is a lithium tetra(1H-pyrazol-1-yl)borate, lithium tri(1H-pyrazol-1-yl)hydroborate or calcium tetra(1H-pyrazol-1-yl)borate. Borate based organic ligands that can be suitable used are disclosed in WO 2013079676 A1.

The metal organic complex may be essentially non-emissive.

### Electron injection layer (EIL)

According to another aspect of the invention, the organic electroluminescent device may further comprise an electron injection layer between the electron transport layer and the cathode.
The electron injection layer (EIL) may facilitate injection of electrons from the cathode.

According to another aspect of the invention, the electron injection layer comprises:
(i) an electropositive metal selected from alkali metals, alkaline earth metals and rare earth metals in substantially elemental form, preferably selected from Li, Na, K, Rb, Cs, Mg, Ca, Sr, Ba, Eu and Yb, more preferably from Li, Na, Mg, Ca, Sr and Yb, even more preferably from Li and Yb, most preferably Yb; and/or
(ii) an alkali metal organic complex and/or alkali metal salt, preferably the Li complex and/or salt, more preferably a Li quinolinolate, even more preferably a lithium 8-hydroxyquinolinolate, most preferably the alkali metal salt and/or complex of the electron transport layer is identical with the alkali metal salt and/or complex of the injection layer.

The electron injection layer may include at least one selected from LiF, NaCl, CsF, Li₂O, and BaO.

A thickness of the EIL may be from about 0.1 nm to about 10 nm, or about 0.3 nm to about 9 nm. When the thickness of the electron injection layer is within these ranges, the electron injection layer may have satisfactory electron injection ability without a substantial increase in operating voltage.

The electron injection layer may comprise a compound of formula 1.

### Cathode

A material for the cathode may be a metal, an alloy, or an electrically conductive compound that have a low work function, or a combination thereof. Specific examples of the material for the cathode may be lithium (Li), magnesium (Mg), aluminum (Al), aluminumlithium (Al-Li), calcium (Ca), magnesium-indium (Mg-In), magnesium-silver (Mg-Ag), silver (Ag) etc. In order to manufacture a top-emission light-emitting device having a reflective anode deposited on a substrate, the cathode may be formed as a light-transmissive electrode from, for example, indium tin oxide (ITO), indium zinc oxide (IZO) or silver (Ag).

In devices comprising a transparent metal oxide cathode or a reflective metal cathode, the cathode may have a thickness from about 50 nm to about 100 nm, whereas semitransparent metal cathodes may be as thin as from about 5 nm to about 15 nm.

### Substrate

A substrate may be further disposed under the anode or on the cathode. The substrate may be a substrate that is used in a general organic light emitting diode and may be a glass substrate or a transparent plastic substrate with strong mechanical strength, thermal stability, transparency, surface smoothness, ease of handling, and water resistance.

Hereinafter, the embodiments are illustrated in more detail with reference to examples. However, the present disclosure is not limited to the following examples.

### Description of the Drawings

These and/or other aspects and advantages of the present invention will become apparent and more readily appreciated from the following description of the exemplary embodiments, taken in conjunction with the accompanying drawings, of which:
- FIG. 1: is a schematic sectional view of an organic electronic device according to an exemplary embodiment of the present invention;
- FIG. 2: is a schematic sectional view of an OLED, according to an exemplary embodiment of the present invention;
- FIG. 3: is a schematic sectional view of an OLED, according to another exemplary embodiment of the present invention;
- FIG. 4: is a schematic sectional view of a tandem OLED comprising a charge generation layer, according to an exemplary embodiment of the present invention.

Reference will now be made in detail to the exemplary aspects, examples of which are illustrated in the accompanying drawings, wherein like reference numerals refer to the like elements throughout. The exemplary embodiments are described below, in order to explain the aspects, by referring to the figures.

Herein, when a first element is referred to as being formed or disposed "on" a second element, the first element can be disposed directly on the second element, or one or more other elements may be disposed there between. When a first element is referred to as being formed or disposed "directly on" a second element, no other elements are disposed there between.

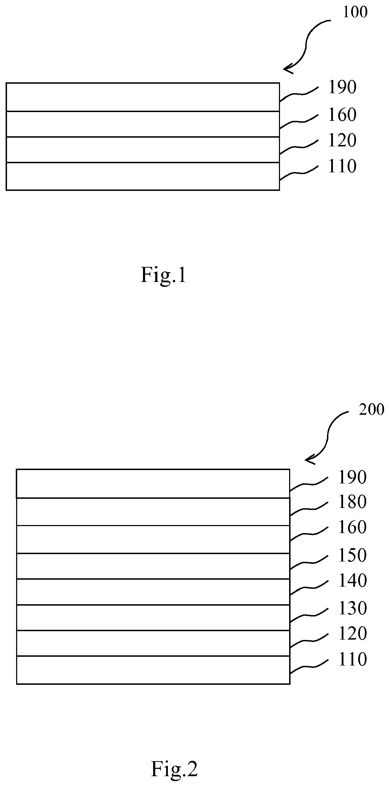

FIG. 1 is a schematic sectional view of an organic electronic device 100 according to an exemplary embodiment of the present invention. The organic electronic device 100 includes a substrate 110, an anode 120, an organic semiconductor layer 160 comprising a compound of formula 1, and a cathode 190.

FIG. 2 is a schematic sectional view of an organic light-emitting diode (OLED) 200, according to an exemplary embodiment of the present invention. The OLED 200 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed on the EML 150. Onto the electron transport layer (ETL) 160, an electron injection layer (EIL) 180 is disposed. The cathode 190 is disposed directly onto the electron injection layer (EIL) 180.

Preferably, the organic semiconducting layer comprising a compound of Formula 1 may be an ETL.

Instead of a single electron transport layer 160, optionally an electron transport layer stack (ETL) can be used.

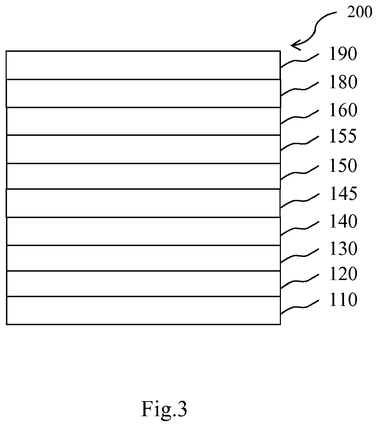

Fig. 3 is a schematic sectional view of an OLED 100, according to another exemplary embodiment of the present invention. Fig. 3 differs from Fig. 2 in that the OLED 200 of Fig. 2 comprises an electron blocking layer (EBL) 145 and a hole blocking layer (HBL) 155.

Referring to Fig. 3, the OLED 200 includes a substrate 110, an anode 120, a hole injection layer (HIL) 130, a hole transport layer (HTL) 140, an electron blocking layer (EBL) 145, an emission layer (EML) 150, a hole blocking layer (HBL, also referred to as auxiliary electron transport layer or a-ETL) 155, an electron transport layer (ETL) 160, an electron injection layer (EIL) 180 and a cathode electrode 190.

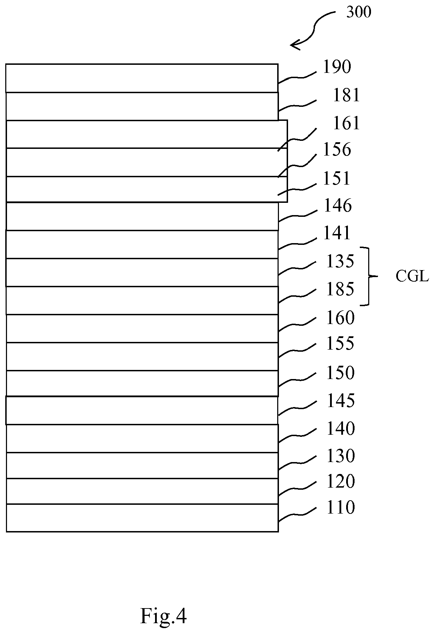

Fig. 4 is a schematic sectional view of a tandem OLED 300, according to another exemplary embodiment of the present invention. Fig. 4 differs from Fig. 3 in that the OLED 300 of Fig. 4 further comprises a charge generation layer (CGL) and a second emission layer (151). Referring to Fig. 4, the OLED 300 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.
Preferably, the organic semiconductor layer comprising a compound of Formula 1 may be the first ETL, n-type CGL and/or second ETL.
While not shown in Fig. 1, Fig. 2, Fig. 3 or Fig. 4, a sealing layer may further be formed on the cathode electrodes 190, in order to seal the organic electronic device 100 and the OLEDs 200 and 300. In addition, various other modifications may be applied thereto.

### Organic semiconductor layer

According to another aspect an organic semiconductor layer may comprise at least one compound of formula 1.

According to one embodiment the organic semiconductor layer may comprises at least one compound of formula 1 and further comprises a metal, metal salt or metal organic complex, preferably a monovalent or divalent metal organic complex, more preferably an alkali or alkaline earth organic complex, and further more preferably LiQ or alkali borate or alkaline earth borate.

According to one embodiment the organic semiconductor layer may comprises at least one compound of formula 1 and LiQ.

According to one embodiment the organic semiconductor layer may comprises at least one compound of formula 1 and an alkali borate or alkaline earth borate.

According to one embodiment, the organic semiconductor layer may consist of a compound of formula 1.

An organic semiconductor layer comprising or consisting of a compound according to formula 1 is essentially non-emissive or non-emitting.

### Organic electronic device

An organic electronic device according to the invention comprises at least one organic semiconductor layer, wherein at least one organic semiconductor layer comprises a compound according to formula 1.

An organic electronic device according to one embodiment comprises at least one organic semiconductor layer and comprising an anode and a cathode, preferably the organic semiconductor layer is arranged between the anode and the cathode.

An organic electronic device according to one embodiment may include a substrate, an anode layer, an organic semiconductor layer comprising a compound of formula 1, and a cathode layer.

The organic electronic device according to one embodiment may comprises at least one photoactive layer arranged between the anode and the cathode; preferably the organic semiconductor layer is arranged between the at least one photoactive layer and the cathode.

The organic electronic device according to one embodiment may comprises at least one organic semiconductor layer, wherein the organic semiconductor layer comprising a compound of formula 1 is arranged between a photoactive layer and a cathode layer, preferably between an emission layer or light-absorbing layer and the cathode layer, preferably the organic semiconductor layer is an electron transport layer.

An organic electronic device according to one embodiment comprises at least one organic semiconductor layer comprising at least one compound of formula 1, at least one anode layer, at least one cathode layer and at least one emission layer, wherein the organic semiconductor layer comprising at least one compound of formula 1 is preferably arranged between the emission layer and the cathode layer.

According to one embodiment, the organic electronic device further comprises an auxiliary electron transport layer, wherein the auxiliary electron transport layer is arranged between the emission layer and the cathode and the at least one organic semiconductor layer is arranged between the auxiliary electron transport layer and the cathode, preferably the auxiliary electron transport layer is in direct contact with the emission layer.

According to one embodiment, the organic electronic device further comprises at least a first and a second emission layer and the organic semiconductor layer is arranged between the first and second emission layer.

According to one embodiment, the organic electronic device further comprises at least a first and a second emission layer and the first organic semiconductor layer comprising compound of formula 1 is arranged between the first and second emission layer and the second organic semiconductor layer comprising compound of formula 1 is arranged between the second emission layer and the cathode.

According to one embodiment, the organic electronic device may comprises at least one organic semiconductor layer comprising a compound of formula 1 that is an electron transport layer, a hole blocking layer, a charge generation layer and/or an electron injection layer, preferably an electron transport layer or a charge generation layer, more preferred an electron transport layer.

The organic electronic device according to one embodiment may comprises at least one organic semiconductor layer comprising a compound of formula 1, wherein the at least one organic semiconductor layer further comprises at least one alkali halide, alkali organic complex or alkaline earth organic complex.

An organic light-emitting diode (OLED) according to the invention may include an anode, a hole transport layer (HTL), an emission layer (EML), an electron transport layer (ETL) comprising at least one compound of formula 1, and a cathode, which are sequentially stacked on a substrate. In this regard, the HTL, the EML, and the ETL are thin films formed from organic compounds.

An organic electronic device according to one embodiment can be a light emitting device, thin film transistor, a battery, a display device or a photovoltaic cell, and preferably a light emitting device. A light emitting device can be an OLED.

According to one embodiment, a method is provided for forming an organic semiconductor layer comprising a compound of formula 1, wherein the formation of the organic semiconductor layer may comprise a step of
- deposition via vacuum thermal evaporation;
- deposition via solution processing, preferably the processing is selected from spin-coating, printing, casting; and/or
- deposition via slot-die coating.

According to various embodiments of the present invention, there is provided a method using:
- a first deposition source to release compound of formula 1 according to the invention, and
- a second deposition source to release the alkali halide or metal organic complex;
   the method comprising the steps of forming the organic semiconductor layer, whereby the organic semiconductor layer is formed by releasing a compound of formula 1 according to the invention from the first deposition source and the alkali halide or metal organic complex from the second deposition source.

According to various embodiments of the present invention, the method may further include the steps for forming an organic light-emitting diode (OLED), wherein
- on a substrate a first anode electrode is formed,
- on the first anode electrode an emission layer is formed,
- on the emission layer an electron transport layer stack is formed, preferably a first electron transport layer is formed on the emission layer and a second electron transport layer is formed on the first electron transport layer and the second electron transport layer comprises a compound of formula 1,
- and finally a cathode electrode is formed,
- optional a hole injection layer, a hole transport layer, and a hole blocking layer, formed in that order between the first anode electrode and the emission layer,
- optional an auxiliary electron transport layer is formed between the emission layer and the organic semiconductor layer comprising compound of formula 1,
- optional an electron injection layer is formed between the electron transport layer stack and the cathode electrode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

Hereinafter, the embodiments are illustrated in more detail with reference to examples. However, the present disclosure is not limited to the following examples. Reference will now be made in detail to the exemplary aspects.

### Preparation of compounds of formula 1

Compounds of formula 1 may be prepared as described below.

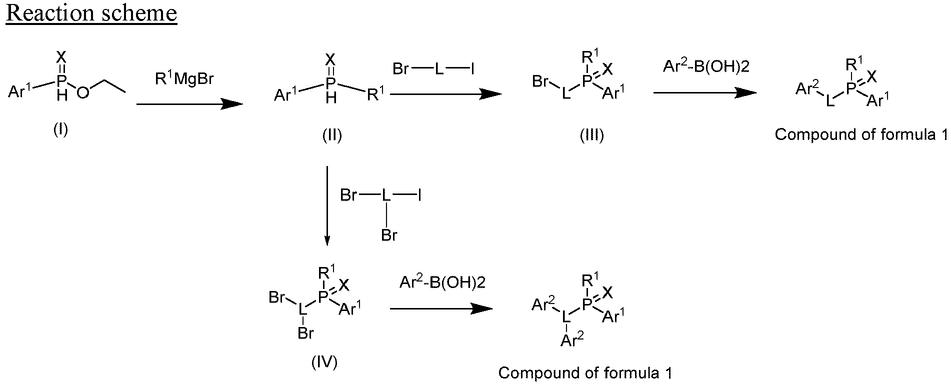

Starting material (I) may be reacted with a Grignard reagent to form Intermediate (II). Subsequent reaction of Intermediate (II) with Br-L-I or I-L-Br₂ may result in formation of Intermediate (III) or (IV). Subsequent reaction of Intermediate (III) or (IV) with Ar² boronic acid or Ar² boronic ester under Suzuki-Miyaura conditions may result in formation of compound of formula 1.

### Preparation of Intermediate (II)

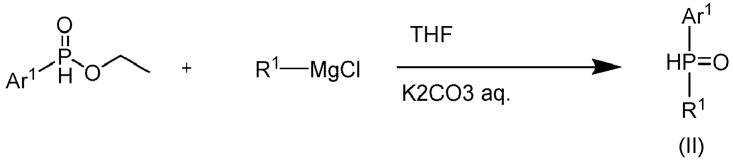

Ethyl aryl phosphinate (1 eq) is added to a cooled Grignard solution in THF (2.02 eq) at such a rate that a temperature of the reaction mixture is maintained below 0°C After stirring at room temperature for 1 h the mixture is hydrolyzed by mixing it with an ice-cold saturated aqueous solution of potassium carbonate (2.02 eq). Precipitated magnesium carbonate is removed by filtration and washed several time with ethanol. Combined filtrates are concentrated in vacuum to give a crude material, which could be further purified by distillation or re-crystallization from an appropriate solvent.

**Table 1**

| Reaction summary | | | |
|---|---|---|---|
| The following compounds may be prepared using this procedure | | | |
| Starting materials | | | |
| Phosphinate | Grignard reagent | Product | Yield / MS data |
| Ethyl phenylphosphinate | Methylmagnesium chloride | Methyl(phenyl)phosphine oxide | 88,2%/140[M]⁺ |
| Ethyl phenylphosphinate | Ethylmagnesium bromide | Ethyl(phenyl)phosphine oxide | |
| Ethyl naphthalen-2-ylphosphinate | Methylmagnesium chloride | Methyl(naphthalen-2-yl)phosphine oxide | |
| Ethyl naphthalen-2-ylphosphinate | Isopropyl magnesium chloride | Isopropyl (naphthalen -2-yl)phosphine oxide | |
| Ethyl phenylphosphinate | Isopropyl magnesium chloride | Isopropyl (phenyl) phosphine oxide | |

### Preparation of Intermediate (III)

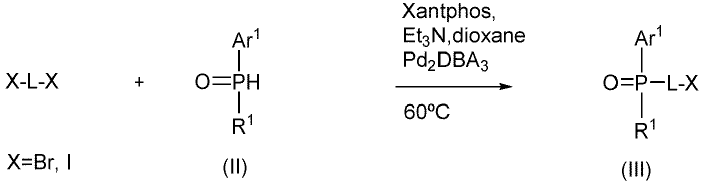

A Schlenck flask is charged with aryl halide (1 eq), aryl alkyl phoshine oxide (1 eq.) and sealed with a rubber septum. Atmosphere is replaced by Argon and the starting compounds are dissolved in anhydrous dioxane. In a separate vial, a mixture of tris(dibenzylideneacetone)dipalladium (0.005eq), Xantphos (0,01eq) and triethylamine (1.17eq.) is dissolved in anhydrous dioxane (75ml/mmol) at 24 °C for 10 min. This catalyst solution is added to the mixture of phosphine oxide and aryl halide and the reaction mixture was stirred for 12-24h at 24°C.

A precipitated solid (trimethylamine salt) is separated by filtration through sintered glass filter (Pore size 4), washed two times with dioxane, combined filtrates are evaporated to a dryness under reduced pressure using a rotary evaporator. The residue is dissolved in dichloromethane, washed with water, dried over sodium sulfate and evaporated to dryness yielding a crude product, which was further purified by column chromatography or by re-crystallization from an appropriate solvent.

**Table 2**

| Reaction summary | | |
|---|---|---|
| The following compounds may be prepared using this procedure | | |
| Starting material(s) | Product | Yield / MS data |
| 1 -bromo-4-iodobenzene, methyl(phenyl)phosphine oxide | (4-bromophenyl)dimethylphosphine oxide | 51% / 294[M]⁺ |
| 1-bromo-3-iodobenzene, methyl(phenyl)phosphine oxide | (3-bromophenyl)dimethylphosphine oxide | 74% / 294[M]⁺ |
| 1 -bromo-4-iodobenzene, iso-propyl(phenyl)phosphine oxide | (4-bromophenyl)(isopropyl)(phenyl)p hosphine oxide | |
| 1 -bromo-4-iodobenzene, Methyl(naphthalen-2-yl)phosphine oxide | (4-bromophenyl)(methyl)(naphthalen-2-yl)phosphine oxide | |

### Preparation of compound of formula 1

Potassium carbonate (51.4mmol, 3 eq.) is dissolved in ∼25ml of deionized water, the solution is degassed with N₂ for 30 min. Glyme (175ml ) is degassed in a 500mL 3-necked round bottom flask with N₂ for 30 min. The flask is then charged with corresponding boronic ester or boronic acid (17.14mmol, 1 eq.), bromophenylalkyaryllphosphine oxide (17.99mmol, 1.05eq.) and tetrakis(triphenylphosphin)palladium(0) (0.51 mmol, 0.03 eq.) under a positive nitrogen pressure. The degassed potassium carbonate solution is added using a syringe, nitrogen purged reflux condenser is attached to the flask and a reaction mixture heated to 90°C with stirring for 12 h. The mixture is allowed to cool down to the room temperature, the reaction mixture is transferred to a separation funnel. An aqueous layer is separated, an organic layer is washed with water and brine, dried over magnesium sulfate and evaporated to a dryness. Residue is suspended in methanol, precipitate is collected by filtration, washed with methanol and dried in vacuum at 40°C yielding a crude product, which could be further purified by re-crystallization or trituration with appropriate solvents. Final purification is achieved by sublimation in a high vacuum.

**Table 3**

| Reaction summary | | |
|---|---|---|
| The following compounds may be prepared using this procedure | | |
| Starting material | Product | Yield / MS data |
| 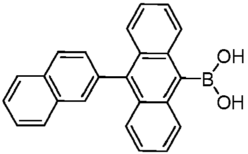 | 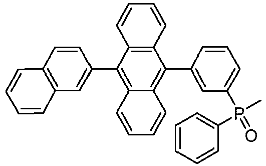 | 78,8% / 519[M+H]⁺, 541[M+Na]⁺, 1037[2M+H⁺] |
| 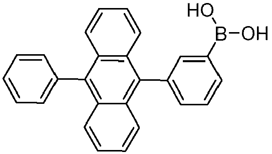 | 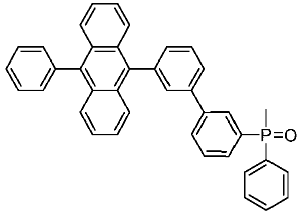 | 69,7% / 567 M+Na]⁺, 1111[2M+Na]⁺ |
| 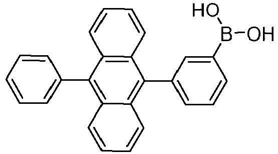 | 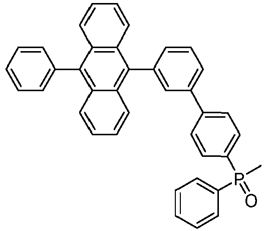 | |
| 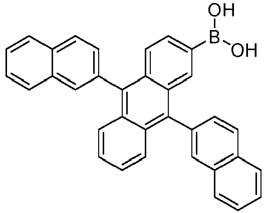 | 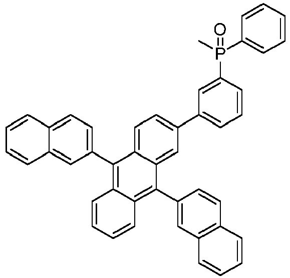 | |
| 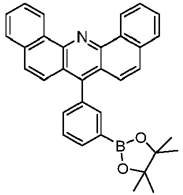 | 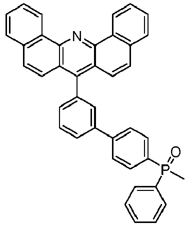 | |
| 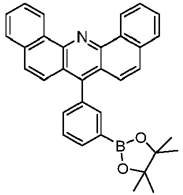 | 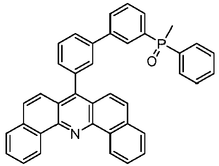 | 94%% / 570 M+H]⁺, 592[M+Na]⁺ |
| 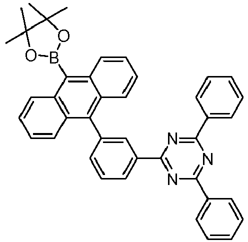 | 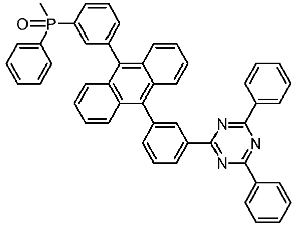 | |
| 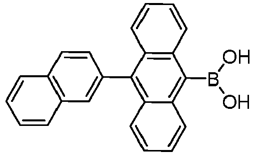 | 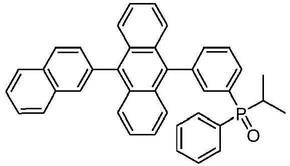 | |
| 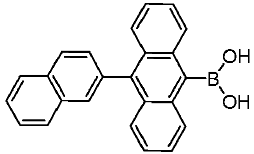 | 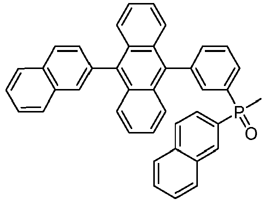 | |

### General procedure for fabrication of OLEDs

For top emission devices, Examples 1 to 3 and comparative example 1, a glass substrate was cut to a size of 50 mm x 50 mm x 0.7 mm, ultrasonically cleaned with isopropyl alcohol for 5 minutes and then with pure water for 5 minutes, and cleaned again with UV ozone for 30 minutes. 100 nm Ag were deposited on the glass substrate at a pressure of 10⁻⁵ to 10⁻⁷ mbar to form the anode.

Then, 92 vol.-% Biphenyl-4-yl(9,9-diphenyl-9H-fluoren-2-yl)-[4-(9-phenyl-9H-carbazol-3-yl)phenyl]-amine (CAS 1242056-42-3) with 8 vol.-% 2,2',2"-(cyclopropane-1,2,3-triylidene)tris(2-(p-cyanotetrafluorophenyl)acetonitrile) was vacuum deposited on the anode, to form a HIL having a thickness of 10 nm. Then, Biphenyl-4-yl(9,9-diphenyl-9H-fluoren-2-yl)-[4-(9-phenyl-9H-carbazol-3-yl)phenyl]-amine was vacuum deposited on the HIL, to form a HTL having a thickness of 118 nm.

Then, N,N-bis(4-(dibenzo[b,d]furan-4-yl)phenyl)-[1,1':4',1"-terphenyl]-4-amine (CAS 1198399-61-9) was vacuum deposited on the HTL, to form an electron blocking layer (EBL) having a thickness of 5 nm.

Then, 97 vol.-% H09 (Sun Fine Chemicals) as EML host and 3 vol.-% BD200 (Sun Fine Chemicals) as fluorescent blue dopant were deposited on the EBL, to form a blue-emitting EML with a thickness of 20 nm.

Then the auxiliary ETL was formed with a thickness of 5 nm by depositing 2,4-diphenyl-6-(4',5',6'-triphenyl-[1,1':2',1":3",1''':3''',1''''-quinquephenyl]-3''''-yl)-1,3,5-triazine (ETM-1, comparative example 1 and example 1) or 2-(3'-(9,9-dimethyl-9H-fluoren-2-yl)-[1,1'-biphenyl]-3-yl)-4,6-diphenyl-1,3,5-triazine (ETM-2, example 2 and 3) on the emission layer (EML).

Then, the electron transporting layer was formed on the auxiliary electron layer according to Examples 1 to 3 and comparative example 1 with a the thickness of 31 nm. The electron transport layer comprises 70 wt.-% matrix compound and 30 wt.-% of metal organic complex, see Table 5. The metal organic complex is selected from MC-1 or MC-2

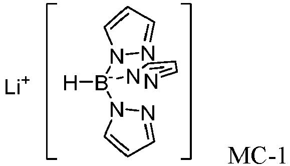

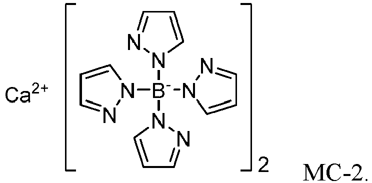

Then, the electron injection layer was formed on the electron transporting layer by deposing Yb with a thickness of 2 nm.

Ag was evaporated at a rate of 0.01 to 1 Å/s at 10⁻⁷ mbar to form a cathode with a thickness of 11 nm.

A cap layer of Biphenyl-4-yl(9,9-diphenyl-9H-fluoren-2-yl)-[4-(9-phenyl-9H-carbazol-3-yl)phenyl]-amine was formed on the cathode with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer for each of the voltage values. The cd/A efficiency at 10 mA/cm² is determined by interpolating the luminance-voltage and current-voltage characteristics, respectively.

Lifetime LT of the device is measured at ambient conditions (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

The light output in external efficiency EQE and power efficiency (lm/W efficiency) are dertermined at 10 mA/cm² for top emission devices.

To determine the efficiency EQE in % the light output of the device is measured using a calibrated photodiode.

To determine the power efficiency in lm/W, in a first step the luminance in candela per square meter (cd/m2) is measured with an array spectrometer CAS140 CT from Instrument Systems which has been calibrated by Deutsche Akkreditierungsstelle (DAkkS). In a second step, the luminance is then multiplied by *π* and divided by the voltage and current density.

### Technical Effect of the invention

In Table 4 below, properties of compounds of formula 1 and of comparative example 1 are shown.

**Table 4: Properties of comparative compounds MX 1 and MX 2 and compounds of formula 1**

| Referred to as: | Chemical formula | mp (°C) | Tg (°C) | T_{RO} (°C) |
|---|---|---|---|---|
| MX 1 | 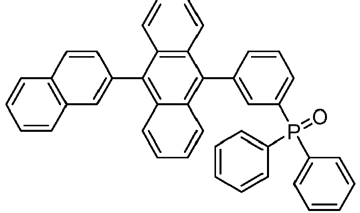 | 272 | 120 | 222 |
| MX 2 | 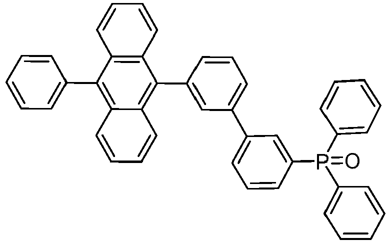 | 246 | 113 | 224 |
| F4 | 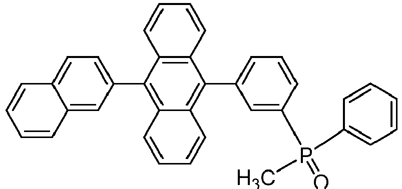 | 254 | 114 | 202 |
| F13 | 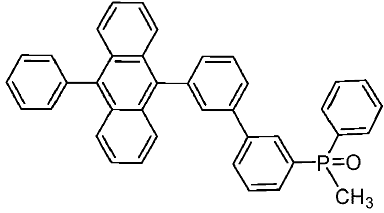 | 274 | 105 | 210 |

As can be seen in Table 4, the rate onset temperature of F4 is reduced by 20 °C compared to MX 1 and 12 °C compared to MX 2. The rate onset temperature of F13 is reduced by 12 °C compared to MX 1 and by 14 °C compared to MX 2.
A reduction in rate onset temperature is beneficial for mass production of organic electronic devices, as the compound can be evaporated at a higher rate, without sacrificing thermal stability of the compound in the organic electronic device. Surprisingly, it was found that the rate onset temperature is reduced without a substantial reduction in melting point and/or glass transition temperature.

In Table 5, efficiency, operating voltage and lifetime LT are shown of an OLED comprising an organic semiconductor layer comprising a compound of formula 1.
As can be seen in Table 5, the lifetime LT is improved for examples 1 to 3 compared to comparative example 1. Without being bound by theory, the improvement in LT may be due to reduced degradation of the compound of formula 1 during fabrication of the OLED.

**Table 5: Performance of an organic electroluminescent device comprising an electron transport layer (ETL) comprising a compound of formula 1**

| | Matrix compound in auxiliary ETL | Thickness auxiliary ETL (nm) | Matrix compound in ETL | Concentration of matrix compound in ETL (vol.-%) | Metal organic complex in ETL | Concentration of metal organic complex in ETL (vol.-%) | Thickness ETL (nm) | Operating voltage at 10 mA/cm² (V) | cd/A efficiency at 10 mA/cm² (cd/A) | LT97 at 30 mA/cm² (h) |
|---|---|---|---|---|---|---|---|---|---|---|
| Comparative example 1 | ETM-1 | 5 | MX1 | 70 | MC-2 | 30 | 31 | 3.6 | 7.4 | 33 |
| Example 1 | ETM-1 | 5 | F4 | 70 | MC-2 | 30 | 31 | 3.8 | 7.7 | 35 |
| Example 2 | ETM-2 | 5 | F4 | 70 | MC-2 | 30 | 31 | 3.9 | 7.3 | 65 |
| Example 3 | ETM-2 | 5 | F4 | 70 | MC-1 | 30 | 31 | 4.0 | 7.4 | 76 |

While this invention has been described in connection with what is presently considered to be practical exemplary embodiments, it is to be understood that the invention is not limited to the disclosed embodiments. Therefore, the aforementioned embodiments should be understood to be exemplary but not limiting the present invention in any way.

## Claims

1. A compound of formula 1: 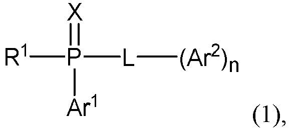 wherein
X is O;
R¹ is selected from a substituted or unsubstituted C₁ to C₁₈ alkyl group,
wherein the substituents of the substituted C₁ to C₁₈ alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
Ar¹ is selected from an unsubstituted C₆ to C₂₄ aryl;
L is selected from a substituted or unsubstituted C₆ to C₁₉ arylene or C₃ to C₂₄ heteroarylene group,
wherein the substituents of the substituted C₆ to C₁₉ arylene or of the substituted C₃ to C₂₄ heteroarylene group are independently selected from C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy;
Ar² is selected from a substituted or unsubstituted C₁₀ to C₄₂ aryl or substituted or unsubstituted C₃ to C₄₂ heteroaryl group, wherein the C₁₀ to C₄₂ aryl group comprises a conjugated system of delocalized electrons having at least 10 conjugated delocalized electrons, and
wherein the substituents of the substituted C₁₀ to C₄₂ aryl group or of the substituted C₃ to C₄₂ heteroaryl group are independently selected from C₁ to C₁₆ alkyl, C₁ to C₁₆ alkoxy, substituted or unsubstituted C₆ to C₃₆ aryl, substituted or unsubstituted C₃ to C₃₆ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl, and
wherein the substituent of the substituted C₆ to C₃₆ aryl or of the substituted C₃ to C₃₆ heteroaryl are independently selected from C₁ to C₁₆ alkyl, C₁ to C₁₆ alkoxy, C₆ to C₁₈ aryl, C₄ to C₁₈ heteroaryl, CN, halogen;
n is an integer selected from 1, 2 or 3; and
excluding compound 2, 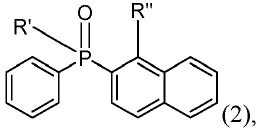
wherein R' is selected from C₁ to C₄ alkyl, and R" is selected from 1-naphthyl, (1,1'-biphenyl)-2-yl and/or 2-methoxy-1-naphthalene-yl;
wherein formula 1 comprises at least 6 to 25 aromatic rings.

2. The compound of formula 1 according to claim 1, wherein
X is O;
R¹ is C₁ to C₁₂ alkyl, preferably C₁ to C₁₀ alkyl, further preferred C₁ to C₆ alkyl, and more preferred methyl,
wherein the substituents of the substituted C₁ to C₁₈ alkyl group are selected from C₆ to C₂₄ aryl, C₃ to C₂₄ heteroaryl, halogen, CN, perfluorinated C₁ to C₁₆ alkyl, perfluorinated C₁ to C₁₆ alkoxy;
Ar¹ is unsubstituted C₆ to C₁₉ aryl, preferably C₆ to C₁₈ aryl, further preferred C₆ to C₁₂ aryl, and more preferred unsubstituted C₆ to C₁₂ aryl;
Ar² is selected from a substituted or unsubstituted C₁₀ to C₃₆ aryl or substituted or unsubstituted C₃ to C₃₅ heteroaryl group, wherein the C₁₀ to C₃₆ aryl group comprises a conjugated system of delocalized electrons having at least 10 conjugated delocalized electrons, and
wherein the substituents of the substituted C₁₀ to C₃₆ aryl group or of the substituted C₃ to C₃₅ heteroaryl group are independently selected from C₁ to C₆ alkyl, C₁ to C₆ alkoxy, substituted or unsubstituted C₆ to C₁₂ aryl, substituted or unsubstituted C₃ to C₁₁ heteroaryl, halogen, CN, perfluorinated C₁ to C₆ alkyl, perfluorinated C₁ to C₆ alkoxy, PXR³R⁴, L-PXR³R⁴, COR⁵, and
wherein R³, R⁴ and R⁵ are independently selected from C₁ to C₆ alkyl, substituted or unsubstituted C₆ to C₁₂ aryl, substituted or unsubstituted C₃ to C₁₁ heteroaryl, perfluorinated C₁ to C₆ alkyl, and wherein the substituent of the substituted C₆ to C₁₂ aryl or of the substituted C₃ to C₁₁ heteroaryl are independently selected from C₁ to C₆ alkyl, C₁ to C₆ alkoxy, C₆ to C₁₂ aryl, C₄ to C₁₁ heteroaryl, CN, halogen;
L is selected from a substituted or unsubstituted C₆ to C₁₈ arylene or C₃ to C₁₇ heteroarylene group, preferably from a substituted or unsubstituted C₆ to C₁₂ arylene or C₃ to C₁₁ heteroarylene group, further preferred from a substituted or unsubstituted C₆ to C₁₀ arylene or C₃ to C₉ heteroarylene group, and more preferred from a phenylene group; wherein
the substituents of the substituted arylene or of the substituted heteroarylene group are independently selected from C₁ to C₆ alkyl, C₁ to C₆ alkoxy, C₆ to C₁₂ aryl, C₃ to C₁₁ heteroaryl, perfluorinated C₁ to C₆ alkyl, perfluorinated C₁ to C₆ alkoxy;
n is selected 1 or 2, preferably n is 1.

3. The compound of formula 1 according to any of the previous claims 1 or 2, wherein for the compound of formula 1:
- Ar² is selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group; and/or
- Ar² is selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group; and Ar² comprises at least two annulated aryl and/or at least two annulated heteroaryl groups, preferably Ar² comprises at least three annulated aryl and/or heteroaryl groups; and/or
- Ar² is selected from a substituted or unsubstituted C₁₂ to C₃₀ aryl or substituted or unsubstituted C₁₁ to C₂₉ heteroaryl group, preferably from a substituted or unsubstituted C₁₈ to C₂₄ aryl or substituted or unsubstituted C₁₇ to C₂₃ heteroaryl group, which is free of an annulated aryl and/or heteroaryl group, and preferably Ar² is free of an annulated aryl and/or heteroaryl group.

4. The compound of formula 1 according to any of the previous claims 1 to 3, wherein
- Ar¹ is selected from unsubstituted phenyl, biphenyl, fluorenyl, benzofluorenyl, naphthyl, phenanthryl, anthracenyl; and/or
- Ar² is selected from substituted or unsubstituted fluorene, benzofluorene, dibenzofluorene, 9,9'-spirobi[fluorene], 13H-indeno[1,2-1]phenanthrene, naphthalene, anthracene, phenanthrene, pyrene, perylene, triphenylene, rubrene, chrysene, fluoranthene, spiro[benzo[de]anthracene-7,9'-fluorene], acridine, benzoacridine, dibenzoacridine, quinoline, quinazoline, quinoxaline, benzoquinoline, phenanthroline, benzimidazole, triazine, pyrimidine, pyridine, pyrazine, aza-triphenylene, carbazole, dibenzofurane, dibenzothiophene, dibenzoselenophene, aza-dibenzofuran, aza-dibenzothiophene, aza-dibenzoselenophene, di-aza-dibenzothiophene, di-aza-dibenzoselenophene.

5. The compound of formula 1 according to any of the previous claims 1 to 4, wherein Ar¹ and/ or Ar² comprises 0 or 1 sp³-hybridised carbon atoms.

6. The compound of formula 1 according to any of the previous claims 1 to 5, wherein Ar² is selected from a C1 to C35 group: 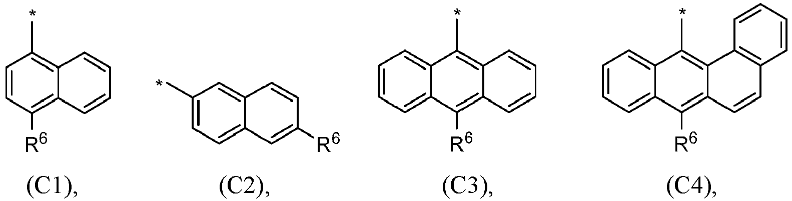 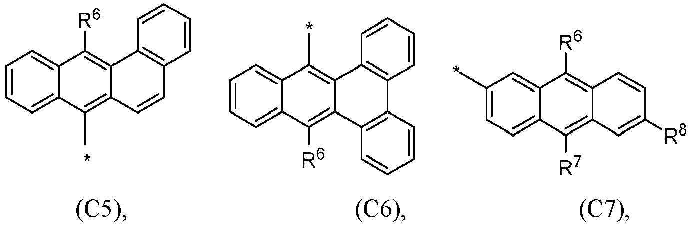 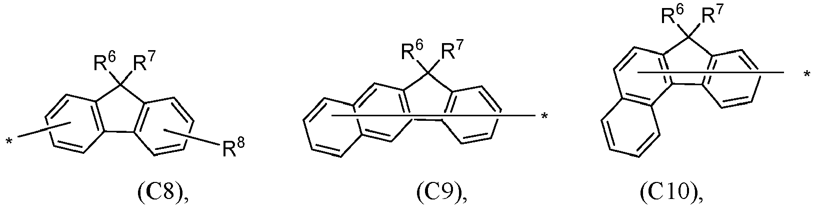 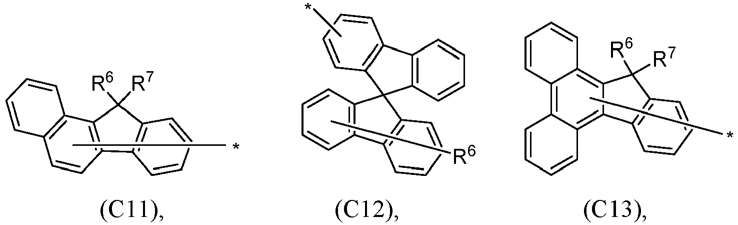 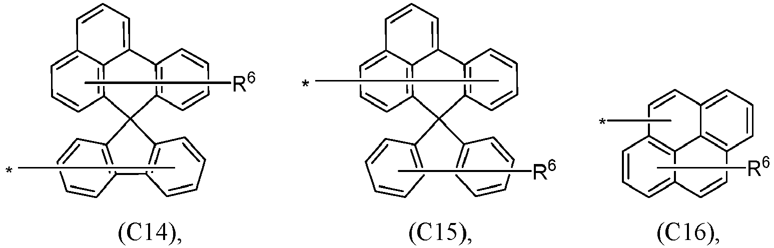 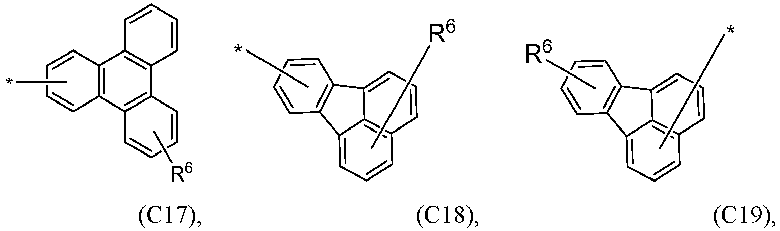 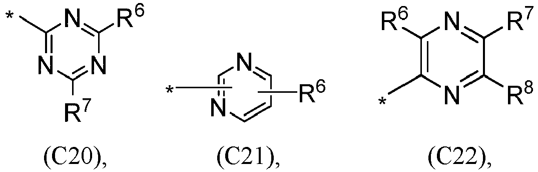 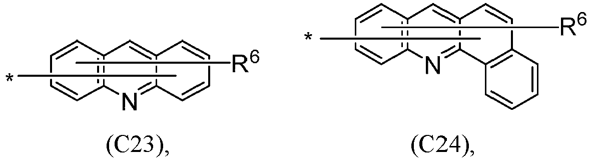 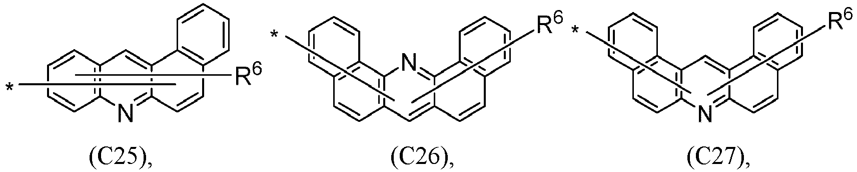 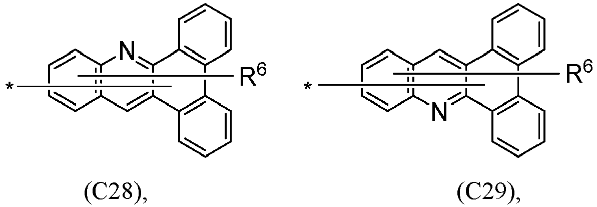 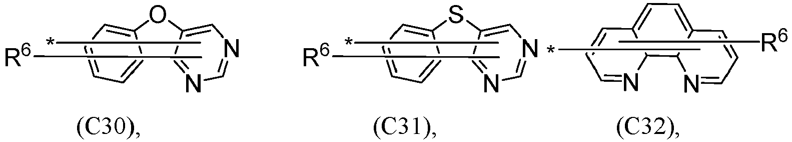 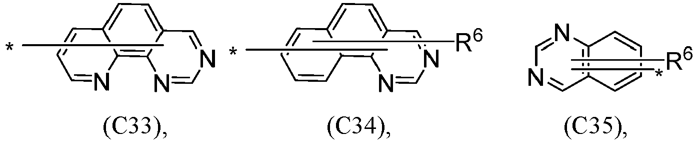 wherein
R⁶, R⁷ and R⁸ are independently selected from H, C₁ to C₁₆ alkyl, C₁ to C₁₆ alkoxy, substituted or unsubstituted C₆ to C₂₄ aryl, substituted or unsubstituted C₃ to C₂₄ heteroaryl, halogen, CN, perfluorinated C₁ to C₁₆ alkyl, perfluorinated C₁ to C₁₆ alkoxy, PXR³R⁴, L-PXR³R⁴, COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl;
the substituent of the substituted C₆ to C₂₄ aryl and of the substituted C₃ to C₂₄ heteroaryl are selected from C₁ to C₁₆ alkyl, C₁ to C₁₆ alkoxy, C₆ to C₁₈ aryl, C₄ to C₁₈ heteroaryl, CN, halogen;
preferably, R⁶, R⁷ and R⁸ are independently selected from H, substituted or unsubstituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl, or PXR³R⁴, L-PXR³R⁴ , COR⁵;
wherein R³, R⁴ and R⁵ are independently selected from C₁ to C₁₆ alkyl, C₆ to C₂₄ aryl, C₃ to C₂₄ heteroaryl, perfluorinated C₁ to C₁₆ alkyl; and
the substituent of the substituted phenyl, biphenyl, fluorenyl, naphthyl, phenanthryl, anthracenyl, pyrenyl, benzofuranyl, benzothiophenyl, dibenzofuranyl, dibenzothiophenyl, pryidyl, quinolinyl, pyrimidinyl, triazinyl, phenanthrolinyl are independently selected from C₁ to C₁₆ alkyl, C₁ to C₁₆ alkoxy, C₆ to C₁₈ aryl, C₄ to C₁₈ heteroaryl, CN, halogen.

7. The compound of formula 1 according to any of the previous claims 1 to 6, wherein the substituents of the substituted aryl group of the Ar² group, or the substituents of the substituted heteroaryl group of the Ar² group, or the substituents of the (C1) to (C35) groups, are independently selected from halogen, CN, D1 to D59:

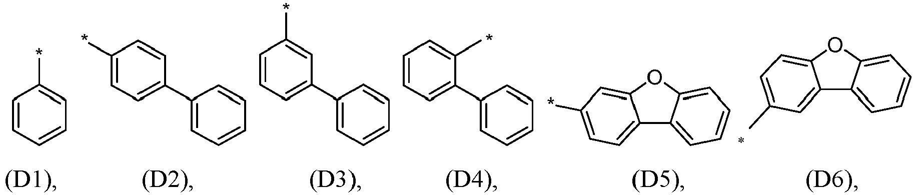

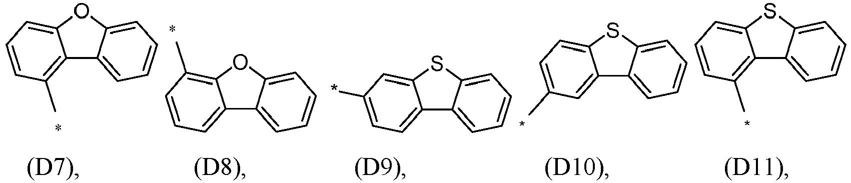

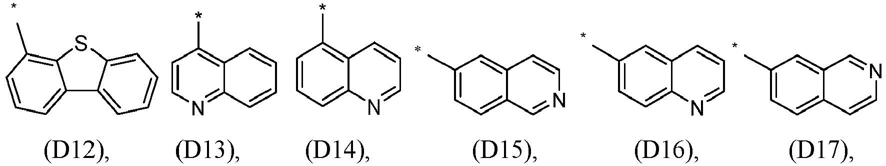

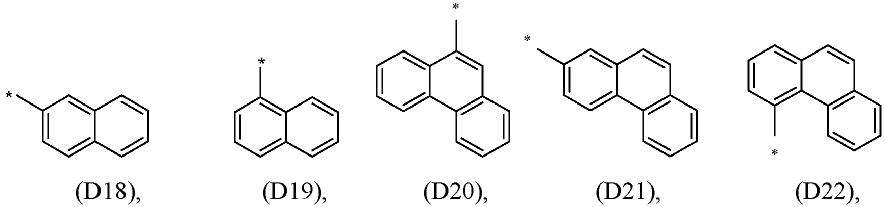

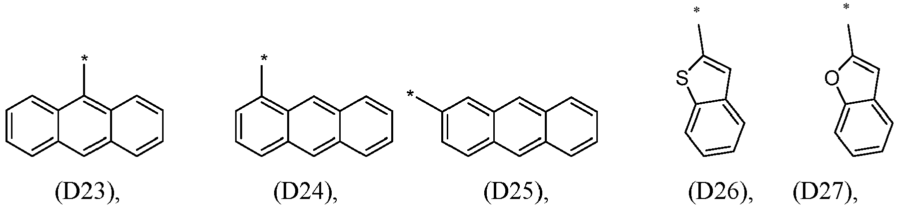

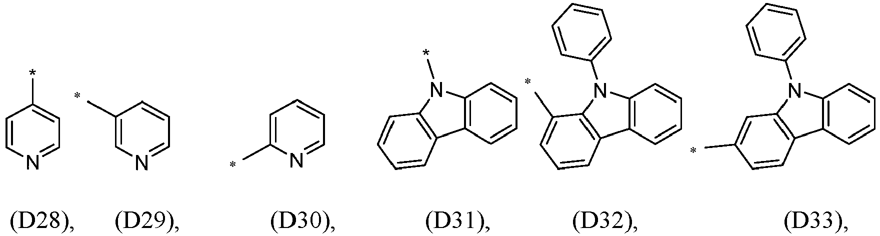

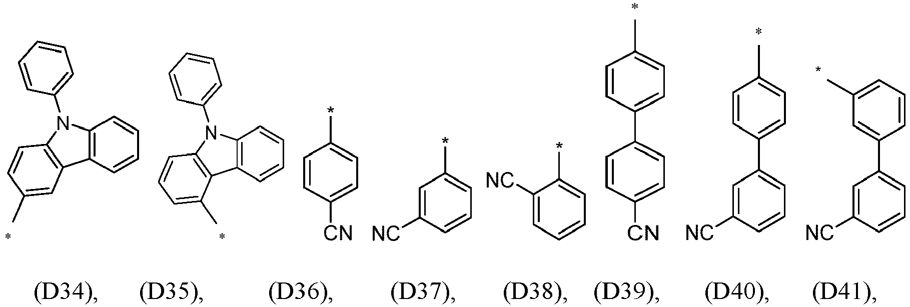

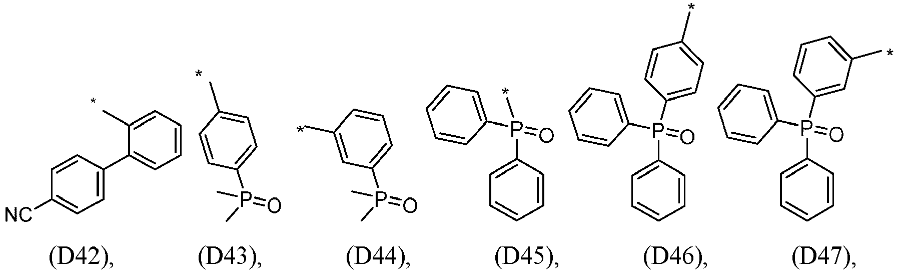

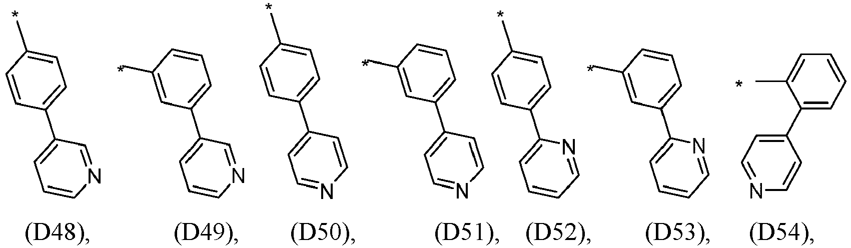

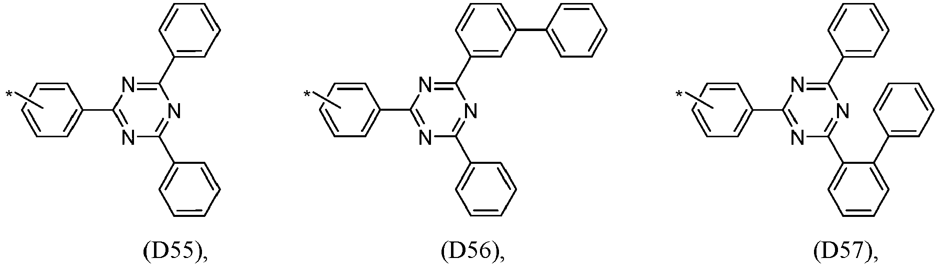

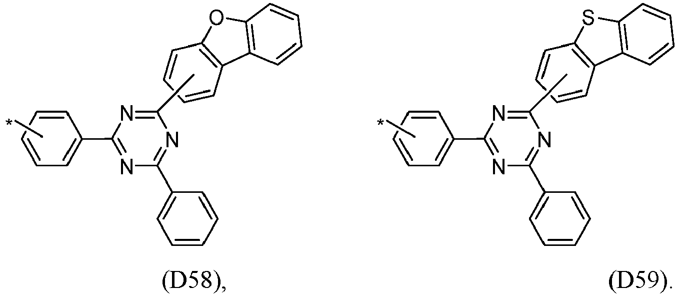

8. The compound of formula 1 according to any of the previous claims 1 to 7, wherein L is selected from a group of (E1) to (E23): 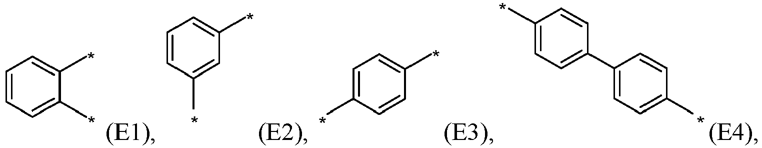 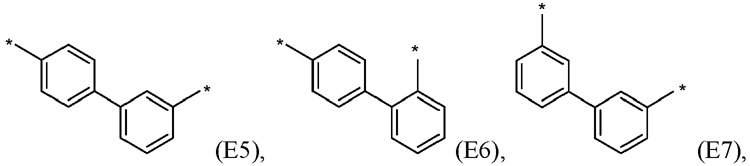 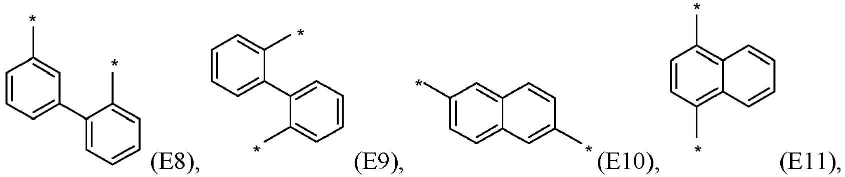 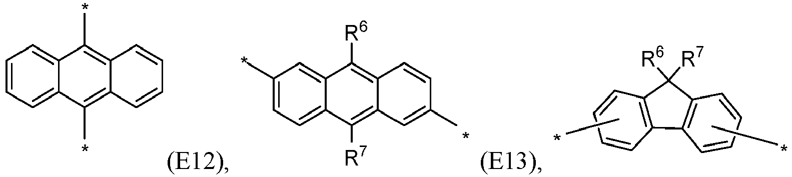 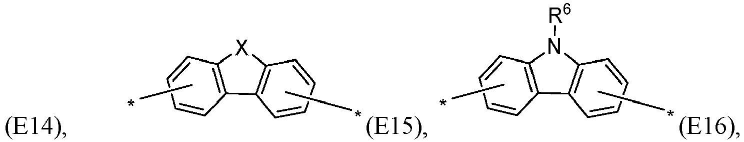 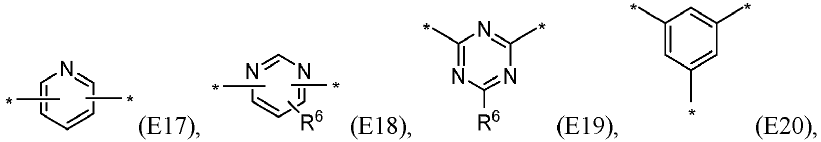 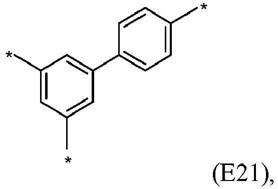 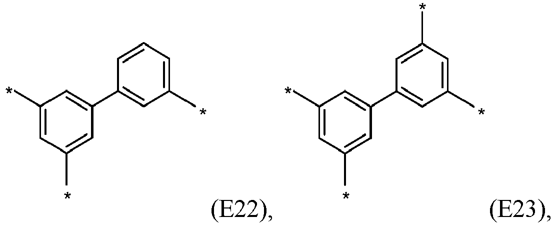 wherein R⁶ and R⁷ are independently selected from H, C₁ to C₁₆ alkyl, C₁ to C₁₆ alkoxy, C₆ to C₂₄ aryl, C₃ to C₂₄ heteroaryl, perfluorinated C₁ to C₁₆ alkyl, perfluorinated C₁ to C₁₆ alkoxy.

9. The compound of formula 1 to any of the previous claims 1 to 8, wherein the compound of formula 1 is selected from (F1) to (F30):

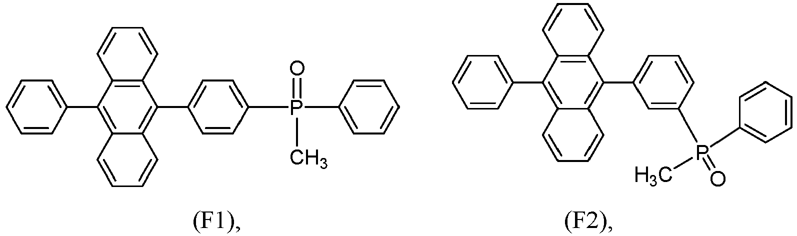

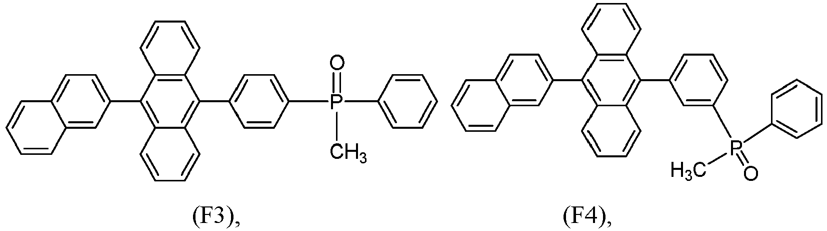

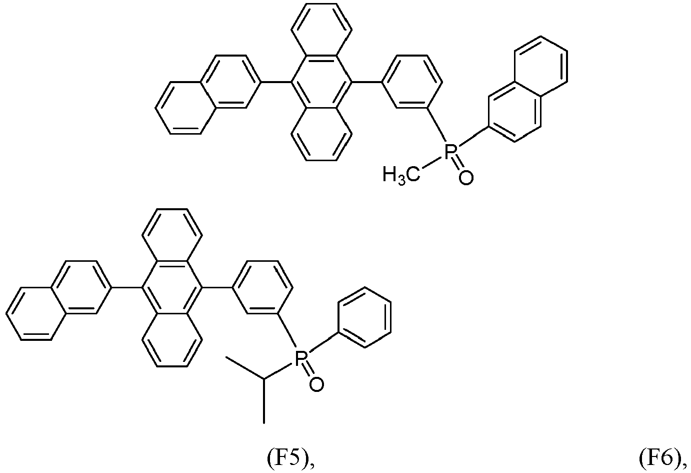

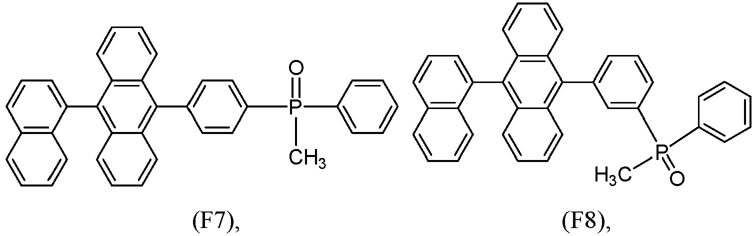

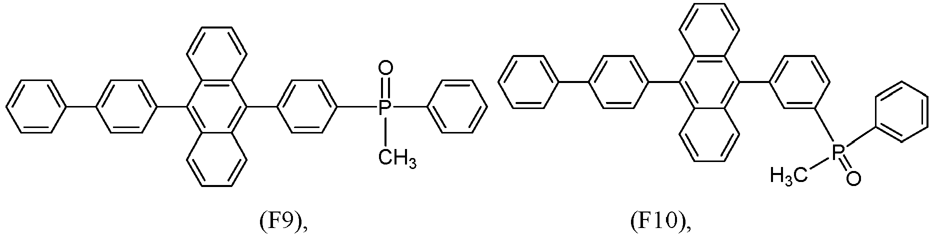

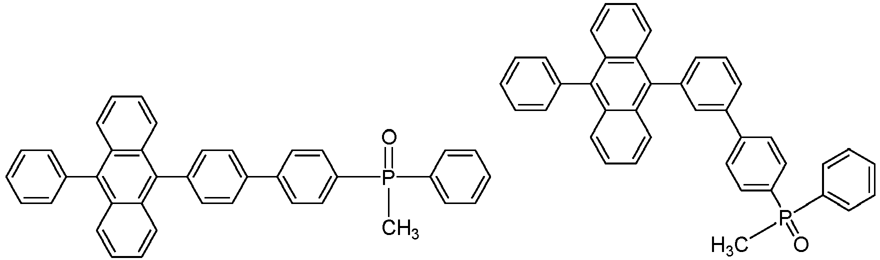

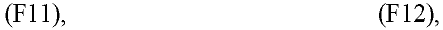

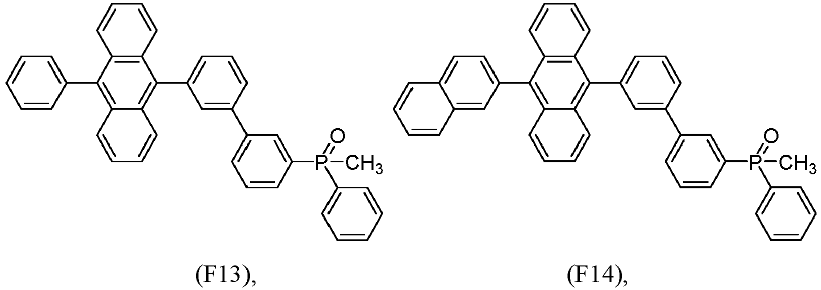

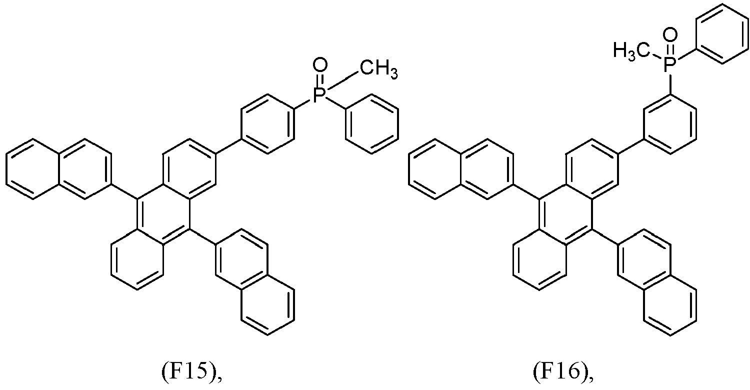

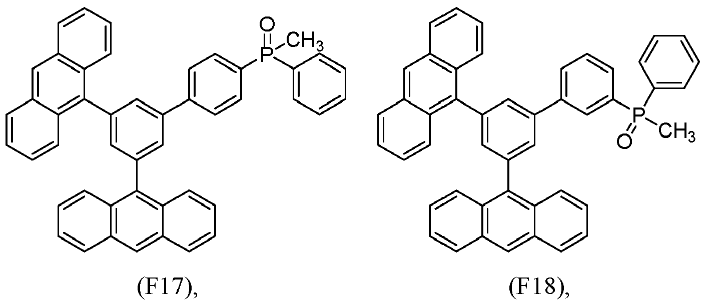

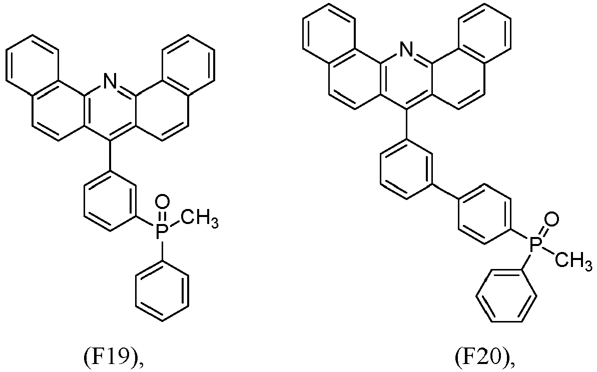

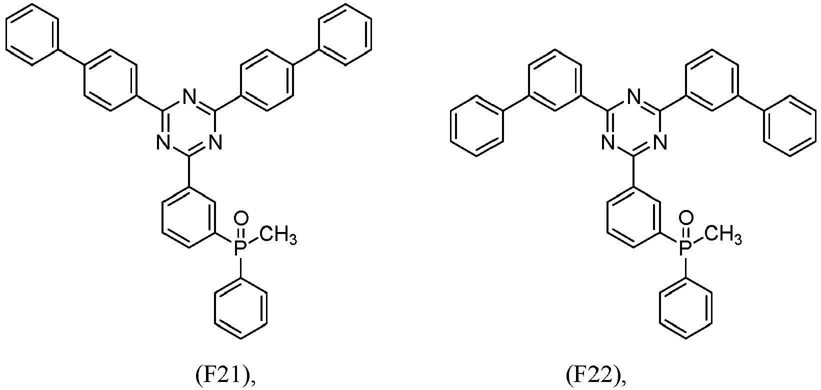

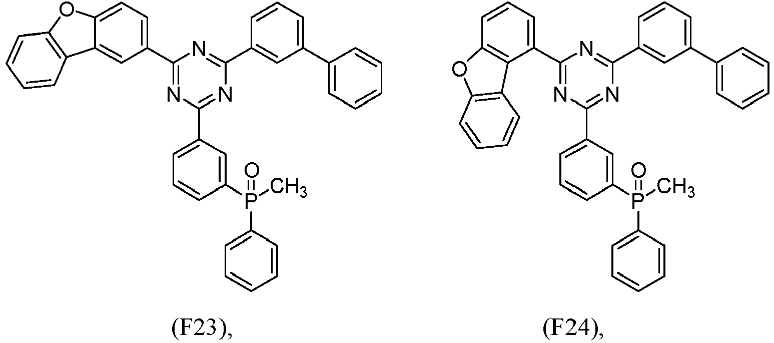

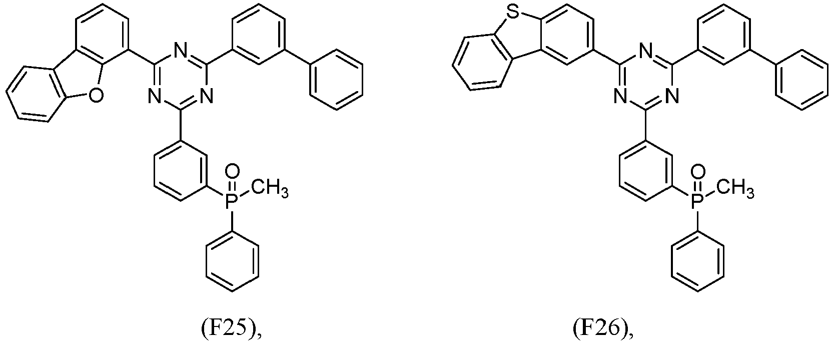

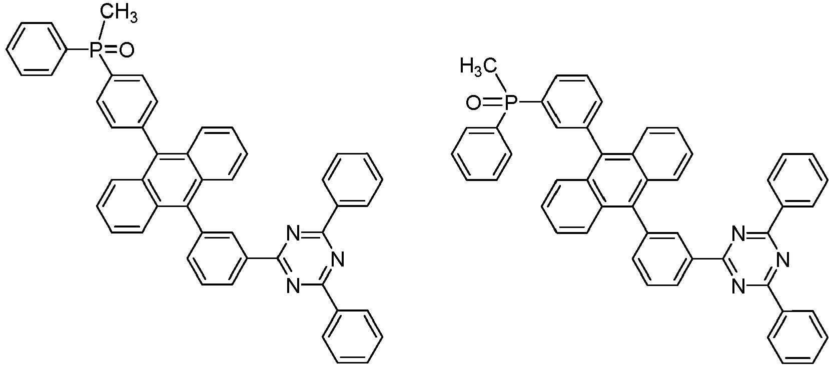

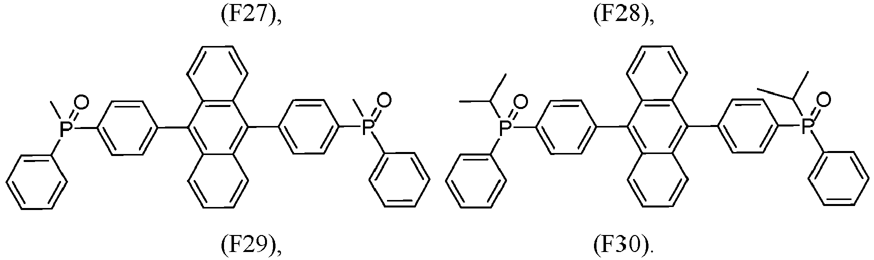

10. An organic semiconductor layer comprising at least one compound selected from formula 1 according to any of the preceding claims 1 to 9.

11. The organic semiconductor layer according to claim 10, further comprises a metal, metal salt or a metal organic complex, preferably a monovalent or divalent metal organic complex, more preferably an alkali or alkaline earth organic complex, and further more preferably LiQ or alkali borate or alkaline earth borate.

12. An organic electronic device comprising at least one organic semiconductor layer according to any of the preceding claim 10 or 11, wherein the at least one organic semiconductor layer comprises a compound of formula 1 according to any of the preceding claims 1 to 9.

13. An organic electronic device according to claim 12, further comprising an anode and a cathode, preferably the organic semiconductor layer is arranged between the anode and the cathode.

14. An organic electronic device according to claim 12 or 13, further comprising at least one photoactive layer arranged between the anode and the cathode; preferably the organic semiconductor layer is arrange between the at least one photoactive layer and the cathode.

15. The organic electronic device according to any of the preceding claims 12 to 14, wherein the organic electronic device is a light emitting device, thin film transistor, a battery, a display device or a photovoltaic cell, preferably a light emitting device.

## Patentansprüche

1. Verbindung der Formel 1: 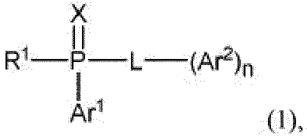 wobei
X für 0 steht;
R¹ aus einer substituierten oder unsubstituierten C₁- bis C₁₈-Alkylgruppe ausgewählt sind,
wobei die Substituenten der substituierten C₁- bis C₁₈-Alkylgruppe aus C₆- bis C₂₄-Aryl, C₃- bis C₂₄-Heteroaryl, Halogen, CN, perfluoriertem C₁- bis C₁₆-Alkyl und perfluoriertem C₁- bis C₁₆-Alkoxy ausgewählt sind;
Ar¹ aus einem unsubstituierten C₆- bis C₂₄-Aryl ausgewählt ist;
L aus einer substituierten oder unsubstituierten C₆- bis C₁₉-Arylen- oder C₃- bis C₂₄-Heteroarylengruppe ausgewählt ist,
wobei die Substituenten der substituierten C₆- bis C₁₉-Arylen- oder substituierten C₃- bis C₂₄-Heteroarylengruppe aus C₁-bis C₁₆-Alkyl, C₁- bis C₁₆-Alkoxy, C₆- bis C₂₄-Aryl, C₃- bis C₂₄-Heteroaryl, perfluoriertem C₁- bis C₁₆-Alkyl und perfluoriertem C₁- bis C₁₆-Alkoxy ausgewählt sind;
Ar² aus einer substituierten oder unsubstituierten C₁₀- bis C₄₂-Aryl- oder substituierten oder unsubstituierten C₃- bis C₄₂-Heteroarylgruppe ausgewählt ist, wobei die C₁₀- bis C₄₂-Arylgruppe ein konjugiertes System von delokalisierten Elektronen mit mindestens 10 konjugierten delokalisierten Elektronen umfasst, und
wobei die Substituenten der substituierten C₁₀- bis C₄₂-Aryl- oder C₃- bis C₄₂-Heteroarylgruppe unabhängig aus C₁- bis C₁₆-Alkyl, C₁- bis C₁₆-Alkoxy, substituiertem oder unsubstituiertem C₆-bis C₃₆-Aryl, substituiertem oder unsubstituiertem C₃- bis C₃₆-Heteroaryl, Halogen, CN, perfluoriertem C₁- bis C₁₆-Alkyl, perfluoriertem C₁- bis C₁₆-Alkoxy, PXR³R⁴, L-PXR³R⁴ und COR⁵ ausgewählt sind;
wobei R³, R⁴ und R⁵ unabhängig aus C₁-bis C₁₆-Alkyl, C₆- bis C₂₄-Aryl, C₃-bis C₂₄-Heteroaryl und perfluoriertem C₁- bis C₁₆-Alkyl ausgewählt sind und wobei die Substituenten des substituierten C₆- bis C₃₆-Aryls oder des substituierten C₃- bis C₃₆-Heteroaryls unabhängig aus C₁- bis C₁₆-Alkyl, C₁-bis C₁₆-Alkoxy, C₆- bis C₁₈-Aryl, C₄-bis C₁₈-Heteroaryl, CN und Halogen ausgewählt sind;
n für eine ganze Zahl steht, die aus 1, 2 oder 3 ausgewählt ist; und
unter Ausschluss von Verbindung 2, 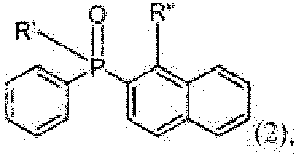 wobei R' aus C₁- bis C₄-Alkyl ausgewählt ist und R" aus 1-Naphthyl, (1,1'-Biphenyl)-2-yl und/oder 2-Methoxy-1-naphthalinyl ausgewählt ist;
wobei Formel 1 mindestens 6 bis 25 aromatische Ringe umfasst.

2. Verbindung der Formel 1 nach Anspruch 1, wobei
X für 0 steht;
R¹ für C₁- bis C₁₂-Alkyl, vorzugsweise C₁- bis C₁₀-Alkyl, weiter bevorzugt C₁- bis C₆-Alkyl und weiter bevorzugt Methyl steht,
wobei die Substituenten der substituierten C₁- bis C₁₈-Alkylgruppe aus C₆- bis C₂₄-Aryl, C₃- bis C₂₄-Heteroaryl, Halogen, CN, perfluoriertem C₁- bis C₁₆-Alkyl und perfluoriertem C₁- bis C₁₆-Alkoxy ausgewählt sind;
Ar¹ für unsubstituiertes C₆- bis C₁₉-Aryl, vorzugsweise C₆- bis C₁₈-Aryl, weiter bevorzugt C₆- bis C₁₂-Aryl und weiter bevorzugt unsubstituiertes C₆- bis C₁₂-Aryl steht;
Ar² aus einer substituierten oder unsubstituierten C₁₀- bis C₃₆-Aryl- oder substituierten oder unsubstituierten C₃- bis C₃₅-Heteroarylgruppe ausgewählt ist, wobei die C₁₀- bis C₃₆-Arylgruppe ein konjugiertes System von delokalisierten Elektronen mit mindestens 10 konjugierten delokalisierten Elektronen umfasst, und
wobei die Substituenten der substituierten C₁₀- bis C₃₆-Arylgruppe oder C₃- bis C₃₅-Heteroarylgruppe unabhängig aus C₁-bis C₆-Alkyl, C₁- bis C₆-Alkoxy, substituiertem oder unsubstituiertem C₆-bis C₁₂-Aryl, substituiertem oder unsubstituiertem C₃- bis C₁₁-Heteroaryl, Halogen, CN, perfluoriertem C₁- bis C₁-Alkyl, perfluoriertem C₁- bis C₆-Alkoxy, PXR³R⁴, L-PXR³R⁴ und COR⁵ ausgewählt sind und
wobei R³, R⁴ und R⁵ unabhängig aus C₁-bis C₆-Alkyl, substituiertem oder unsubstituiertem C₆- bis C₁₂-Aryl, substituiertem oder unsubstituiertem C₃- bis C₁₁-Heteroaryl und perfluoriertem C₁- bis C₆-Alkyl ausgewählt sind und wobei
die Substituenten des substituierten C₆- bis C₁₂-Aryls oder des substituierten C₃- bis C₁₁-Heteroaryls unabhängig aus C₁- bis C₆-Alkyl, C₁-bis C₆-Alkoxy, C₆- bis C₁₂-Aryl, C₄-bis C₁₁-Heteroaryl, CN und Halogen ausgewählt sind;
L aus einer substituierten oder unsubstituierten C₆- bis C₁₈-Arylen- oder C₃- bis C₁₇-Heteroarylengruppe, vorzugsweise aus einer substituierten oder unsubstituierten C₆- bis C₁₂-Arylen- oder C₃- bis C₁₁-Heteroarylengruppe, weiter bevorzugt aus einer substituierten oder unsubstituierten C₆- bis C₁₀-Arylen- oder C₃- bis C₉-Heteroarylengruppe und weiter bevorzugt aus einer Phenylengruppe ausgewählt ist; wobei
die Substituenten der substituierten Arylen- oder substituierten Heteroarylengruppe unabhängig aus C₁- bis C₆-Alkyl, C₁- bis C₆-Alkoxy, C₆- bis C₁₂-Aryl, C₃- bis C₁₁-Heteroaryl, perfluoriertem C₁- bis C₆-Alkyl und perfluoriertem C₁- bis C₆-Alkoxy ausgewählt sind;
n für aus 1 und 2 ausgewählt ist, vorzugsweise n für 1 steht.

3. Verbindung der Formel 1 nach einem der vorhergehenden Ansprüche 1 und 2, wobei für die Verbindung der Formel 1:
- Ar² aus einer substituierten oder unsubstituierten C₁₂- bis C₃₀-Aryl- oder substituierten oder unsubstituierten C₁₁- bis C₂₉-Heteroarylgruppe, vorzugsweise aus einer substituierten oder unsubstituierten C₁₈- bis C₂₄-Aryl- oder substituierten oder unsubstituierten C₁₇- bis C₂₃-Heteroarylgruppe, ausgewählt ist und/oder
- Ar² aus einer substituierten oder unsubstituierten C₁₂- bis C₃₀-Aryl- oder substituierten oder unsubstituierten C₁₁- bis C₂₉-Heteroarylgruppe, vorzugsweise aus einer substituierten oder unsubstituierten C₁₈- bis C₂₄-Aryl- oder substituierten oder unsubstituierten C₁₇- bis C₂₃-Heteroarylgruppe, ausgewählt ist und Ar² mindestens zwei anellierte Aryl- und/oder mindestens zwei anellierte Heteroarylgruppen umfasst, vorzugsweise Ar² mindestens drei anellierte Arylund/oder Heteroarylgruppen umfasst; und/oder
- Ar² aus einer substituierten oder unsubstituierten C₁₂- bis C₃₀-Aryl- oder substituierten oder unsubstituierten C₁₁- bis C₂₉-Heteroarylgruppe, vorzugsweise aus einer substituierten oder unsubstituierten C₁₈- bis C₂₄-Aryl- oder substituierten oder unsubstituierten C₁₇- bis C₂₃-Heteroarylgruppe, die frei von einer anellierten Aryl- und/oder Heteroarylgruppe ist, ausgewählt ist und vorzugsweise Ar² frei von einer anellierten Aryl- und/oder Heteroarylgruppe ist.

4. Verbindung der Formel 1 nach einem der vorhergehenden Ansprüche 1 bis 3, wobei
- Ar¹ aus unsubstituiertem Phenyl, Biphenyl, Fluorenyl, Benzofluorenyl, Naphthyl, Phenanthryl und Anthracenyl ausgewählt ist und/oder
- Ar² aus substituiertem oder unsubstituiertem Fluoren, Benzofluoren, Dibenzofluoren, 9,9'-Spirobi[fluoren], 13H-Indeno[1,2-l]phenanthren, Naphthalin, Anthracen, Phenanthren, Pyren, Perylen, Triphenylen, Rubren, Chrysen, Fluoranthen, Spiro[benzo[de]anthracen-7,9'-fluoren], Acridin, Benzoacridin, Dibenzoacridin, Chinolin, Chinazolin, Chinoxalin, Benzochinolin, Phenanthrolin, Benzimidazolyl, Triazin, Pyrimidin, Pyridin, Pyrazin, Azatriphenylen, Carbazol, Dibenzofuran, Dibenzothiophen, Dibenzoselenophen, Azadibenzofuran, Azadibenzothiophen, Azadibenzoselenophen, Diazadibenzothiophen und Diazadibenzoselenophen ausgewählt ist.

5. Verbindung der Formel 1 nach einem der vorhergehenden Ansprüche 1 bis 4, wobei Ar¹ und/oder Ar² 0 oder 1 sp³-hybridisierte Kohlenstoffatome enthalten/enthält.

6. Verbindung der Formel 1 nach einem der vorhergehenden Ansprüche 1 bis 5, wobei Ar² aus einer C1-bis C35-Gruppe ausgewählt ist: 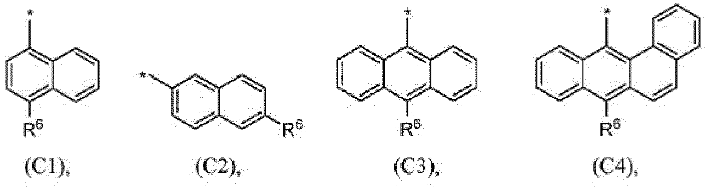 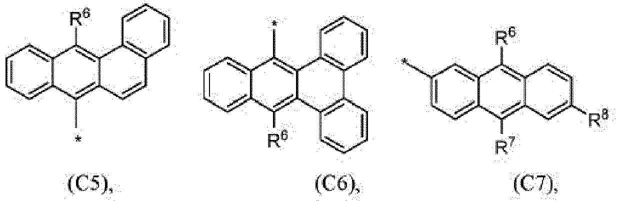 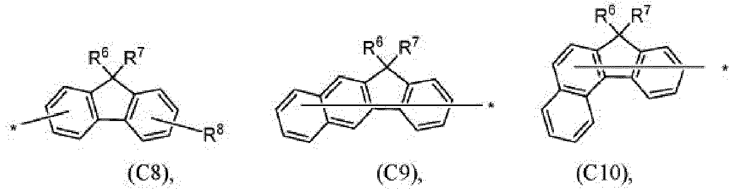 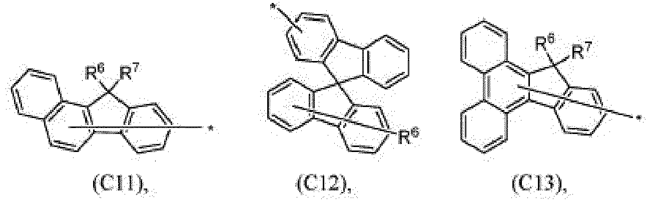 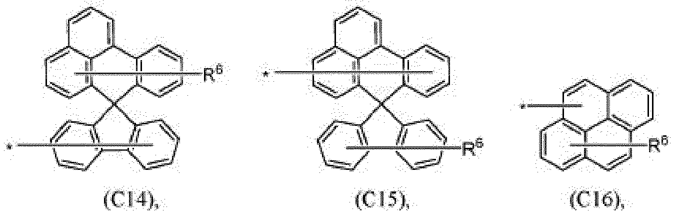 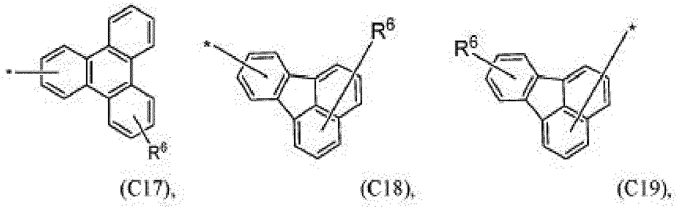 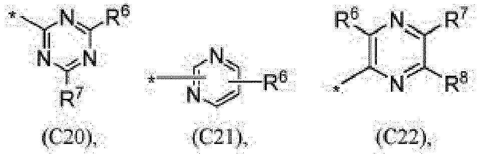 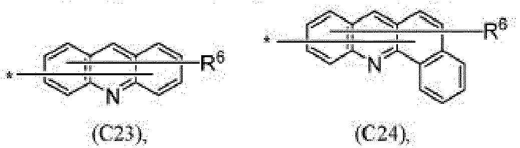 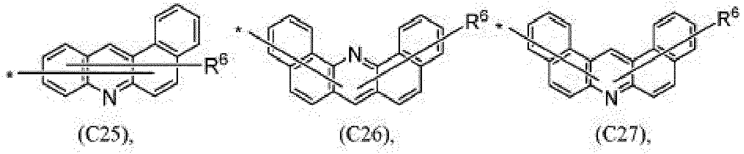 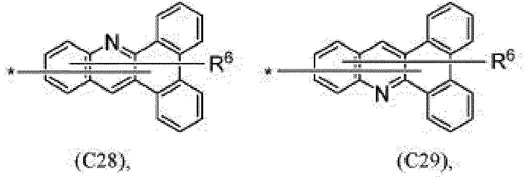 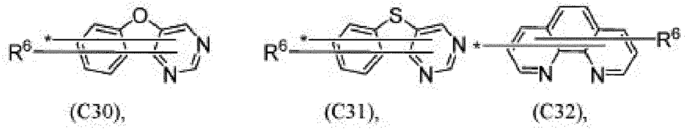 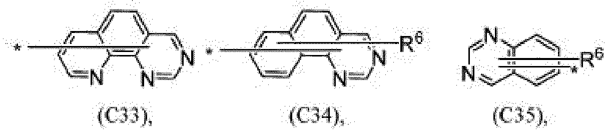 wobei
R⁶, R⁷ und R⁸ unabhängig aus H, C₁- bis C₁₆-Alkyl, C₁- bis C₁₆-Alkoxy, substituiertem oder unsubstituiertem C₆- bis C₂₄-Aryl, substituiertem oder unsubstituiertem C₃- bis C₂₄-Heteroaryl, Halogen, CN, perfluoriertem C₁-bis C₁₆-Alkyl, perfluoriertem C₁- bis C₁₆-Alkoxy, PXR³R⁴, L-PXR³R⁴ und COR⁵ ausgewählt sind;
wobei R³, R⁴ und R⁵ unabhängig aus C₁- bis C₁₆-Alkyl, C₆- bis C₂₄-Aryl, C₃- bis C₂₄-Heteroaryl und perfluoriertem C₁- bis C₁₆-Alkyl ausgewählt sind;
wobei die Substituenten des substituierten C₆-bis C₂₄-Aryls und des substituierten C₃- bis C₂₄-Heteroaryls aus C₁- bis C₁₆-Alkyl, C₁- bis C₁₆-Alkoxy, C₆- bis C₁₈-Aryl, C₄- bis C₁₈-Heteroaryl, CN und Halogen ausgewählt sind;
vorzugsweise R⁶, R⁷ und R⁸ unabhängig aus H, substituiertem oder unsubstituiertem Phenyl, Biphenyl, Fluorenyl, Naphthyl, Phenanthryl, Anthracenyl, Pyrenyl, Benzofuranyl, Benzothiophenyl, Dibenzofuranyl, Dibenzothiophenyl, Pyridyl, Chinolinyl, Pyrimidinyl, Triazinyl, Phenanthrolinyl, PXR³R⁴, L-PXR³R⁴ und COR⁵ ausgewählt sind;
wobei R³, R⁴ und R⁵ unabhängig aus C₁- bis C₁₆-Alkyl, C₆- bis C₂₄-Aryl, C₃- bis C₂₄-Heteroaryl und perfluoriertem C₁- bis C₁₆-Alkyl ausgewählt sind und
die Substituenten des substituierten Phenyls, Biphenyls, Fluorenyls, Naphthyls, Phenanthryls, Anthracenyls, Pyrenyls, Benzofuranyls, Benzothiophenyls, Dibenzofuranyls, Dibenzothiophenyls, Pyridyls, Chinolinyls, Pyrimidinyls, Triazinyls und Phenanthrolinyls unabhängig aus C₁- bis C₁₆-Alkyl, C₁- bis C₁₆-Alkoxy, C₆- bis C₁₈-Aryl, C₄- bis C₁₈-Heteroaryl, CN und Halogen ausgewählt sind.

7. Verbindung der Formel 1 nach einem der vorhergehenden Ansprüche 1 bis 6, wobei die Substituenten der substituierten Arylgruppe der Ar²-Gruppe oder die Substituenten der substituierten Heteroarylgruppe der Ar²-Gruppe oder die Substituenten der (C1)- bis (C35)-Gruppen unabhängig aus Halogen, CN und D1 bis D59 ausgewählt sind:

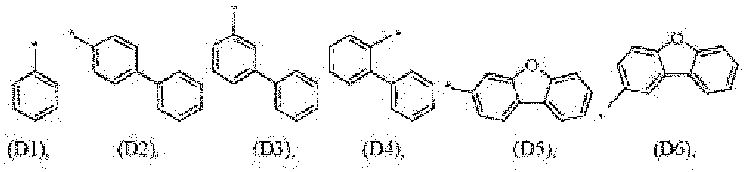

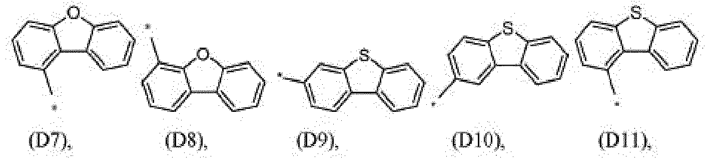

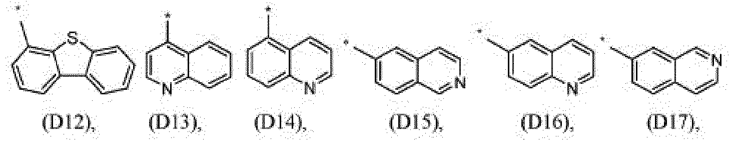

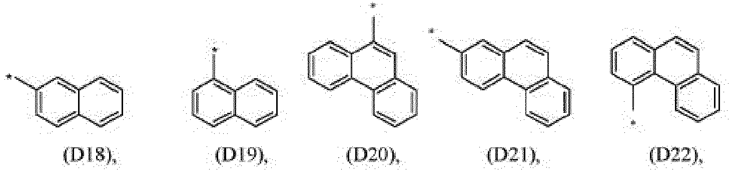

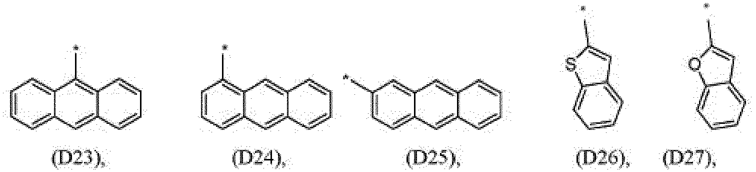

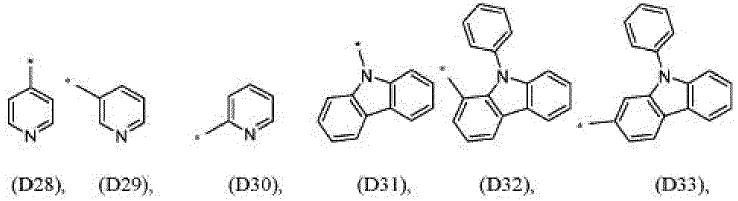

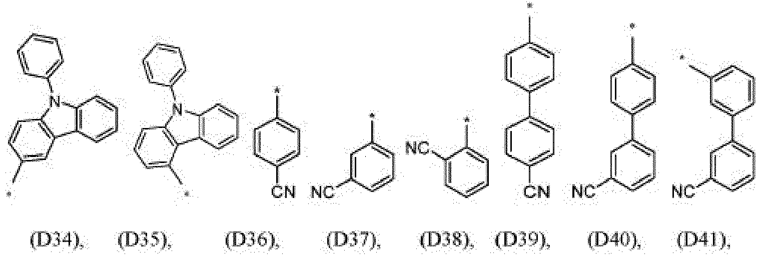

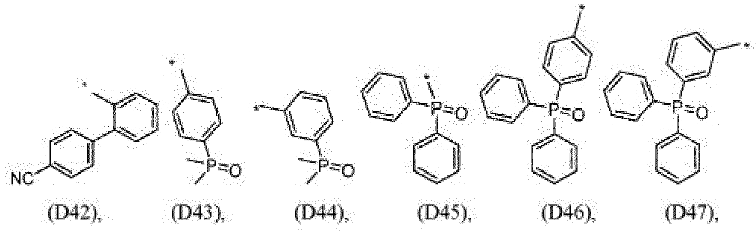

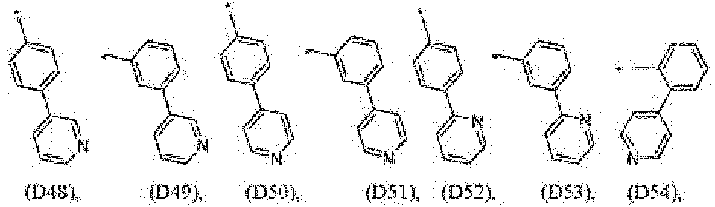

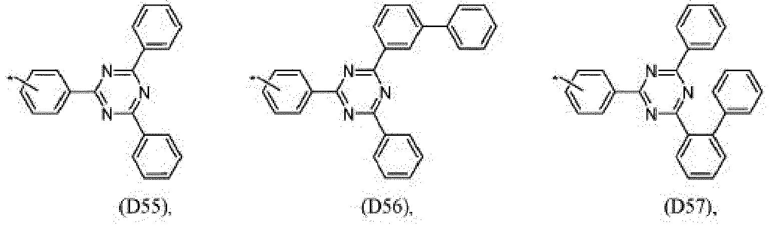

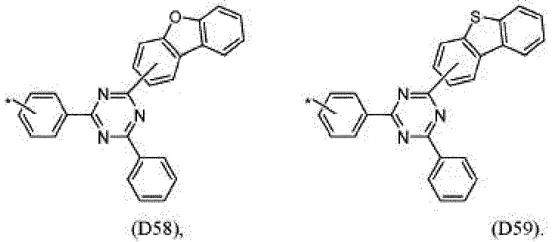

8. Verbindung der Formel 1 nach einem der vorhergehenden Ansprüche 1 bis 7, wobei L aus einer Gruppe von (E1) bis (E23) ausgewählt ist: 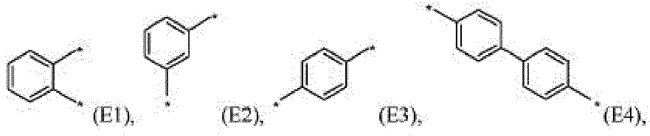 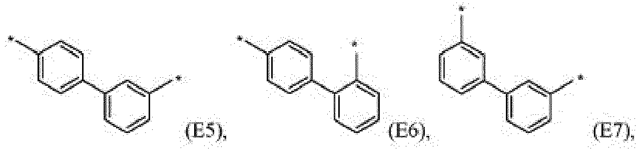 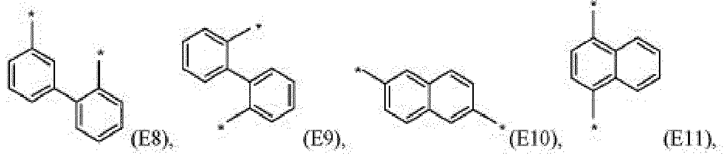 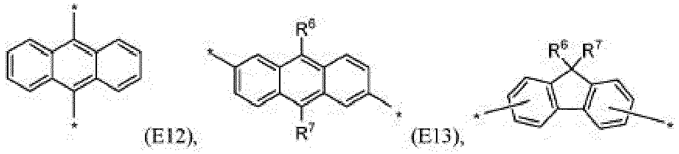 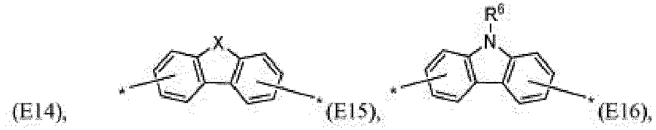 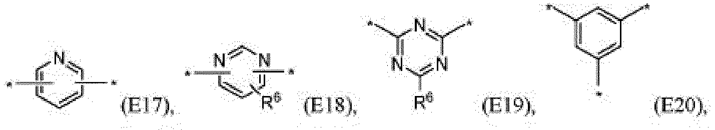 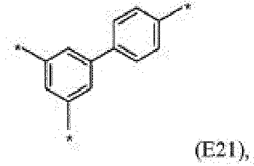 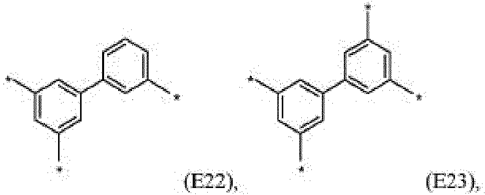 wobei R⁶ und R⁷ unabhängig aus H, C₁- bis C₁₆-Alkyl, C₁- bis C₁₆-Alkoxy, C₆- bis C₂₄-Aryl, C₃- bis C₂₄-Heteroaryl, perfluoriertem C₁- bis C₁₆-Alkyl und perfluoriertem C₁- bis C₁₆-Alkoxy ausgewählt sind.

9. Verbindung der Formel 1 nach einem der vorhergehenden Ansprüche 1 bis 8, wobei die Verbindung der Formel 1 aus (F1) bis (F30) ausgewählt ist:

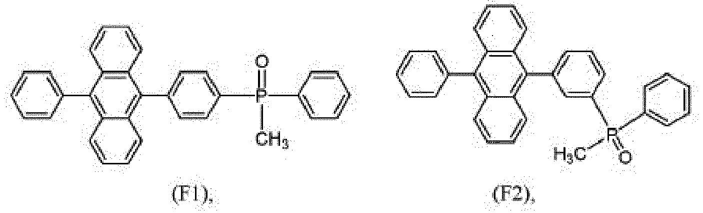

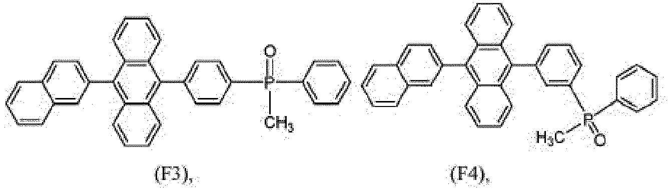

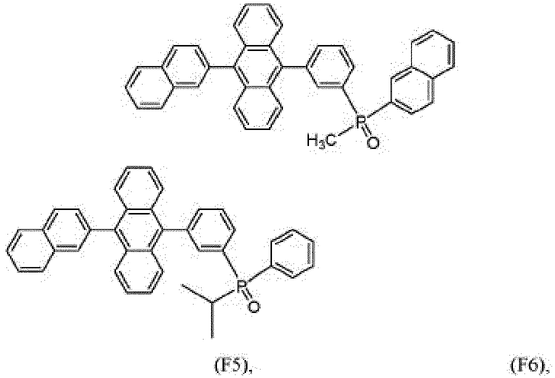

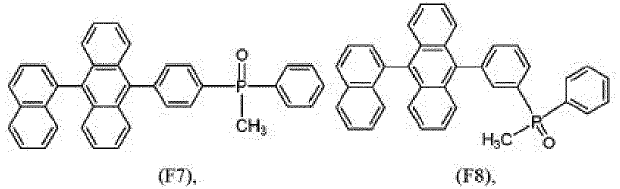

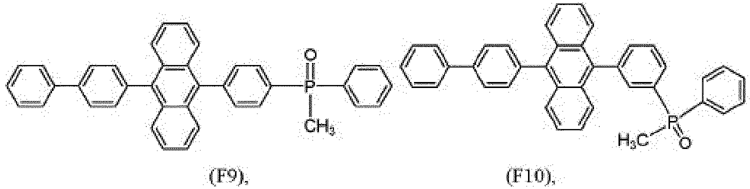

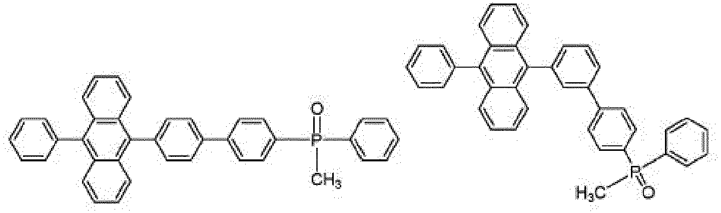

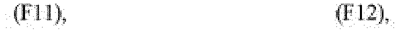

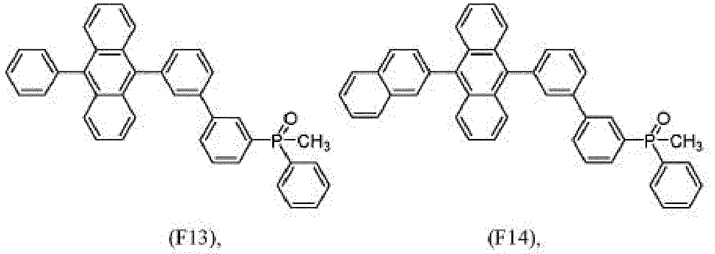

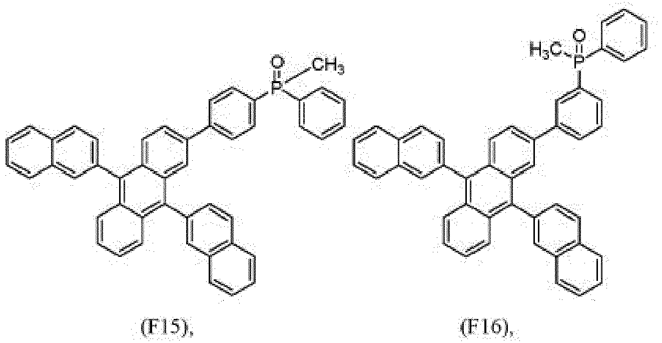

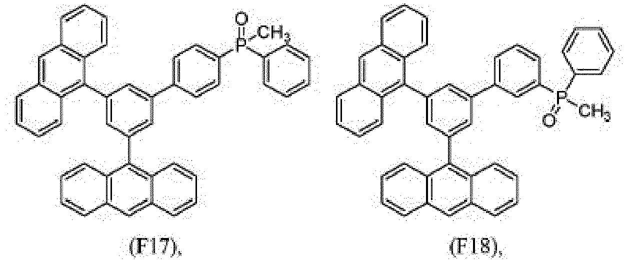

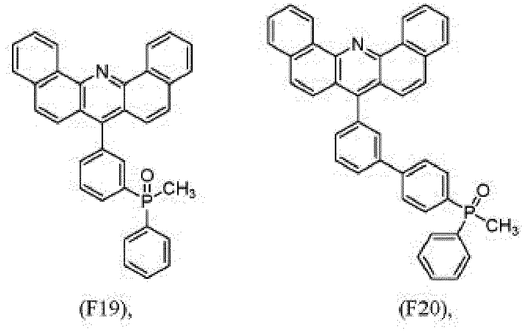

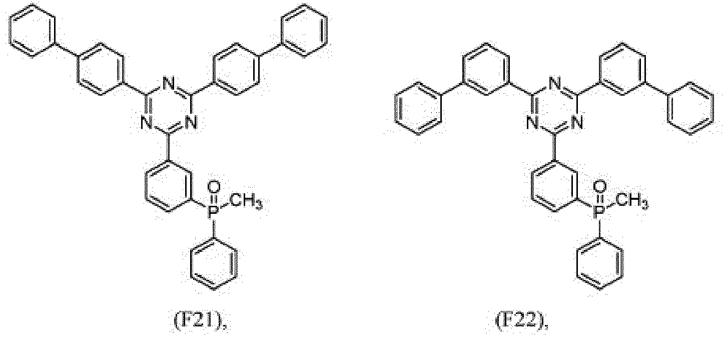

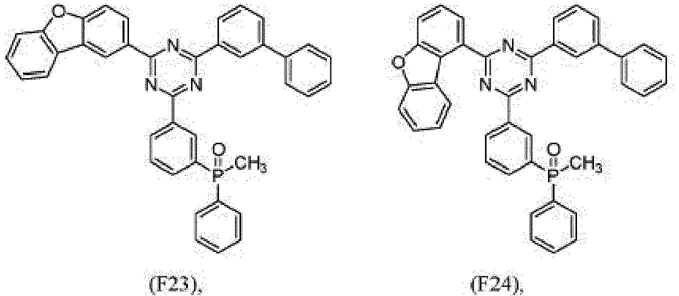

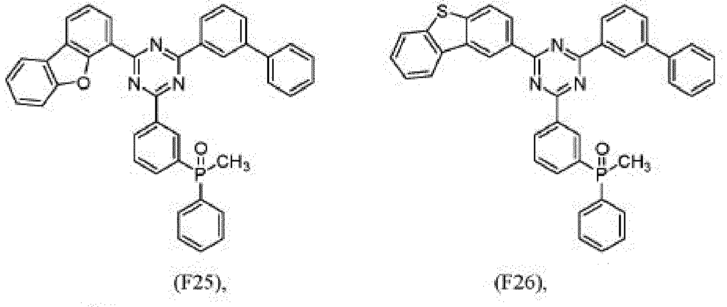

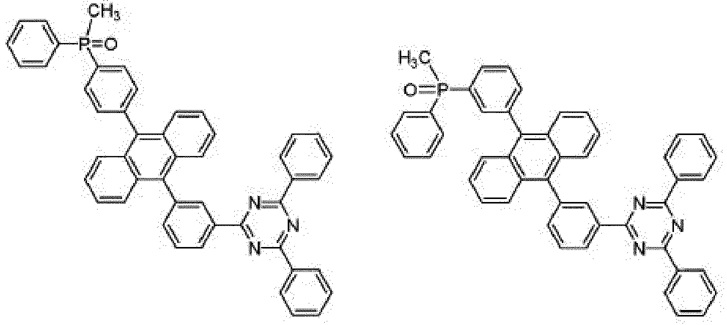

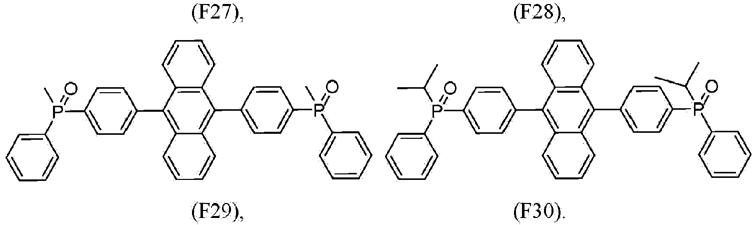

10. Organische Halbleiterschicht, umfassend mindestens eine Verbindung, die aus Formel 1 nach einem der vorhergehenden Ansprüche 1 bis 9 ausgewählt ist.

11. Organische Halbleiterschicht nach Anspruch 10, ferner umfassend ein Metall, ein Metallsalz oder einen organischen Metallkomplex, vorzugsweise einen organischen Komplex eines einwertigen oder zweiwertigen Metalls, weiter bevorzugt LiQ oder Alkaliborat oder Erdalkaliborat.

12. Organische elektronische Vorrichtung, umfassend mindestens eine organische Halbleiterschicht nach einem der vorhergehenden Ansprüche 10 und 11, wobei die mindestens eine organische Halbleiterschicht eine Verbindung der Formel 1 nach einem der vorhergehenden Ansprüche 1 bis 9 umfasst.

13. Organische elektronische Vorrichtung nach Anspruch 12, ferner umfassend eine Anode und eine Kathode, wobei die organische Halbleiterschicht vorzugsweise zwischen der Anode und der Kathode angeordnet ist.

14. Organische elektronische Vorrichtung nach Anspruch 12 oder 13, ferner umfassend mindestens eine photoreaktive Schicht, die zwischen der Anode und der Kathode angeordnet ist, wobei die organische Halbleiterschicht vorzugsweise zwischen der mindestens einen photoaktiven Schicht und der Kathode angeordnet ist.

15. Organische elektronische Vorrichtung nach einem der vorhergehenden Ansprüche 12 bis 14, wobei es sich bei der organischen elektronischen Vorrichtung um eine lichtemittierende Vorrichtung, einen Dünnschichttransistor, eine Batterie, eine Anzeigevorrichtung oder eine Photovoltaikzelle, vorzugsweise eine lichtemittierende Vorrichtung, handelt.

## Revendications

1. Composé de formule 1 : 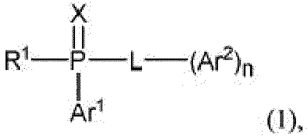
X étant O ;
R¹ étant choisi parmi un groupe C₁ à C₁₈ alkyle substitué ou non substitué,
les substituants du groupe C₁ à C₁₈ alkyle substitué étant choisis parmi C₆ à C₂₄ aryle, C₃ à C₂₄ hétéroaryle, halogène, CN, C₁ à C₁₆ alkyle perfluoré, C₁ à C₁₆ alcoxy perfluoré ;
Ar¹ étant choisi parmi un C₆ à C₂₄ aryle substitué ;
L étant choisi parmi un groupe C₆ à C₁₉ arylène ou C₃ à C₂₄ hétéroarylène substitué ou non substitué,
les substituants du groupe C₆ à C₁₉ arylène substitué ou du groupe C₃ à C₂₄ hétéroarylène substitué étant indépendamment choisis parmi C₁ à C₁₆ alkyle, C₁ à C₁₆ alcoxy, C₆ à C₂₄ aryle, C₃ à C₂₄ hétéroaryle, C₁ à C₁₆ alkyle perfluoré, C₁ à C₁₆ alcoxy perfluoré ;
Ar² étant choisi parmi un groupe C₁₀ à C₄₂ aryle substitué ou non substitué ou C₃ à C₄₂ hétéroaryle substitué ou non substitué, le groupe C₁₀ à C₄₂ aryle comprenant un système conjugué d'électrons délocalisés possédant au moins 10 électrons délocalisés conjugués, et les substituants du groupe C₁₀ à C₄₂ aryle substitué ou du groupe C₃ à C₄₂ hétéroaryle substitué étant indépendamment choisis parmi C₁ à C₁₆ alkyle, C₁ à C₁₆ alcoxy, C₆ à C₃₆ aryle substitué ou non substitué, C₃ à C₃₆ hétéroaryle substitué ou non substitué, halogène, CN, C₁ à C₁₆ alkyle perfluoré, C₁ à C₁₆ alcoxy perfluoré, PXR³R⁴, L-PXR³R⁴, COR⁵ ;
R³, R⁴ et R⁵ étant indépendamment choisis parmi C₁ à C₁₆ alkyle, C₆ à C₂₄ aryle, C₃ à C₂₄ hétéroaryle, C₁ à C₁₆ alkyle perfluoré, et
les substituants du C₆ à C₃₆ aryle substitué ou du C₃ à C₃₆ hétéroaryle substitué étant indépendamment choisis parmi C₁ à C₁₆ alkyle, C₁ à C₁₆ alcoxy, C₆ à C₁₈ aryle, C₄ à C₁₈ hétéroaryle, CN, halogène ;
n étant un entier choisi parmi 1, 2 et 3 ; et
à l'exclusion du composé 2, 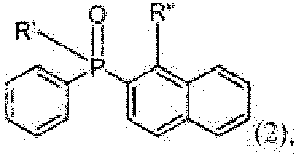
R' étant choisi parmi C₁ à C₄ alkyle, et R" étant choisi parmi 1-naphtyle, (1,1'-biphényl)-2-yle et/ou 2-méthoxy-1-naphtalén-yle ;
la formule 1 comprenant au moins 6 à 25 cycles aromatiques.

2. Composé de formule 1 selon la revendication 1, X étant O ;
R¹ étant C₁ à C₁₂ alkyle, préférablement C₁ à C₁₀ alkyle, de manière davantage préférée C₁ à C₆ alkyle, et de manière plus préférée méthyle,
les substituants du groupe C₁ à C₁₈ alkyle substitué étant choisis parmi C₆ à C₂₄ aryle, C₃ à C₂₄ hétéroaryle, halogène, CN, C₁ à C₁₆ alkyle perfluoré, C₁ à C₁₆ alcoxy perfluoré ;
Ar¹ étant C₆ à C₁₉ aryle non substitué, préférablement C₆ à C₁₈ aryle, de manière davantage préférée C₆ à C₁₂ aryle, et de la manière la plus préférée C₆ à C₁₂ aryle non substitué ;
Ar² étant choisi parmi un groupe C₁₀ à C₃₆ aryle substitué ou non substitué ou C₃ à C₃₅ hétéroaryle substitué ou non substitué, le groupe C₁₀ à C₃₆ aryle comprenant un système conjugué d'électrons délocalisés possédant au moins 10 électrons délocalisés conjugués, et
les substituants du groupe C₁₀ à C₃₆ aryle substitué ou du groupe C₃ à C₃₅ hétéroaryle substitué étant indépendamment choisis parmi C₁ à C₆ alkyle, C₁ à C₆ alcoxy, C₆ à C₁₂ aryle substitué ou non substitué, C₃ à C₁₁ hétéroaryle substitué ou non substitué, halogène, CN, C₁ à C₆ alkyle perfluoré, C₁ à C₆ alcoxy perfluoré, PXR³R⁴, L-PXR³R⁴, COR⁵, et
R³, R⁴ et R⁵ étant indépendamment choisis parmi C₁ à C₆ alkyle, C₆ à C₁₂ aryle substitué ou non substitué, C₃ à C₁₁ hétéroaryle substitué ou non substitué, C₁ à C₆ alkyle perfluoré, et
les substituants du C₆ à C₁₂ aryle substitué ou du C₃ à C₁₁ hétéroaryle substitué étant indépendamment choisis parmi C₁ à C₆ alkyle, C₁ à C₆ alcoxy, C₆ à C₁₂ aryle, C₄ à C₁₁ hétéroaryle, CN, halogène ;
L étant choisi parmi un groupe C₆ à C₁₈ arylène substitué ou non substitué ou C₃ à C₁₇ hétéroarylène substitué ou non substitué, préférablement parmi un groupe C₆ à C₁₂ arylène substitué ou non substitué ou C₃ à C₁₁ hétéroarylène substitué ou non substitué, de manière davantage préférée parmi un groupe C₆ à C₁₀ arylène substitué ou non substitué ou C₃ à C₉ hétéroarylène substitué ou non substitué, et de manière plus préférée parmi un groupe phénylène ;
les substituants du groupe arylène substitué ou du groupe hétéroarylène substitué étant indépendamment choisis parmi C₁ à C₆ alkyle, C₁ à C₆ alcoxy, C₆ à C₁₂ aryle, C₃ à C₁₁ hétéroaryle, C₁ à C₆ alkyle perfluoré, C₁ à C₆ alcoxy perfluoré ;
n étant choisi parmi 1 ou 2, préférablement n étant 1.

3. Composé de formule 1 selon l'une quelconque des revendications précédentes 1 et 2, pour le composé de formule 1 :
- Ar² étant choisi parmi un groupe C₁₂ à C₃₀ aryle substitué ou non substitué ou C₁₁ à C₂₉ hétéroaryle substitué ou non substitué, préférablement parmi un groupe C₁₈ à C₂₄ aryle substitué ou non substitué ou C₁₇ à C₂₃ hétéroaryle substitué ou non substitué ; et/ou
- Ar² étant choisi parmi un groupe C₁₂ à C₃₀ aryle substitué ou non substitué ou C₁₁ à C₂₉ hétéroaryle substitué ou non substitué, préférablement parmi un groupe C₁₈ à C₂₄ aryle substitué ou non substitué ou C₁₇ à C₂₃ hétéroaryle substitué ou non substitué ; et Ar² comprenant au moins deux groupes aryle annelés et/ou au moins deux groupes hétéroaryle annelés, préférablement Ar² comprenant au moins trois groupes aryle et/ou hétéroaryle annelés ; et/ou
- Ar² étant choisi parmi un groupe C₁₂ à C₃₀ aryle substitué ou non substitué ou C₁₁ à C₂₉ hétéroaryle substitué ou non substitué, préférablement parmi un groupe C₁₈ à C₂₄ aryle substitué ou non substitué ou C₁₇ à C₂₃ hétéroaryle substitué ou non substitué, qui est exempt de groupe aryle et/ou hétéroaryle annelé, et préférablement Ar² est exempt de groupe aryle et/ou hétéroaryle annelé.

4. Composé de formule 1 selon l'une quelconque des revendications précédentes 1 à 3,
- Ar¹ étant choisi parmi phényle, biphényle, fluorényle, benzofluorényle, naphtyle, phénanthryle, anthracényle, substitué ou non substitué ; et/ou
- Ar² étant choisi parmi fluorène, benzofluorène, dibenzofluorène, 9,9'-spirobi[fluorène], 13H-indéno[1,2-1]phénanthrène, naphtalène, anthracène, phénanthrène, pyrène, pérylène, triphénylène, rubrène, chrysène, fluoranthène, spiro[benzo[de]anthracène-7,9'-fluorène], acridine, benzoacridine, dibenzoacridine, quinoléine, quinazoline, quinoxaline, benzoquinoléine, phénanthroline, benzimidazole, triazine, pyrimidine, pyridine, pyrazine, azatriphénylène, carbazole, dibenzofuranne, dibenzothiophène, dibenzosélénophène, azadibenzofuranne, aza-dibenzothiophène, azadibenzosélénophène, di-aza-dibenzothiophène, di-aza-dibenzosélénophène, substitué ou non substitué.

5. Composé de formule 1 selon l'une quelconque des revendications précédentes 1 à 4, Ar¹ et/ou Ar² comprenant 0 ou 1 atome de carbone hybridé sp³.

6. Composé de formule 1 selon l'une quelconque des revendications précédentes 1 à 5, Ar² étant choisi parmi un groupe C1 à C35 : 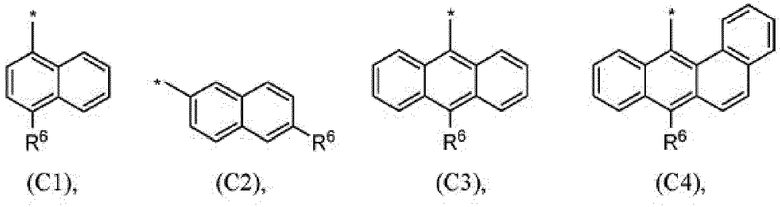 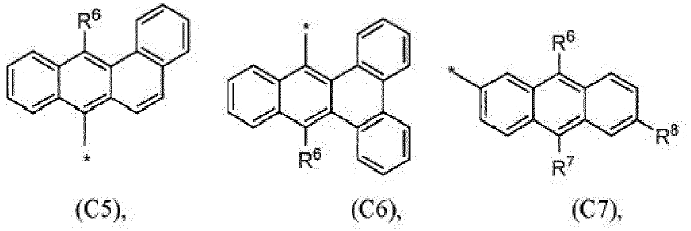 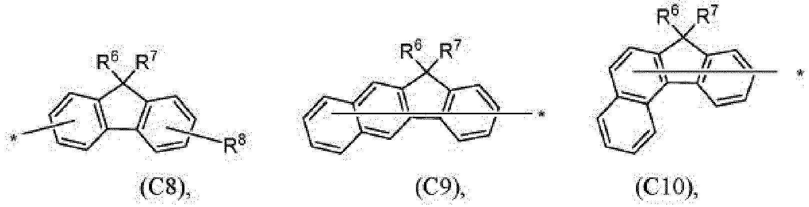 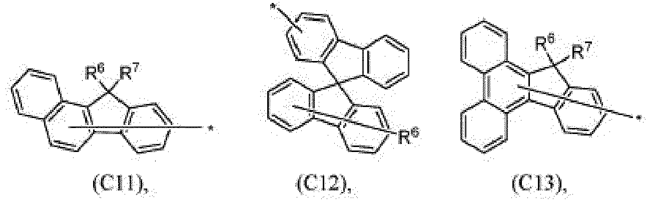 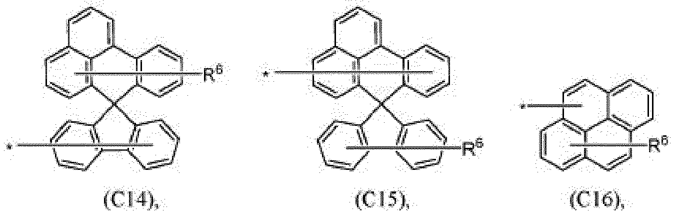 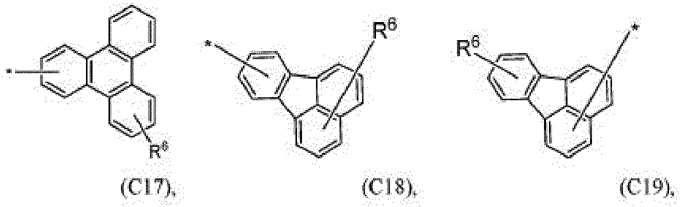 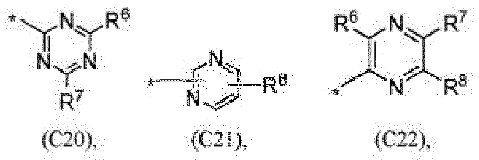 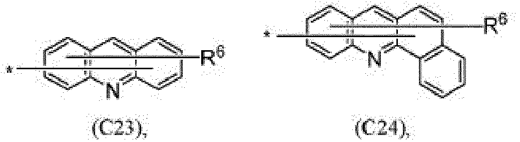 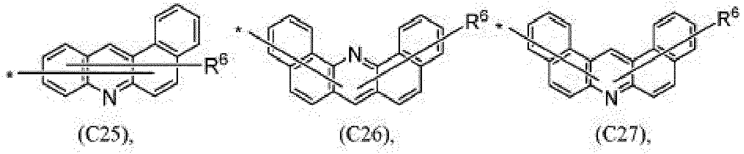 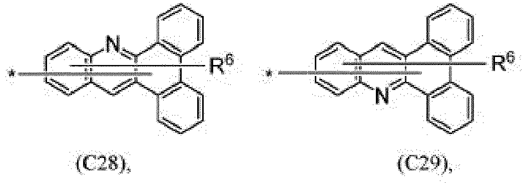 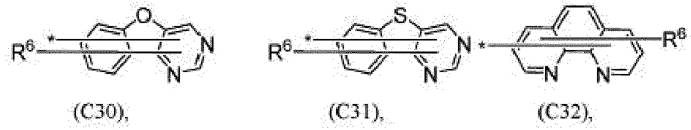 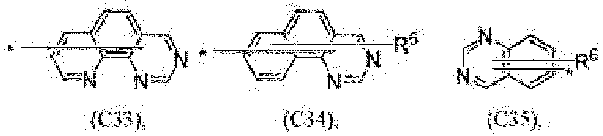
R⁶, R⁷ et R⁸ étant indépendamment choisis parmi H, C₁ à C₁₆ alkyle, C₁ à C₁₆ alcoxy, C₆ à C₂₄ aryle substitué ou non substitué, C₃ à C₂₄ hétéroaryle substitué ou non substitué, halogène, CN, C₁ à C₁₆ alkyle perfluoré, C₁ à C₁₆ alcoxy perfluoré, PXR³R⁴, L-PXR³R⁴, COR⁵ ;
R³, R⁴ et R⁵ étant indépendamment choisis parmi C₁ à C₁₆ alkyle, C₆ à C₂₄ aryle, C₃ à C₂₄ hétéroaryle, C₁ à C₁₆ alkyle perfluoré ;
les substituants du C₆ à C₂₄ aryle substitué et du C₃ à C₂₄ hétéroaryle substitué étant choisis parmi C₁ à C₁₆ alkyle, C₁ à C₁₆ alcoxy, C₆ à C₁₈ aryle, C₄ à C₁₈ hétéroaryle, CN, halogène ;
préférablement, R⁶, R⁷ et R⁸ étant indépendamment choisis parmi H, phényle, biphényle, fluorényle, naphtyle, phénanthryle, anthracényle, pyrényle, benzofurannyle, benzothiophényle, dibenzofurannyle, dibenzothiophényle, pyridinyle, quinoléinyle, pyrimidinyle, triazinyle, phénanthrolinyle, substitué ou non substitué, et PXR³R⁴, L-PXR³R⁴, COR⁵ ;
R³, R⁴ et R⁵ étant indépendamment choisis parmi C₁ à C₁₆ alkyle, C₆ à C₂₄ aryle, C₃ à C₂₄ hétéroaryle, C₁ à C₁₆ alkyle perfluoré ; et les substituants du phényle, biphényle, fluorényle, naphtyle, phénanthryle, anthracényle, pyrényle, benzofuranyle, benzothiophényle, dibenzofurannyle, dibenzothiophényle, pyridinyle, quinoléinyle, pyrimidinyle, triazinyle, phénanthrolinyle substitué étant indépendamment choisis parmi C₁ à C₁₆ alkyle, C₁ à C₁₆ alcoxy, C₆ à C₁₈ aryle, C₄ à C₁₈ hétéroaryle, CN, halogène.

7. Composé de formule 1 selon l'une quelconque des revendications précédentes 1 à 6, les substituants du groupe aryle substitué du groupe Ar², ou les substituants du groupe hétéroaryle substitué du groupe Ar², ou les substituants des groupes (C1) à (C35), étant indépendamment choisis parmi halogène, CN, D1 à D59 :

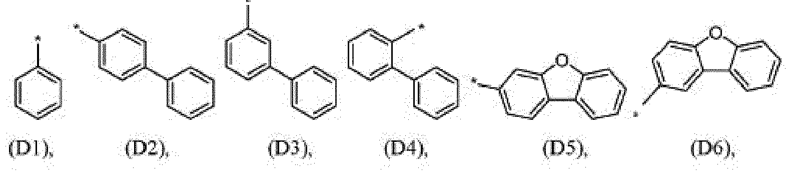

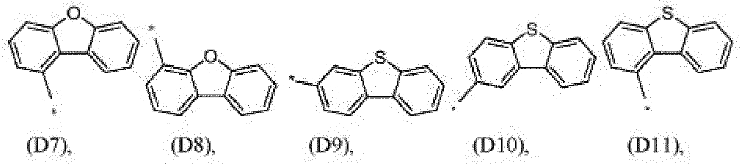

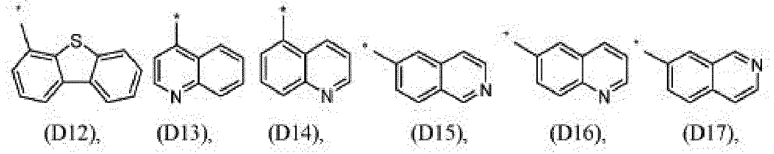

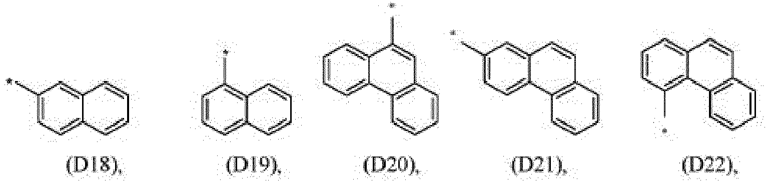

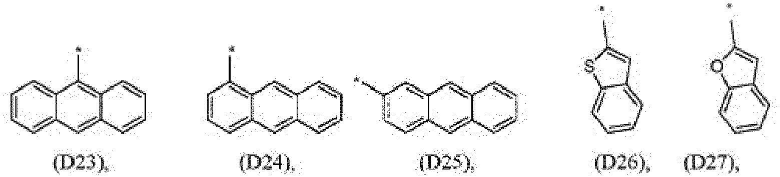

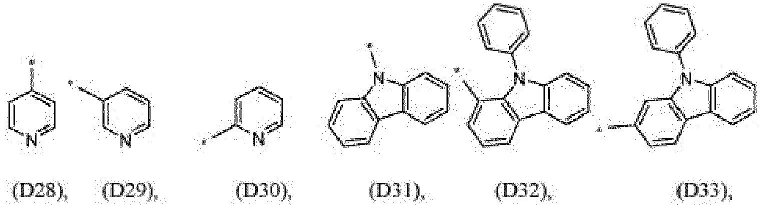

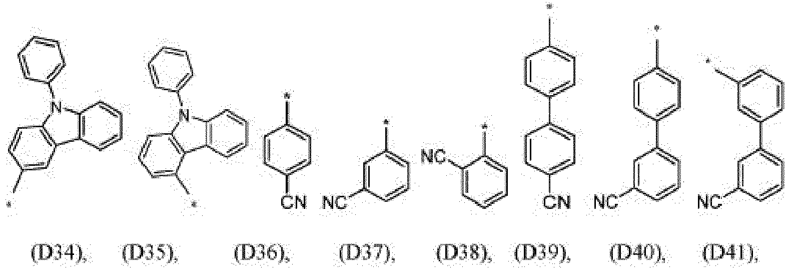

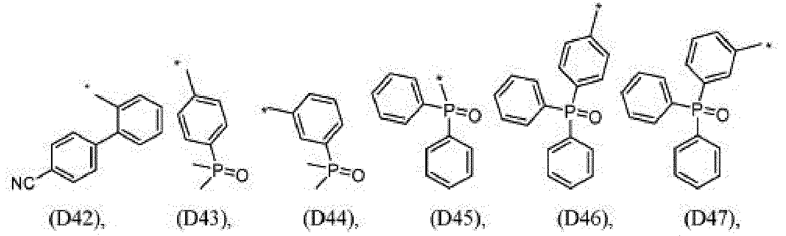

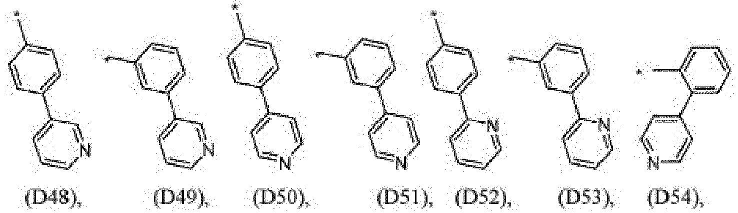

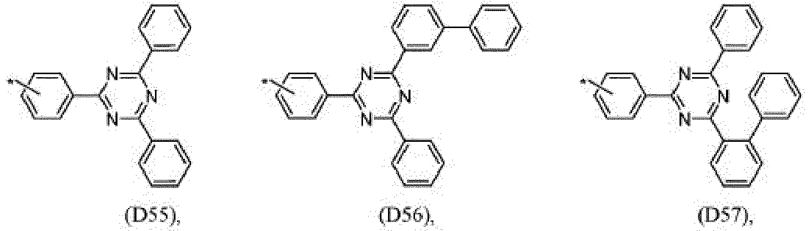

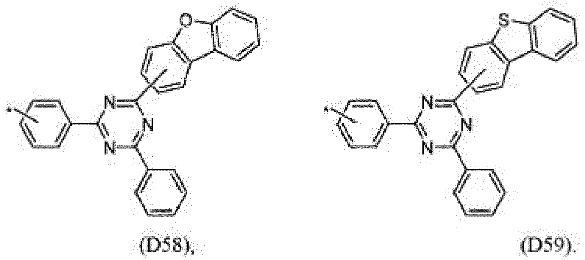

8. Composé de formule 1 selon l'une quelconque des revendications 1 à 7, L étant choisi parmi un groupe de (E1) à (E23) : 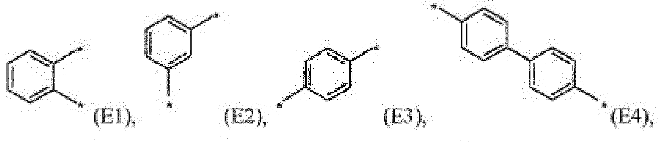 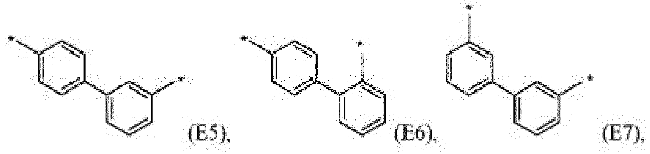 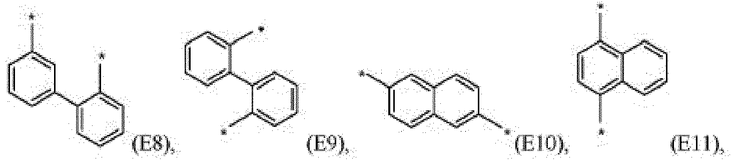 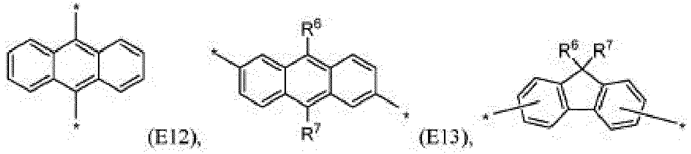 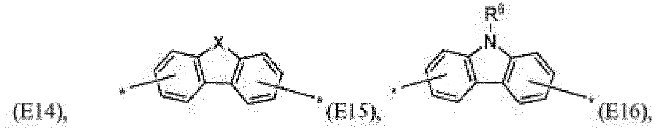 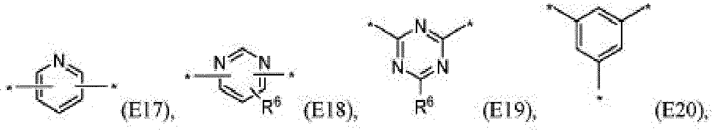 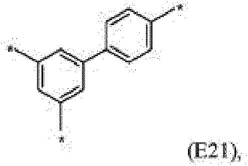 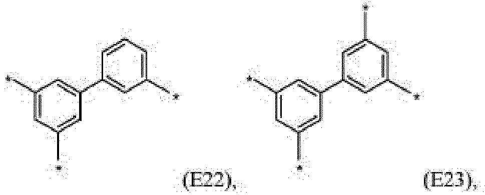 R⁶ et R⁷ étant indépendamment choisis parmi H, C₁ à C₁₆ alkyle, C₁ à C₁₆ alcoxy, C₆ à C₂₄ aryle, C₃ à C₂₄ hétéroaryle, C₁ à C₁₆ alkyle perfluoré, C₁ à C₁₆ alcoxy perfluoré.

9. Composé de formule 1 selon l'une quelconque des revendications 1 à 8, le composé de formule 1 étant choisi parmi (F1) à (F30) :

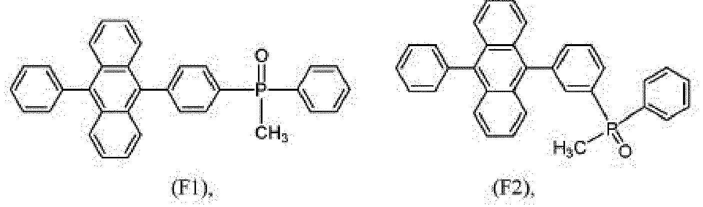

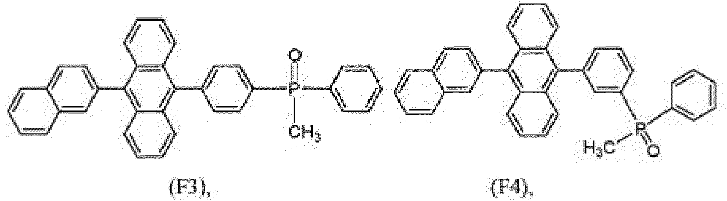

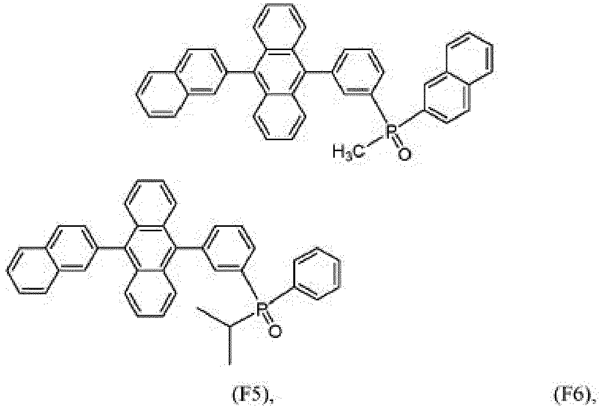

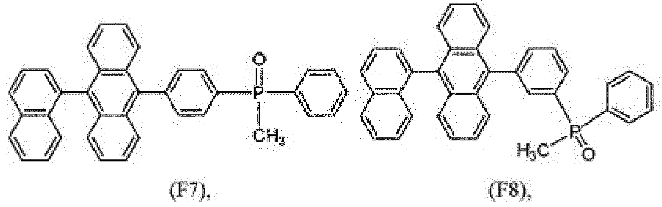

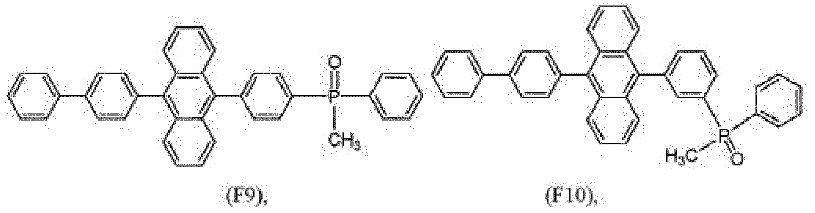

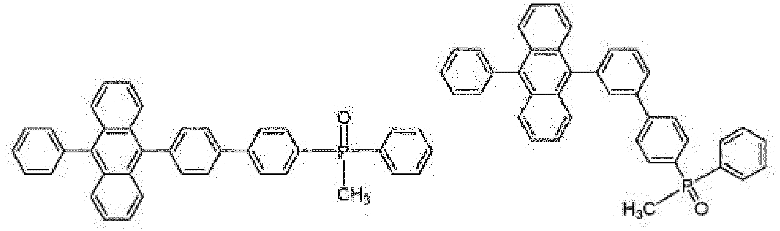

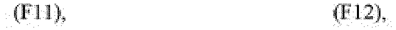

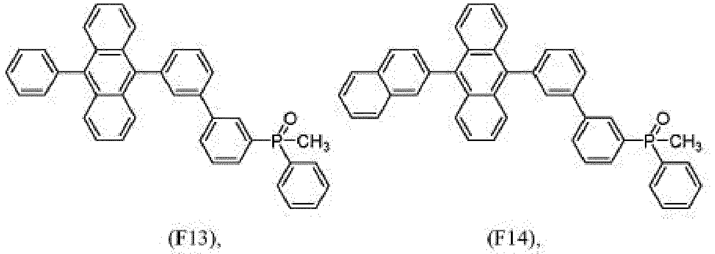

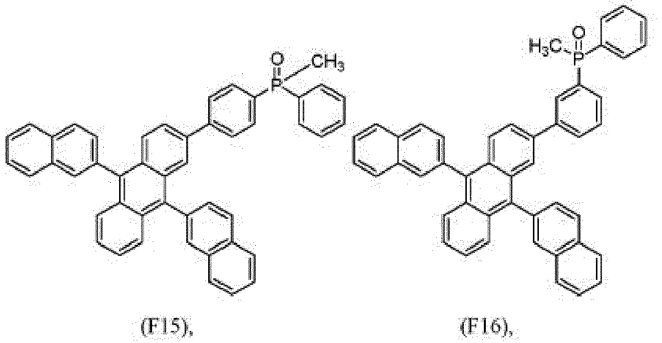

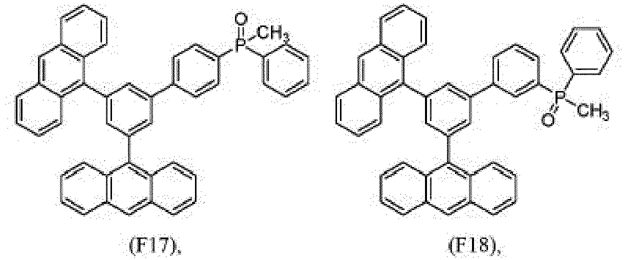

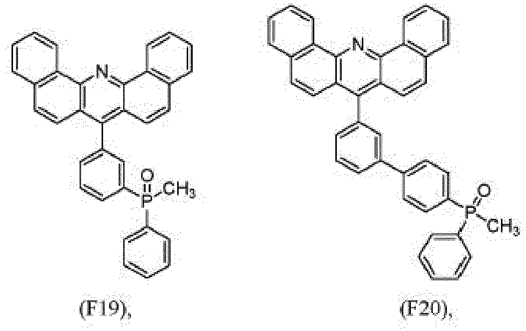

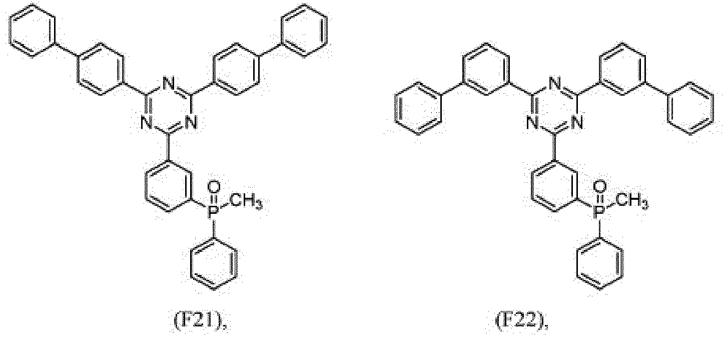

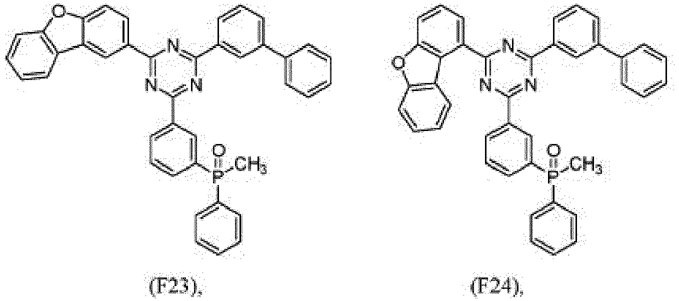

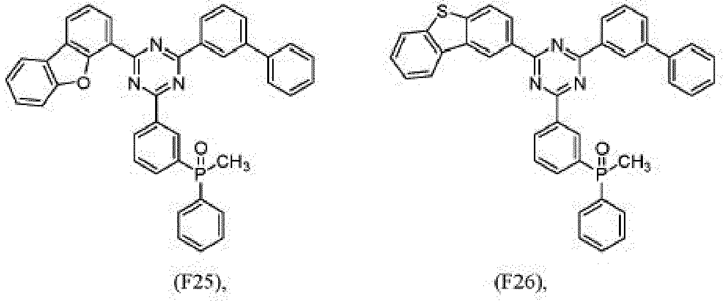

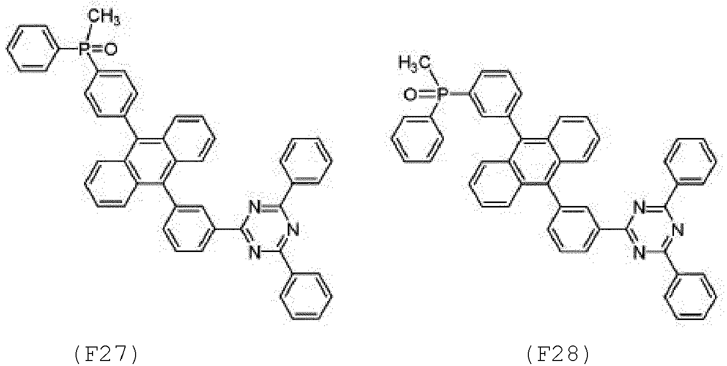

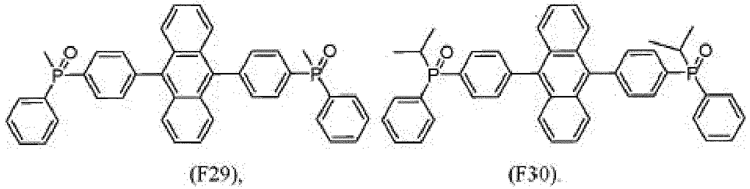

10. Couche semi-conductrice organique comprenant au moins un composé choisi parmi la formule 1 selon l'une quelconque des revendications précédentes 1 à 9.

11. Couche semi-conductrice organique selon la revendication 10, comprenant en outre un métal, un sel métallique ou un complexe organique d'un métal, préférablement un complexe organique d'un métal monovalent ou divalent, plus préférablement un complexe organique de métal alcalin ou alcalino-terreux, et en outre plus préférablement LiQ ou un borate de métal alcalin ou un borate de métal alcalino-terreux.

12. Dispositif électronique organique comprenant au moins une couche semi-conductrice organique selon l'une quelconque des revendications précédentes 10 et 11, l'au moins une couche semi-conductrice organique comprenant un composé de formule 1 selon l'une quelconque des revendications précédentes 1 à 9.

13. Dispositif électronique organique selon la revendication 12, comprenant en outre une anode et une cathode, préférablement la couche semi-conductrice organique étant agencée entre l'anode et la cathode.

14. Dispositif électronique organique selon la revendication 12 ou 13, comprenant en outre au moins une couche photoactive agencée entre l'anode et la cathode, préférablement la couche semi-conductrice organique étant agencée entre l'au moins une couche photoactive et la cathode.

15. Dispositif électronique organique selon l'une quelconque des revendications précédentes 12 à 14, le dispositif électronique organique étant un dispositif luminescent, un transistor en film mince, une batterie, un dispositif d'affichage ou une cellule photovoltaïque, préférablement un dispositif luminescent.
